(19) Europäisches Patentamt

European Patent Office

Office européen des brevets

(11) **EP 0 789 453 B1**

(12) **EUROPEAN PATENT SPECIFICATION**

(45) Date of publication and mention
of the grant of the patent:
**24.07.2002   Bulletin 2002/30**

(51) Int Cl.$^7$: **H03H 9/02**

(21) Application number: **97101742.1**

(22) Date of filing: **04.02.1997**

(54) **Surface acoustic wave device**

Akustische Oberflächenwellenanordnung

Dispositif à ondes acoustiques de surface

(84) Designated Contracting States:
**CH DE FR GB LI NL**

(30) Priority: **09.02.1996   JP 15502496**

(43) Date of publication of application:
**13.08.1997   Bulletin 1997/33**

(73) Proprietor: **SUMITOMO ELECTRIC INDUSTRIES, LTD.**
**Osaka-shi, Osaka 541 (JP)**

(72) Inventors:
 • **Nakahata, Hideaki, c/o Itami Works**
   **Itami-shi, Hyogo 664 (JP)**
 • **Narita, Masashi, c/o Osaka Works**
   **Konohana-ku , Osaka-shi, Osaka 554 (JP)**
 • **Higaki, Kenjiro, c/o Itami Works**
   **Itami-shi, Hyogo 664 (JP)**
 • **Fujii, Satoshi, c/o Itami Works**
   **Itami-shi, Hyogo 664 (JP)**
 • **Kitabayashi, Hiroyuki, c/o Itami Works**
   **Itami-shi, Hyogo 664 (JP)**
 • **Shikata, Shin-ichi, c/o Itami Works**
   **Itami-shi, Hyogo 664 (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 691 739**

## Description

BACKGROUND OF THE INVENTION

Field of the Invention

The present invention relates to a surface acoustic wave device which improves the propagation velocity (V) and the electromechanical coupling coefficient ($K^2$) of a surface acoustic wave.

Related Background Art

Surface acoustic wave devices using a surface acoustic wave (to be referred to as an "SAW" hereinafter) propagating on a solid surface have the following characteristic features which are common to electromechanical functional parts.

1) Compact and lightweight.
2) Excellent in vibration resistance and high-impact properties.
3) Highly reliable because of few product variations.
4) Since the circuits need no adjustment, the mounting process can be easily automated and simplified.

In addition to the above characteristic features common to electromechanical functional parts, the SAW devices also have various advantages such as a relatively good temperature stability, a long service life, and excellent phase characteristics. For this reason, the SAW devices can be popularly used as frequency filters, resonators, delay devices, signal processing devices, convolvers, opto-electronic functional devices, and the like.

As is known, for such SAW devices, a multilayer structure with an $LiNbO_3$ layer formed on diamond is used, paying attention to the fact that $LiNbO_3$ is chemically stabler (acid resistance and alkali resistance) than, e.g., ZnO.

For application as a frequency filter, an electromechanical coupling coefficient ($K^2$) used as an index of conversion efficiency from an electrical energy to a mechanical energy is about 0.15% to 0.7% for a narrowband filter, about 0.7% to 3% for an intermediate-band filter, or 3% to 10% for a wideband filter.

In the field of the above-described SAW devices, along with a recent tendency in multichannel or higher-frequency arrangements in the field of communications including satellite communication and mobile communication, the development of devices usable in a higher frequency range (e.g., GHz band) has been desired.

An operating frequency f of an SAW device is generally determined by $f = V/\lambda$ (V is the propagation velocity of an SAW, and $\lambda$ is the wavelength of the SAW). The wavelength $\lambda$ depends on the period of an interdigital transducer, as will be described later. However, the wavelength $\lambda$ of an SAW to be used for the device can hardly be extremely shortened because of the limitation in micropatterning technique such as photolithography. Therefore, to raise the operating frequency of the SAW device, it is preferable to increase the propagation velocity V of the SAW.

In the above-described field of communications represented by satellite communication and mobile communication, further power saving and size reduction of an entire device are required mainly from the viewpoint of mounting of the SAW device. In addition to the above-described higher frequency, an improvement in the electromechanical coupling coefficient ($K^2$) as the index of conversion efficiency from an electrical energy to a mechanical energy is required.

In recent years, therefore, for SAW devices to be widely used, a strong demand for not only an increase in propagation velocity V of an SAW to be used for the devices (e.g., $V \geq 7,000$ m/s) but also an increase in electromechanical coupling coefficient ($K^2$) (e.g., $K^2 \geq 2\%$) has arisen.

SUMMARY OF THE INVENTION

More specifically, the present invention relates to a surface acoustic wave device comprising: a diamond, a single crystal $LiNbO_3$ layer formed on said diamond, said single crystal $LiNbO_3$ layer having a thickness $t_1$ [$\mu$m], and an interdigital transducer formed on said $LiNbO_3$ layer, said surface acoustic wave device using a surface acoustic wave with wavelength $\lambda$ [$\mu$m] in the 2nd-order mode, wherein a parameter $kh_1$ defined by $kh_1 = 2\pi t_1/\lambda$ is in a predetermined range. Such a surface acoustic wave (SAW) device is known from EP-A-0 691 739 (also by Sumitomo Electric Industries).

It is an object of the present invention to provide an SAW device which increases the propagation velocity V of an SAW and improves the electromechanical coupling coefficient ($K_2$) of the SAW.

This object is solved by a surface acoustic device as defined in any one of the appended claims.

As a result of extensive studies, the present inventors found the following fact. In an SAW device having a structure with single crystal $LiNbO_3$ and diamond layers and an interdigital transducer, the above object can be achieved, i.e., an SAW device which increases the propagation velocity V of an SAW and improves the electric-mechanical coupling coefficient ($K^2$) of the SAW can be realized by combining the crystal orientation in the single crystal $LiNbO_3$ layer and a parameter $kh_1 = 2\pi(t_1/\lambda)$ ($\lambda$: the wavelength [$\mu$m] of an SAW to be used, $t_1$: the thickness [$\mu$m] of the $LiNbO_3$ layer) and adjusting this combination.

More specifically, according to the present invention, there is provided a surface acoustic wave device comprising diamond, a single crystal $LiNbO_3$ layer formed on a surface of the diamond, and an interdigital transducer formed on one of a surface of the $LiNbO_3$

layer and an interface between the diamond and the $LiNbO_3$ layer, wherein a crystal orientation of the $LiNbO_3$ layer with respect to an exposed surface of the $LiNbO_3$ layer and a propagation direction of an SAW (cut orientation with respect to the crystallographic fundamental coordinate system of the $LiNbO_3$ layer), and a ratio of a thickness of the $LiNbO_3$ layer to a wavelength of the SAW to be used are selected such that a velocity V of the SAW to be used becomes 8,000 m/s and an electromechanical coupling coefficient $K^2$ becomes 10% or more.

Therefore, an SAW device having characteristics representing a satisfactory propagation velocity V ($\geq$ 8,000 m/s) and a satisfactory electromechanical coupling coefficient $K^2$ ($\geq$ 10%) is realized.

In the SAW device of the present invention, preferably, the diamond is a diamond layer formed on a base material, and when a thickness of the diamond layer is $t_2$ [$\mu$m], the wavelength of the SAW to be used is $\lambda$, and $kh_2 = 2\pi(t_2/\lambda)$, the following relation is satisfied:

$$kh_2 \geq 4$$

If the diamond layer is thin, the SAW characteristics vary. However, when the thickness $t_2$ [$\mu$m] of the diamond layer is set such that $kh_2 \geq 4$ holds, the variation amount poses no practical problem. In addition, according to the finding of the present inventors, $kh_2 \geq 8$ is more preferable. With this arrangement, the variation amount can be further decreased.

The present invention will be more fully understood from the detailed description given hereinbelow and the accompanying drawings, which are given by way of illustration only and are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will be apparent to those skilled in the art from this detailed description.

## BRIEF DESCRIPTION OF THE DRAWINGS

Fig. 1 is an explanatory view of an Eulerian angle representation;
Fig. 2 is a sectional view showing the structure of an SAW device according to the first embodiment of the present invention;
Fig. 3 is an explanatory view of the shape of the first example (single electrode) of an interdigital transducer;

Fig. 4 is an explanatory view of the shape of the second example (double electrode) of the interdigital transducer;
Fig. 5 is a graph showing the relationship between $kh_1$ and a propagation velocity V of an SAW in the 1st-order mode;
Fig. 6 is a graph showing the evaluation result of $K^2$ in the first embodiment ($kh_1 = 0.2$, $\phi = 0°$);
Fig. 7 is a graph showing the evaluation result of $K^2$ in the first embodiment ($kh_1 = 0.2$, $\phi = 10°$);
Fig. 8 is a graph showing the evaluation result of $K^2$ in the first embodiment ($kh_1 = 0.2$, $\phi = 20°$);
Fig. 9 is a graph showing the evaluation result of $K^2$ in the first embodiment ($kh_1 = 0.2$, $\phi = 30°$);
Fig. 10 is a graph showing the evaluation result of $K^2$ in the first embodiment ($kh_1 = 0.325$, $\phi = 0°$);
Fig. 11 is a graph showing the evaluation result of $K^2$ in the first embodiment ($kh_1 = 0.325$, $\phi = 10°$);
Fig. 12 is a graph showing the evaluation result of $K^2$ in the first embodiment ($kh_1 = 0.325$, $\phi = 20°$);
Fig. 13 is a graph showing the evaluation result of $K^2$ in the first embodiment ($kh_1 = 0.325$, $\phi = 30°$);
Fig. 14 is a graph showing the evaluation result of $K^2$ in the first embodiment ($kh_1 = 0.45$, $\phi = 0°$);
Fig. 15 is a graph showing the evaluation result of $K^2$ in the first embodiment ($kh_1 = 0.45$, $\phi = 10°$);
Fig. 16 is a graph showing the evaluation result of $K^2$ in the first embodiment ($kh_1 = 0.45$, $\phi = 20°$);
Fig. 17 is a graph showing the evaluation result of $K^2$ in the first embodiment ($kh_1 = 0.45$, $\phi = 30°$);
Fig. 18 is a graph showing the evaluation result of $K^2$ in the first embodiment ($kh_1 = 0.7$, $\phi = 0°$);
Fig. 19 is a graph showing the evaluation result of $K^2$ in the first embodiment ($kh_1 = 0.7$, $\phi = 10°$);
Fig. 20 is a graph showing the evaluation result of $K^2$ in the first embodiment ($kh_1 = 0.7$, $\phi = 20°$);
Fig. 21 is a graph showing the evaluation result of $K^2$ in the first embodiment ($kh_1 = 0.7$, $\phi = 30°$);
Fig. 22 is a sectional view showing the structure of an SAW device according to the second embodiment of the present invention;
Fig. 23 is a graph showing the relationship between $kh_1$ and a propagation velocity V of an SAW in the 2nd-order mode;
Fig. 24 is a graph showing the evaluation result of $K^2$ in the second embodiment ($kh_1 = 0.6$, $\phi = 0°$);
Fig. 25 is a graph showing the evaluation result of $K^2$ in the second embodiment ($kh_1 = 0.6$, $\phi = 10°$);
Fig. 26 is a graph showing the evaluation result of $K^2$ in the second embodiment ($kh_1 = 0.6$, $\phi = 20°$);
Fig. 27 is a graph showing the evaluation result of $K^2$ in the second embodiment ($kh_1 = 0.6$, $\phi = 30°$);
Fig. 28 is a graph showing the evaluation result of $K^2$ in the second embodiment ($kh_1 = 0.85$, $\phi = 0°$);
Fig. 29 is a graph showing the evaluation result of $K^2$ in the second embodiment ($kh_1 = 0.85$, $\phi = 10°$);
Fig. 30 is a graph showing the evaluation result of $K^2$ in the second embodiment ($kh_1 = 0.85$, $\phi = 20°$);

Fig. 31 is a graph showing the evaluation result of $K^2$ in the second embodiment ($kh_1$ = 0.85, $\phi$ = 30°);

Fig. 32 is a graph showing the evaluation result of $K^2$ in the second embodiment ($kh_1$ = 1.1, $\phi$ = 0°);

Fig. 33 is a graph showing the evaluation result of $K^2$ in the second embodiment ($kh_1$ = 1.1, $\phi$ = 10°);

Fig. 34 is a graph showing the evaluation result of $K^2$ in the second embodiment ($kh_1$ = 1.1, $\phi$ = 20°);

Fig. 35 is a graph showing the evaluation result of $K^2$ in the second embodiment ($kh_1$ = 1.1, $\phi$ = 30°);

Fig. 36 is a graph showing the evaluation result of $K^2$ in the second embodiment ($kh_1$ = 1.6, $\phi$ = 0°);

Fig. 37 is a graph showing the evaluation result of $K^2$ in the second embodiment ($kh_1$ = 1.6, $\phi$ = 10°);

Fig. 38 is a graph showing the evaluation result of $K^2$ in the second embodiment ($kh_1$ = 1.6, $\phi$ = 20°);

Fig. 39 is a graph showing the evaluation result of $K^2$ in the second embodiment ($kh_1$ = 1.6, $\phi$ = 30°);

Fig. 40 is a sectional view showing the structure of an SAW device according to the third embodiment of the present invention;

Fig. 41 is a graph showing the evaluation result of $K^2$ in the third embodiment ($kh_1$ = 0.2, $\phi$ = 0°);

Fig. 42 is a graph showing the evaluation result of $K^2$ in the third embodiment ($kh_1$ = 0.2, $\phi$ = 10°);

Fig. 43 is a graph showing the evaluation result of $K^2$ in the third embodiment ($kh_1$ = 0.2, $\phi$ = 20°);

Fig. 44 is a graph showing the evaluation result of K' in the third embodiment ($kh_1$ = 0.2, $\phi$ = 30°);

Fig. 45 is a graph showing the evaluation result of $K^2$ in the third embodiment ($kh_1$ = 0.325, $\phi$ = 0°);

Fig. 46 is a graph showing the evaluation result of $K^2$ in the third embodiment ($kh_1$ = 0.325, $\phi$ = 10°);

Fig. 47 is a graph showing the evaluation result of $K^2$ in the third embodiment ($kh_1$ = 0.325, $\phi$ = 20°);

Fig. 48 is a graph showing the evaluation result of $K^2$ in the third embodiment ($kh_1$ = 0.325, $\phi$ = 30°);

Fig. 49 is a graph showing the evaluation result of $K^2$ in the third embodiment ($kh_1$ = 0.45, $\phi$ = 0°);

Fig. 50 is a graph showing the evaluation result of $K^2$ in the third embodiment ($kh_1$ = 0.45, $\phi$ = 10°);

Fig. 51 is a graph showing the evaluation result of $K^2$ in the third embodiment ($kh_1$ = 0.45, $\phi$ = 20°);

Fig. 52 is a graph showing the evaluation result of $K^2$ in the third embodiment ($kh_1$ = 0.45, $\phi$ = 30°);

Fig. 53 is a graph showing the evaluation result of $K^2$ in the third embodiment ($kh_1$ = 0.7, $\phi$ = 0°);

Fig. 54 is a graph showing the evaluation result of $K^2$ in the third embodiment ($kh_1$ = 0.7, $\phi$ = 10°);

Fig. 55 is a graph showing the evaluation result of $K^2$ in the third embodiment ($kh_1$ = 0.7, $\phi$ = 20°);

Fig. 56 is a graph showing the evaluation result of $K^2$ in the third embodiment ($kh_1$ = 0.7, $\phi$ = 30°);

Fig. 57 is a sectional view showing the structure of an SAW device according to the fourth embodiment of the present invention;

Fig. 58 is a graph showing the evaluation result of $K^2$ in the fourth embodiment ($kh_1$ = 0.6, $\phi$ = 0°);

Fig. 59 is a graph showing the evaluation result of $K^2$ in the fourth embodiment ($kh_1$ = 0.6, $\phi$ = 10°);

Fig. 60 is a graph showing the evaluation result of $K^2$ in the fourth embodiment ($kh_1$ = 0.6, $\phi$ = 20°);

Fig. 61 is a graph showing the evaluation result of $K^2$ in the fourth embodiment ($kh_1$ = 0.6, $\phi$ = 30°);

Fig. 62 is a graph showing the evaluation result of $K^2$ in the fourth embodiment ($kh_1$ = 0.85, $\phi$ = 0°);

Fig. 63 is a graph showing the evaluation result of $K^2$ in the fourth embodiment ($kh_1$ = 0.85, $\phi$ = 10°);

Fig. 64 is a graph showing the evaluation result of $K^2$ in the fourth embodiment ($kh_1$ = 0.85, $\phi$ = 20°);

Fig. 65 is a graph showing the evaluation result of $K^2$ in the fourth embodiment ($kh_1$ = 0.85, $\phi$ = 30°);

Fig. 66 is a graph showing the evaluation result of $K^2$ in the fourth embodiment ($kh_1$ = 1.1, $\phi$ = 0°);

Fig. 67 is a graph showing the evaluation result of $K^2$ in the fourth embodiment ($kh_1$ = 1.1, $\phi$ = 10°);

Fig. 68 is a graph showing the evaluation result of $K^2$ in the fourth embodiment ($kh_1$ = 1.1, $\phi$ = 20°);

Fig. 69 is a graph showing the evaluation result of $K^2$ in the fourth embodiment ($kh_1$ = 1.1, $\phi$ = 30°);

Fig. 70 is a graph showing the evaluation result of $K^2$ in the fourth embodiment ($kh_1$ = 1.6, $\phi$ = 0°);

Fig. 71 is a graph showing the evaluation result of $K^2$ in the fourth embodiment ($kh_1$ = 1.6, $\phi$ = 10°);

Fig. 72 is a graph showing the evaluation result of $K^2$ in the fourth embodiment ($kh_1$ = 1.6, $\phi$ = 20°);

Fig. 73 is a graph showing the evaluation result of $K^2$ in the fourth embodiment ($kh_1$ = 1.6, $\phi$ = 30°);

Fig. 74 is a sectional view showing the structure of an SAW device according to the fifth embodiment of the present invention;

Fig. 75 is a graph showing the evaluation result of $K^2$ in the fifth embodiment ($kh_1$ = 0.2, $\phi$ = 0°);

Fig. 76 is a graph showing the evaluation result of $K^2$ in the fifth embodiment ($kh_1$ = 0.2, $\phi$ = 10°);

Fig. 77 is a graph showing the evaluation result of $K^2$ in the fifth embodiment ($kh_1$ = 0.2, $\phi$ = 20°);

Fig. 78 is a graph showing the evaluation result of $K^2$ in the fifth embodiment ($kh_1$ = 0.2, $\phi$ = 30°);

Fig. 79 is a graph showing the evaluation result of $K^2$ in the fifth embodiment ($kh_1$ = 0.325, $\phi$ = 0°);

Fig. 80 is a graph showing the evaluation result of $K^2$ in the fifth embodiment ($kh_1$ = 0.325, $\phi$ = 10°);

Fig. 81 is a graph showing the evaluation result of $K^2$ in the fifth embodiment ($kh_1$ = 0.325, $\phi$ = 20°);

Fig. 82 is a graph showing the evaluation result of $K^2$ in the fifth embodiment ($kh_1$ = 0.325, $\phi$ = 30°);

Fig. 83 is a graph showing the evaluation result of $K^2$ in the fifth embodiment ($kh_1$ = 0.45, $\phi$ = 0°);

Fig. 84 is a graph showing the evaluation result of $K^2$ in the fifth embodiment ($kh_1$ = 0.45, $\phi$ = 10°);

Fig. 85 is a graph showing the evaluation result of $K^2$ in the fifth embodiment ($kh_1$ = 0.45, $\phi$ = 20°);

Fig. 86 is a graph showing the evaluation result of $K^2$ in the fifth embodiment ($kh_1$ = 0.45, $\phi$ = 30°);

Fig. 87 is a graph showing the evaluation result of

$K^2$ in the fifth embodiment ($kh_1 = 0.7$, $\phi = 0°$);

Fig. 88 is a graph showing the evaluation result of $K^2$ in the fifth embodiment ($kh_1 = 0.7$, $\phi = 10°$);

Fig. 89 is a graph showing the evaluation result of $K^2$ in the fifth embodiment ($kh_1 = 0.7$, $\phi = 20°$);

Fig. 90 is a graph showing the evaluation result of $K^2$ in the fifth embodiment ($kh_1 = 0.7$, $\phi = 30°$);

Fig. 91 is a sectional view showing the structure of an SAW device according to the sixth embodiment of the present invention;

Fig. 92 is a graph showing the evaluation result of $K^2$ in the sixth embodiment ($kh_1 = 0.6$, $\phi$) = 0°);

Fig. 93 is a graph showing the evaluation result of $K^2$ in the sixth embodiment ($kh_1 = 0.6$, $\phi = 10°$);

Fig. 94 is a graph showing the evaluation result of $K^2$ in the sixth embodiment ($kh_1 = 0.6$, $\phi = 20°$);

Fig. 95 is a graph showing the evaluation result of $K^2$ in the sixth embodiment ($kh_1 = 0.6$, $\phi = 30°$);

Fig. 96 is a graph showing the evaluation result of $K^2$ in the sixth embodiment ($kh_1 = 0.85$, $\phi = 0°$);

Fig. 97 is a graph showing the evaluation result of $K^2$ in the sixth embodiment ($kh_1 = 0.85$, $\phi = 10°$);

Fig. 98 is a graph showing the evaluation result of $K^2$ in the sixth embodiment ($kh_1 = 0.85$, $\phi = 20°$);

Fig. 99 is a graph showing the evaluation result of $K^2$ in the sixth embodiment ($kh_1 = 0.85$, $\phi = 30°$);

Fig. 100 is a graph showing the evaluation result of $K^2$ in the sixth embodiment ($kh_1 = 1.1$, $\phi = 0°$);

Fig. 101 is a graph showing the evaluation result of $K^2$ in the sixth embodiment ($kh_1 = 1.1$, $\phi = 10°$);

Fig. 102 is a graph showing the evaluation result of $K^2$ in the sixth embodiment ($kh_1 = 1.1$, $\phi = 20°$);

Fig. 103 is a graph showing the evaluation result of $K^2$ in the sixth embodiment ($kh_1 = 1.1$, $\phi = 30°$);

Fig. 104 is a graph showing the evaluation result of $K^2$ in the sixth embodiment ($kh_1 = 1.6$, $\phi = 0°$);

Fig. 105 is a graph showing the evaluation result of $K^2$ in the sixth embodiment ($kh_1 = 1.6$, $\phi = 10°$);

Fig. 106 is a graph showing the evaluation result of $K^2$ in the sixth embodiment ($kh_1 = 1.6$, $\phi = 20°$);

Fig. 107 is a graph showing the evaluation result of $K^2$ in the sixth embodiment ($kh_1 = 1.6$, $\phi = 30°$);

Fig. 108 is a sectional view showing the structure of an SAW device according to the seventh embodiment of the present invention;

Fig. 109 is a graph showing the evaluation result of $K^2$ in the seventh embodiment ($kh_1 = 0.6$, $\phi = 0°$);

Fig. 110 is a graph showing the evaluation result of $K^2$ in the seventh embodiment ($kh_1 = 0.6$, $\phi = 10°$);

Fig. 111 is a graph showing the evaluation result of $K^2$ in the seventh embodiment ($kh_1 = 0.6$, $\phi = 20°$);

Fig. 112 is a graph showing the evaluation result of $K^2$ in the seventh embodiment ($kh_1 = 0.6$, $\phi = 30°$);

Fig. 113 is a graph showing the evaluation result of $K^2$ in the seventh embodiment ($kh_1 = 0.85$, $\phi = 0°$);

Fig. 114 is a graph showing the evaluation result of $K^2$ in the seventh embodiment ($kh_1 = 0.65$, $\phi = 10°$);

Fig. 115 is a graph showing the evaluation result of $K^2$ in the seventh embodiment ($kh_1 = 0.85$, $\phi = 20°$);

Fig. 116 is a graph showing the evaluation result of $K^2$ in the seventh embodiment ($kh_1 = 0.85$, $\phi = 30°$);

Fig. 117 is a graph showing the evaluation result of $K^2$ in the seventh embodiment ($kh_1 = 1.1$, $\phi = 0°$);

Fig. 118 is a graph showing the evaluation result of $K^2$ in the seventh embodiment ($kh_1 = 1.1$, $\phi = 10°$);

Fig. 119 is a graph showing the evaluation result of $K^2$ in the seventh embodiment ($kh_1 = 1.1$, $\phi = 20°$);

Fig. 120 is a graph showing the evaluation result of $K^2$ in the seventh embodiment ($kh_1 = 1.1$, $\phi = 30°$);

Fig. 121 is a graph showing the evaluation result of $K^2$ in the seventh embodiment ($kh_1 = 1.6$, $\phi = 0°$);

Fig. 122 is a graph showing the evaluation result of $K^2$ in the seventh embodiment ($kh_1 = 1.6$, $\phi = 10°$);

Fig. 123 is a graph showing the evaluation result of $K^2$ in the seventh embodiment ($kh_1 = 1.6$, $\phi = 20°$);

Fig. 124 is a graph showing the evaluation result of $K^2$ in the seventh embodiment ($kh_1 = 1.6$, $\phi = 30°$);

Fig. 125 is a graph showing the evaluation result of $K^2$ in an evaluation example ($kh_1 = 0.2$, $\phi = 0°$);

Fig. 126 is a graph showing the evaluation result of $K^2$ in the evaluation example ($kh_1 = 0.2$, $\phi = 10°$);

Fig. 127 is a graph showing the evaluation result of $K^2$ in the evaluation example ($kh_1 = 0.2$, $\phi = 20°$);

Fig. 128 is a graph showing the evaluation result of $K^2$ in the evaluation example ($kh_1 = 0.2$, $\phi = 30°$);

Fig. 129 is a graph showing the evaluation result of $K^2$ in the evaluation example ($kh_1 = 0.325$, $\phi = 0°$);

Fig. 130 is a graph showing the evaluation result of $K^2$ in the evaluation example ($kh_1 = 0.325$, $\phi = 10°$);

Fig. 131 is a graph showing the evaluation result of $K^2$ in the evaluation example ($kh_1 = 0.325$, $\phi = 20°$);

Fig. 132 is a graph showing the evaluation result of $K^2$ in the evaluation example ($kh_1 = 0.325$, $\phi = 30°$);

Fig. 133 is a graph showing the evaluation result of $K^2$ in the evaluation example ($kh_1 = 0.45$, $\phi = 0°$);

Fig. 134 is a graph showing the evaluation result of $K^2$ in the evaluation example ($kh_1 = 0.45$, $\phi = 10°$);

Fig. 135 is a graph showing the evaluation result of $K^2$ in the evaluation example ($kh_1 = 0.45$, $\phi = 20°$);

Fig. 136 is a graph showing the evaluation result of $K^2$ in the evaluation example ($kh_1 = 0.45$, $\phi = 30°$);

Fig. 137 is a graph showing the evaluation result of $K^2$ in the evaluation example ($kh_1 = 0.7$, $\phi = 0°$);

Fig. 138 is a graph showing the evaluation result of $K^2$ in the evaluation example ($kh_1 = 0.7$, $\phi = 10°$);

Fig. 139 is a graph showing the evaluation result of $K^2$ in the evaluation example ($kh_1 = 0.7$, $\phi = 20°$); and

Fig. 140 is a graph showing the evaluation result of $K^2$ in the evaluation example ($kh_1 = 0.7$, $\phi = 30°$).

## DETAILED DESCRIPTION OF THE PREFERRED EMBODIMENTS

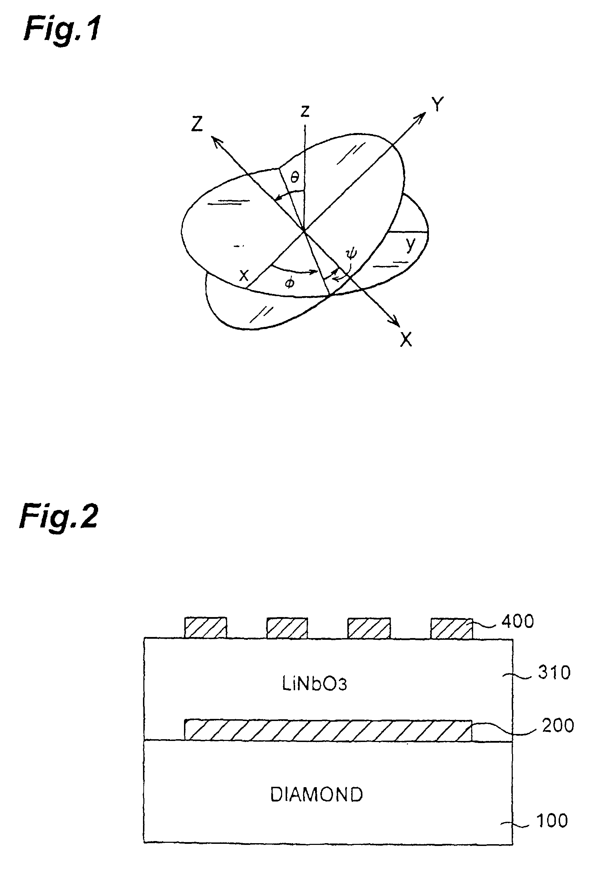

In the present invention, a single crystal $LiNbO_3$ layer is used. As shown in Fig. 1, the crystal ori-

entation of the LiNbO$_3$ layer is represented by an Eulerian angle representation $(\theta,\phi,\psi)$ on an orthogonal coordinate system (X,Y,Z) in which the Z-axis is set along the normal direction of the cut plane, and the X-axis is set along the SAW propagation direction (one direction on the cut plane of the LiNbO$_3$ layer, which is determined by the shape of an interdigital transducer) when viewed from the LiNbO$_3$ crystallographic fundamental coordinate system (x,y,z) of the LiNbO$_3$ layer.

The LiNbO$_3$ crystal has a three-time mirror surface symmetry (3m). For this reason, (i) the characteristics of the LiNbO$_3$ layer at $\theta$ of 0° to 180° match those at $\theta$ of 180° to 360°, (ii) the characteristics of the LiNbO$_3$ layer at $\psi$ of 0° to 180° match those at $\psi$ of 180° to 360°. In addition, (iii) the characteristics of the LiNbO$_3$ layer at $\phi$ of 0° to 30° match those at $\phi$ of 60° to 30°, the characteristics of the LiNbO$_3$ layer at $\phi$ of 0° to 60° match those at $\phi$ of 120° to 60°, and the characteristics of the LiNbO$_3$ layer at $\phi$ of 0° to 120° match those at $\phi$ of 120° to 240° and 240° to 360°.

The embodiments of an SAW device of the present invention will be described below with reference to the accompanying drawings. The same reference numerals denote the same elements throughout the drawings, and a detailed description thereof will be omitted.

(First Embodiment)

Fig. 2 is a sectional view showing the structure of an SAW device according to the first embodiment of the present invention. As shown in Fig. 2, the SAW device of the first embodiment comprises (a) diamond 100, (b) a short-circuit electrode 200 formed on the diamond 100, (c) a single crystal LiNbO$_3$ layer 310 formed on the short-circuit electrode 200, and (d) an interdigital transducer 400 formed on the LiNbO$_3$ layer 310.

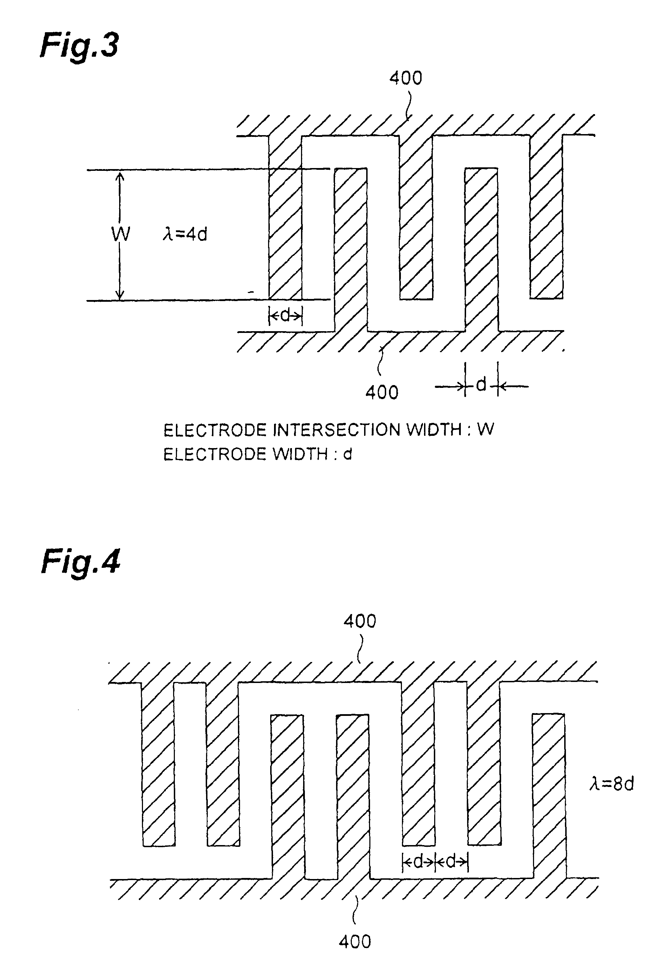

In the SAW device of the first embodiment, when the interdigital transducer 400 is used to excite an SAW, a plurality of SAWs with different propagation velocities V are excited (0th-order mode, 1st-order mode, 2nd-order mode,... in ascending order of the propagation velocities V). Therefore, the mode of an SAW used in the SAW device can be determined by measuring the propagation velocity V of the SAW at the operating frequency of the device. This propagation velocity V can be obtained from, e.g., a relation V = f$\lambda$ (f is the center frequency; $\lambda$ is the wavelength based on the electrode width of the interdigital transducer 400). When the interdigital transducer 400 constituting the SAW device is a single electrode finger structure (electrode width d) having a planar shape as shown in Fig. 3, $\lambda$ = 4d. When the interdigital transducer 400 is a double electrode finger structure (electrode width d) having a planar shape as shown in Fig. 4, $\lambda$ = 8d.

The SAW device of the first embodiment uses an SAW in the 1st-order mode.

As the diamond 100, single crystal diamond and/or polycrystalline diamond can be used. The method of obtaining the diamond 100 is not particularly limited. More specifically, single crystal diamond may be used as the diamond. In addition, a diamond layer may be formed on any material (substrate) by epitaxial growth to obtain the diamond 100 as a polycrystalline diamond layer or an epitaxial diamond layer.

The base material for forming the diamond layer is not particularly limited and can be appropriately selected depending on the application purpose of the SAW device. In the first embodiment, a semiconductor such as Si, a metal, a glass material, a ceramic, or the like can be used as the material.

When the diamond 100 is a diamond layer, the method of growing the diamond layer is not particularly limited. More specifically, a known technique such as CVD (Chemical Vapor Deposition), microwave plasma CVD, PVD (Physical Vapor Deposition), sputtering, ion plating, a plasma jet method, a flame method, or a hot filament method can be used as the growth method.

The plane orientation of the diamond 100 is not particularly limited. The diamond 100 can have a plane orientation (111), (100), or (110), or can have two or more of them simultaneously.

When the diamond 100 is to be obtained as a layer, the thickness of the diamond 100 is set such that $kh_2 \geq 4$ is satisfied when $t_2$ represents the thickness of the diamond 100, and a relation $kh_2 = 2\pi(t_2/\lambda)$ holds.

If the diamond layer is thin, the SAW characteristics vary. However, when the thickness $t_2$ [μm] of the diamond layer is set such that $kh_2 \geq 4$ holds, the variation amount poses no practical problem. More preferably, $kh_2 \geq 8$. In this case, the variation amount can be further reduced.

The short-circuit electrode 200 is an electrode having a function of setting an equipotential of an electric field to change the SAW characteristics of the device. The short-circuit electrode 200 is preferably formed of a (thin) metal film (e.g., Al, Au, or Al-Cu). Since the short-circuit electrode 200 has a function different from that of the interdigital transducer 400, the material of the short-circuit electrode 200 need not be the same as that of the interdigital transducer 400.

The thickness of the short-circuit electrode 200 is not particularly limited as far as the function as a short-circuit electrode can be obtained. However, it is preferably about 50 to 3,000 Å (more preferably, about 100 to 500 Å). When this thickness is smaller than 50 Å, it is difficult to set an equipotential. On the other hand, a thickness larger than 3,000 Å results in a decrease in velocity of an SAW.

The short-circuit electrode 200 preferably has a planar shape of, e.g., a "solid electrode" having the same area as that of the interdigital transducer 400.

The material of the interdigital transducer 400 is not particularly limited as far as it is a conductive material. From the viewpoint of workability as an interdigital transducer and cost, Al (aluminum) can be particularly preferably used.

The thickness of the interdigital transducer 400 is preferably about 100 to 5,000 Å (more preferably, about 100 to 500 Å) though it is not particularly limited as far as the function as an interdigital transducer can be obtained. When this thickness is smaller than 100 Å, the resistivity increases, resulting in an increase in loss. On the other hand, when the thickness of the electrode exceeds 5,000 Å, the mass addition effect which causes reflection of an SAW due to the thickness and height of the electrode becomes conspicuous, and desired SAW characteristics may be impeded.

The planar shape of the interdigital transducer 400 is not particularly limited as far as the function as an interdigital transducer can be obtained. A so-called single electrode finger structure whose schematic plan view is shown in Fig. 3 or a double electrode finger structure whose schematic plan view is shown in Fig. 4 can be preferably used.

The $LiNbO_3$ layer 310 is formed by bonding a cut single crystal $LiNbO_3$ thin plate to the diamond 100 having the short-circuit electrode 200 formed on its polished surface, and then polishing the single crystal $LiNbO_3$ thin plate.

For the $LiNbO_3$ layer 310, a thickness $t_1$ [μm] and a crystal orientation $(\theta[°], \phi[°], \psi[°])$ are selected from the following values. Note that $kh_1$ $(= 2\pi(t_1/\lambda);$ $\lambda$ = the wavelength [μm] of an SAW) is used instead of the thickness $t_1$.

An arbitrarily value within the range of $0° \leq \phi \leq 360°$ is set. The remaining values are set for each of integer pairs (i,k), i.e., (0,0), (0,1), (1,0), and (1,1) on an orthogonal coordinate system $(kh_1, \theta, \psi)$.

(i) For the integer pairs (i,k), i.e., (0,0), (0,1), (1,0), and (1,1) on the orthogonal coordinate system $(kh_1, \theta, \psi)$, values in the internal regions of four hexahedrons each of which has, as its opposing bottom surfaces, a planar rectangular region with its vertexes at points $A_{11}{}^{ik}$, $B_{11}{}^{ik}$, $C_{11}{}^{ik}$, and $D_{11}{}^{ik}$ and a planar rectangular region with its vertexes at points $A_{12}{}^{ik}$, $B_{12}{}^{ik}$, $C_{12}{}^{ik}$, and $D_{12}{}^{ik}$, where

point $A_{11}{}^{ik} = (0.45, 80+180i, 140+180k)$
point $B_{11}{}^{ik} = (0.45, 100+180i, 140+180k)$
point $C_{11}{}^{ik} = (0.45, 100+180i, 180+180k)$
point $D_{11}{}^{ik} = (0.45, 80+180i, 180+180k)$
point $A_{12}{}^{ik} = (0.7, 70+180i, 120+180k)$
point $B_{12}{}^{ik} = (0.7, 110+180i, 120+180k)$
point $C_{12}{}^{ik} = (0.7, 110+180i, 180+180k)$
point $D_{12}{}^{ik} = (0.7, 60+180i, 180+180k)$.

(ii) For the integer pairs (i,k), i.e., (0,0), (0,1), (1,0), and (1,1) on the orthogonal coordinate system $(kh_1, \theta, \psi)$, values in the internal regions of four hexahedrons each of which has, as its opposing bottom surfaces, a planar rectangular region with its vertexes at points $A_{13}{}^{ik}$, $B_{13}{}^{ik}$, $C_{13}{}^{ik}$, and $D_{13}{}^{ik}$ and a

planar rectangular region with its vertexes at points $A_{14}{}^{ik}$, $B_{14}{}^{ik}$, $C_{14}{}^{ik}$, and $D_{14}{}^{ik}$, where

point $A_{13}{}^{ik} = (0.45, 80+180i, 0+180k)$
point $B_{13}{}^{ik} = (0.45, 90+180i, 0+180k)$
point $C_{13}{}^{ik} = (0.45, 90+180i, 10+180k)$
point $D_{13}{}^{ik} = (0.45, 80+180i, 20+180k)$
point $A_{14}{}^{ik} = (0.7, 60+180i, 0+180k)$
point $B_{14}{}^{ik} = (0.7, 110+180i, 0+180k)$
point $C_{14}{}^{ik} = (0.7, 90+180i, 40+180k)$
point $D_{14}{}^{ik} = (0.7, 80+180i, 40+180k)$.

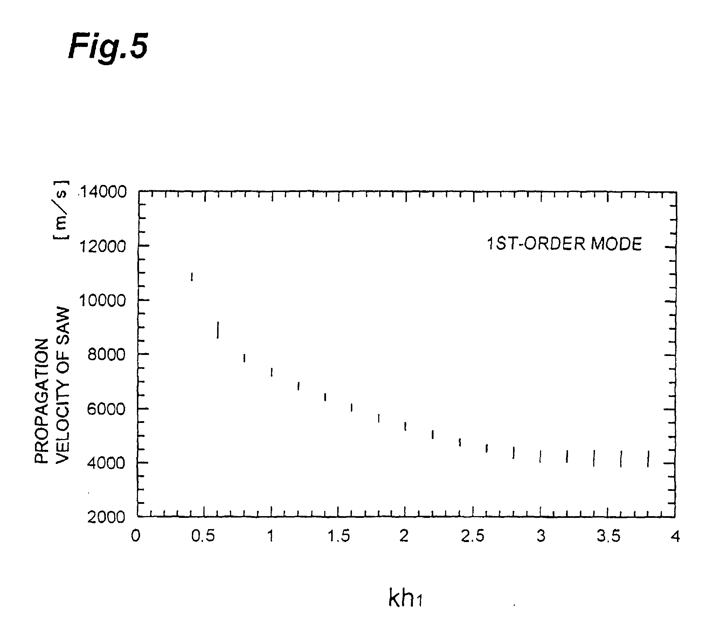

In the structure of the SAW device according to the first embodiment, the propagation velocity V is exclusively determined by $kh_1$ of the $LiNbO_3$ layer 310. Fig. 5 is a graph showing the relationship between $kh_1$ of the $LiNbO_3$ layer 310 and the propagation velocity V of an SAW in the 1st-order mode in the SAW device of the first embodiment. It is confirmed from Fig. 5 that, when $kh_1$ is equal to or smaller than 0.7, a propagation velocity V equal to or higher than 8,000 m/s is ensured.

The present inventors set the thickness of the diamond 100 at 20 μm, and evaluated an electromechanical coupling coefficient $K^2$ while changing $kh_1$ within the above-described limitation for $kh_1$ and simultaneously changing the values $\theta$, $\phi$, and $\psi$.

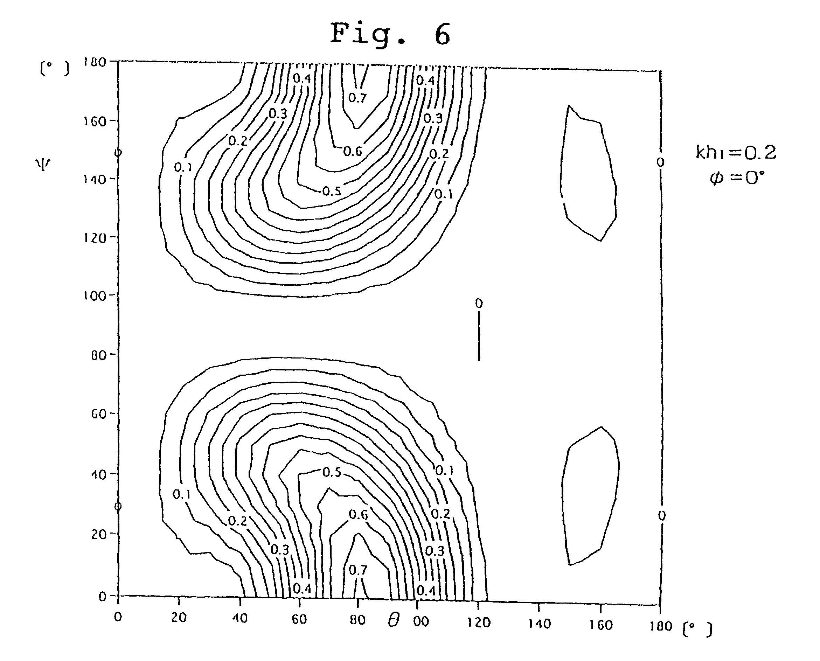

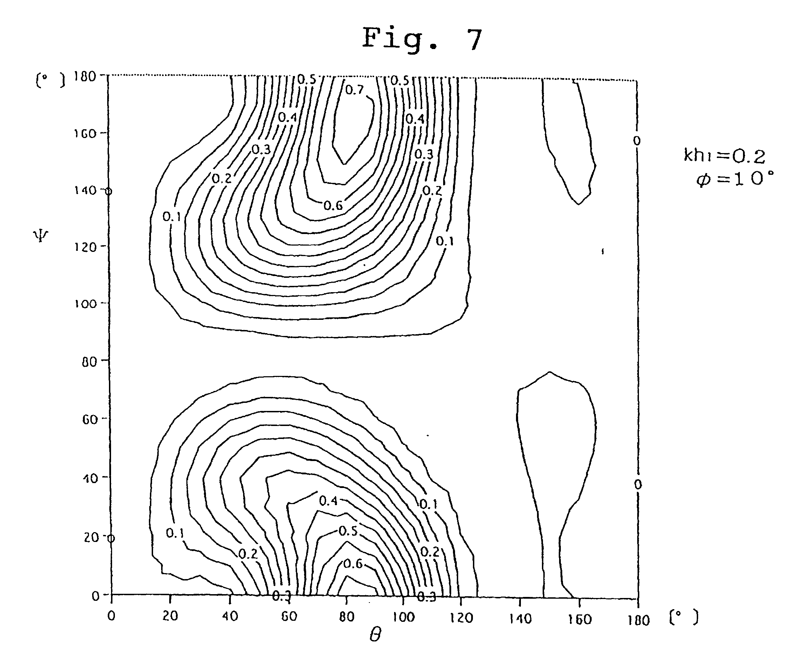

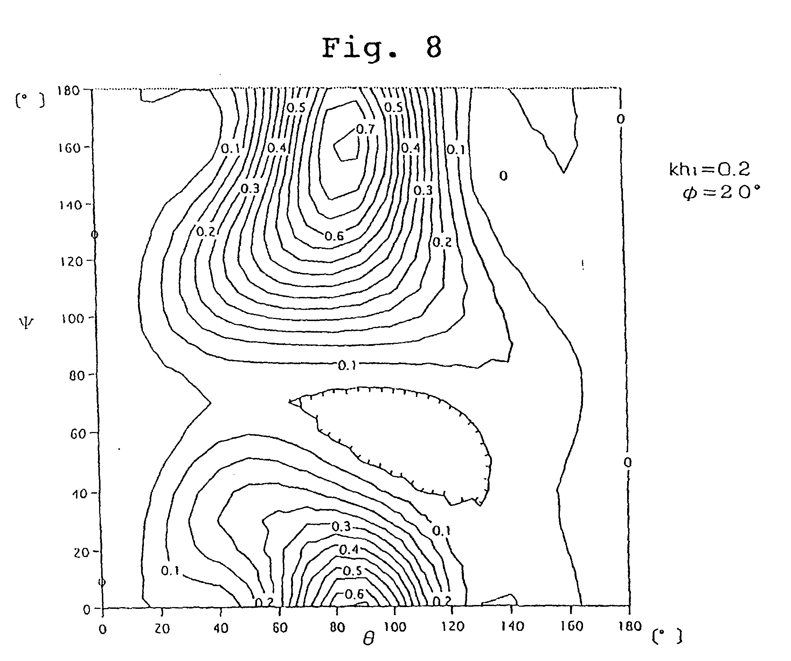

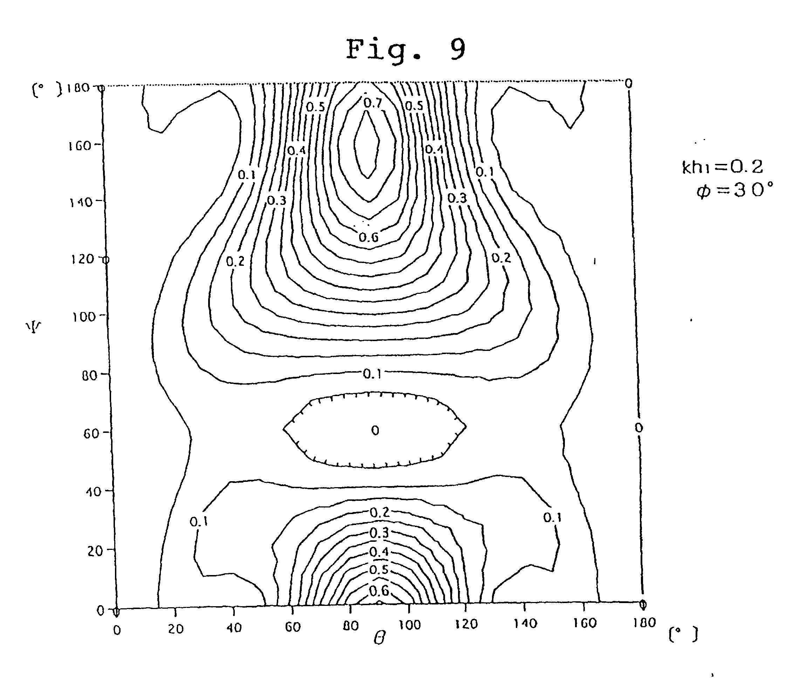

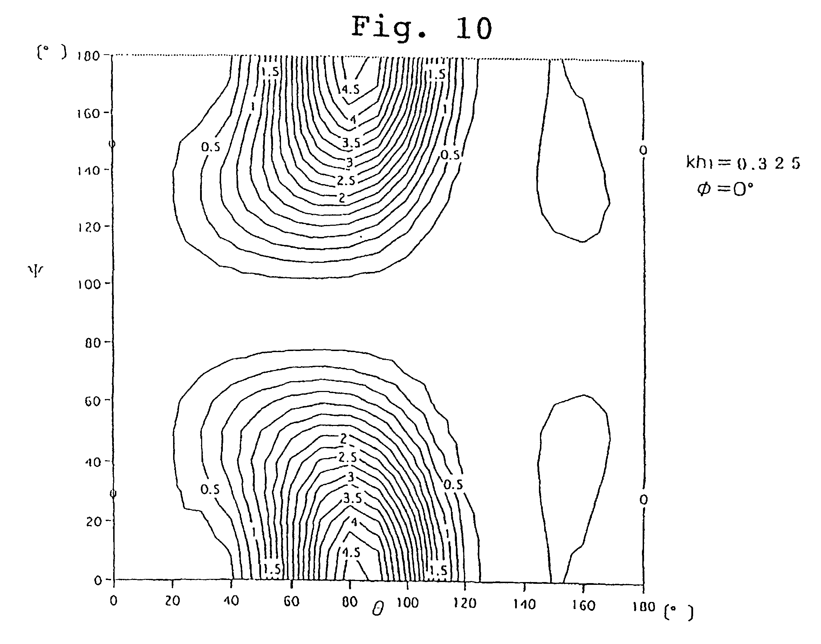

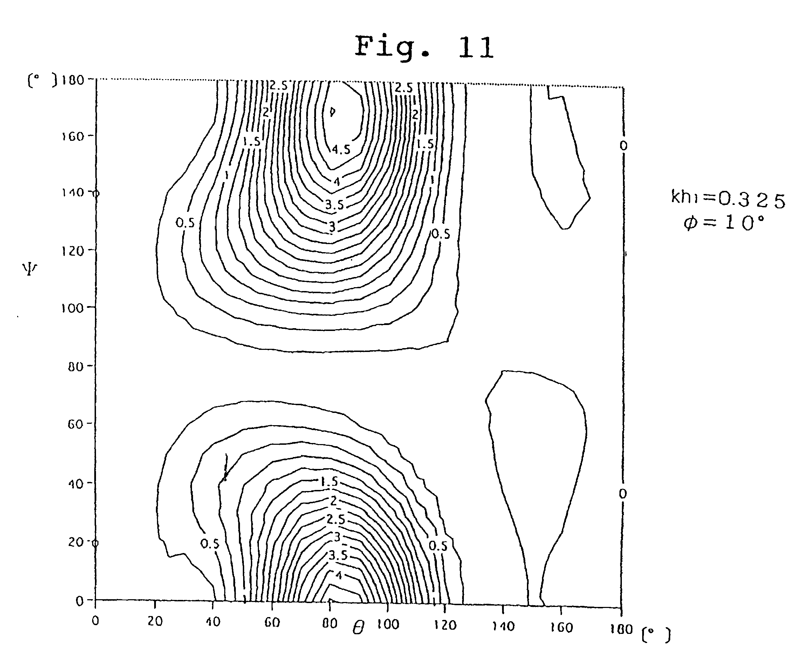

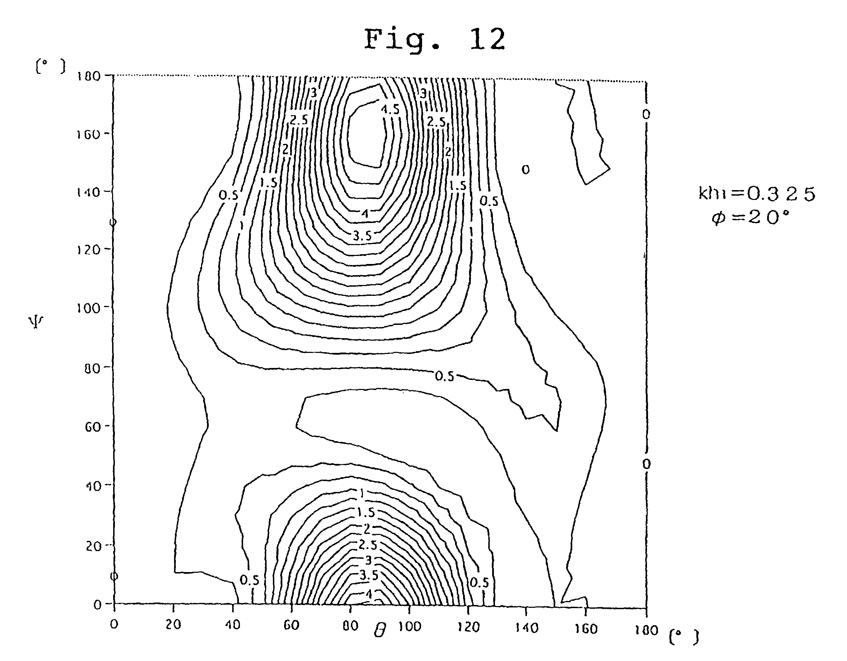

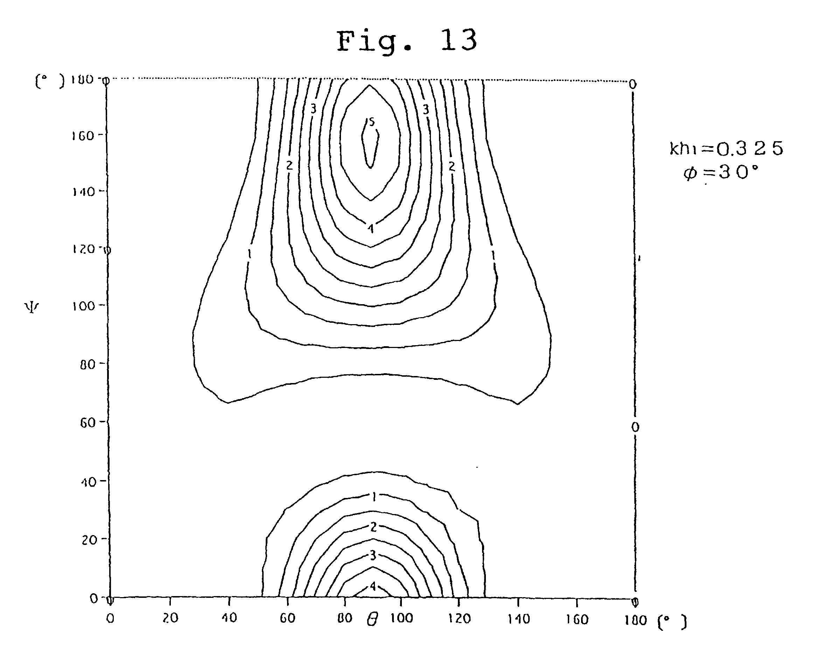

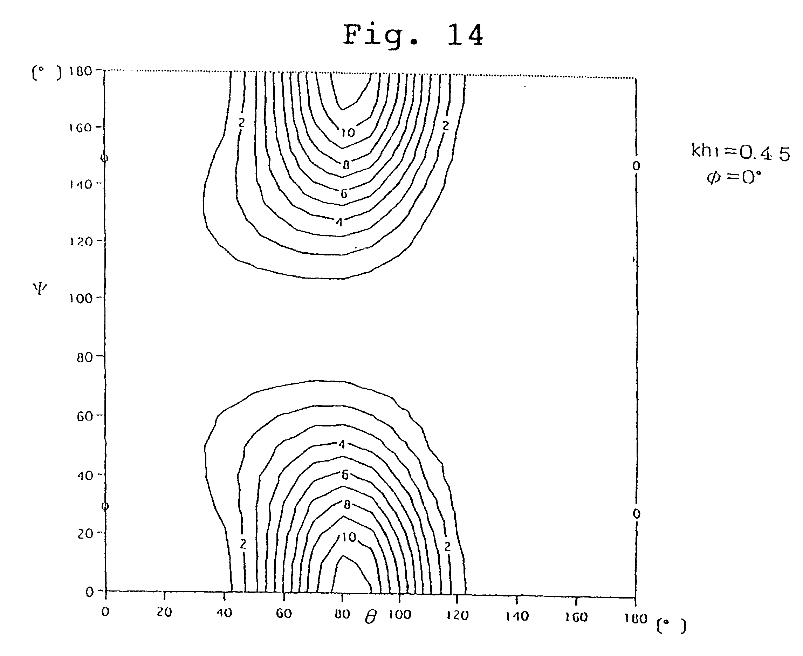

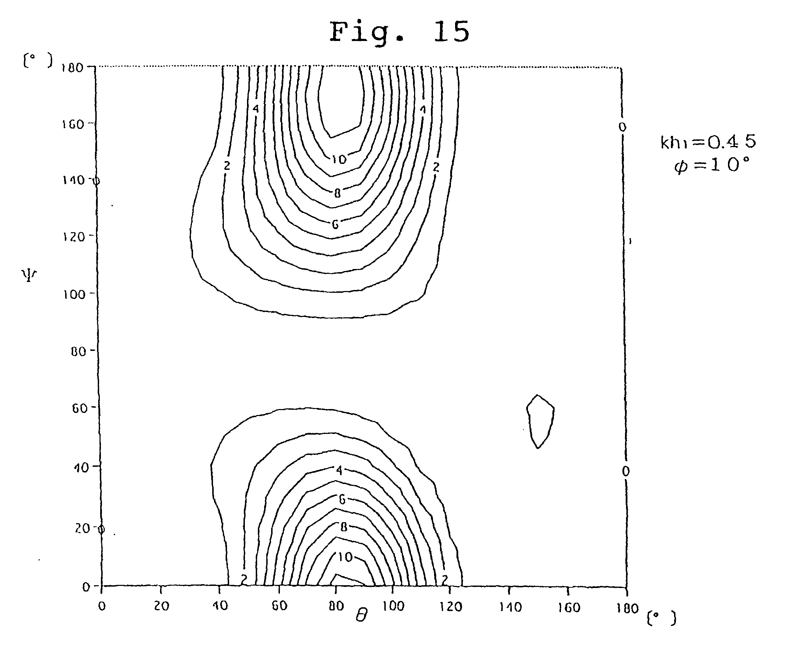

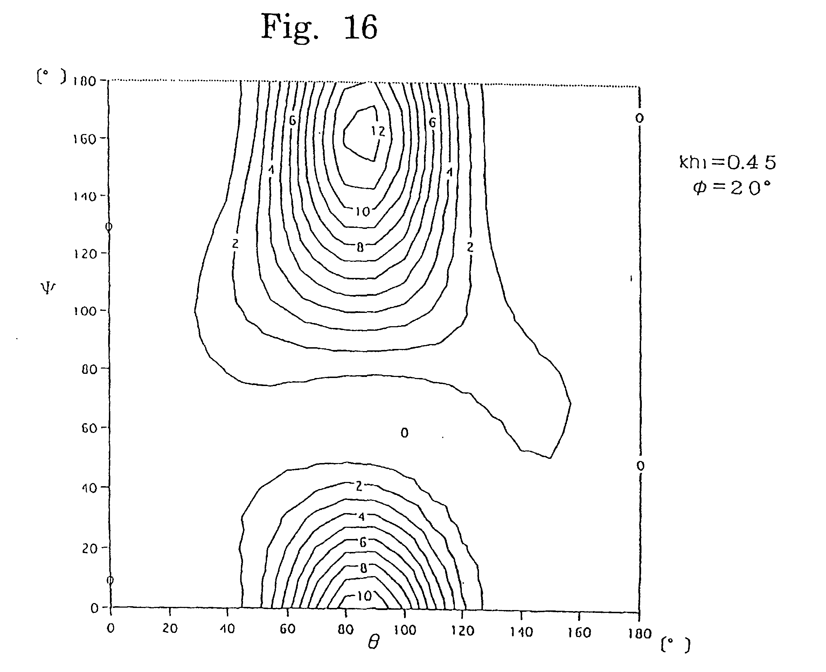

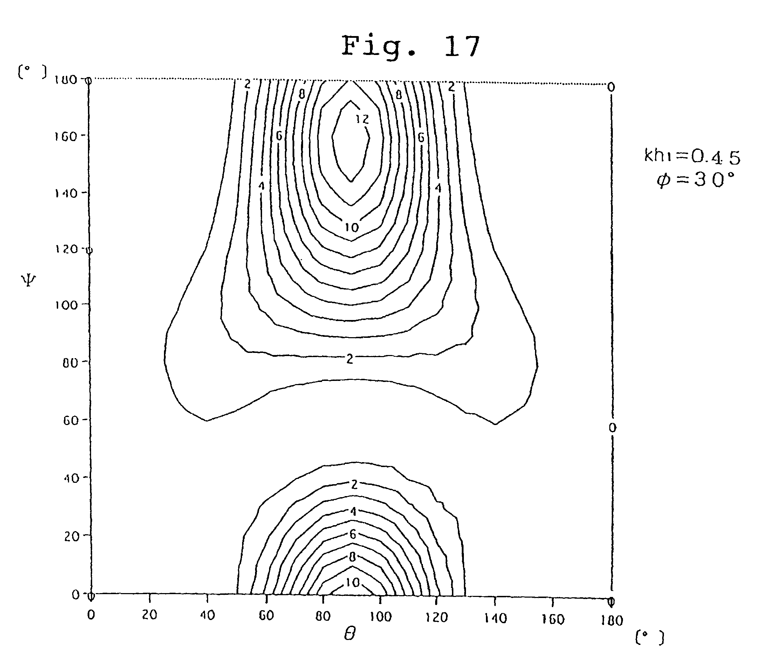

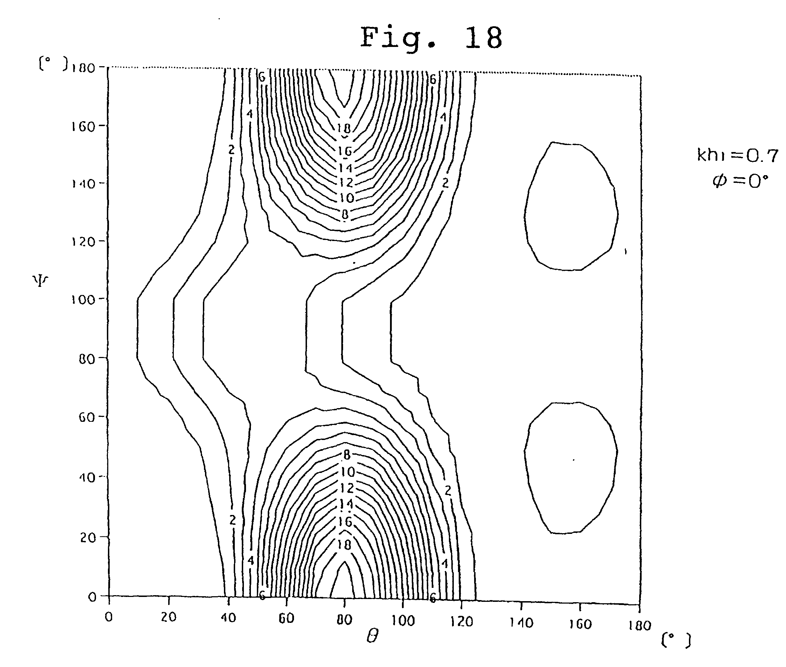

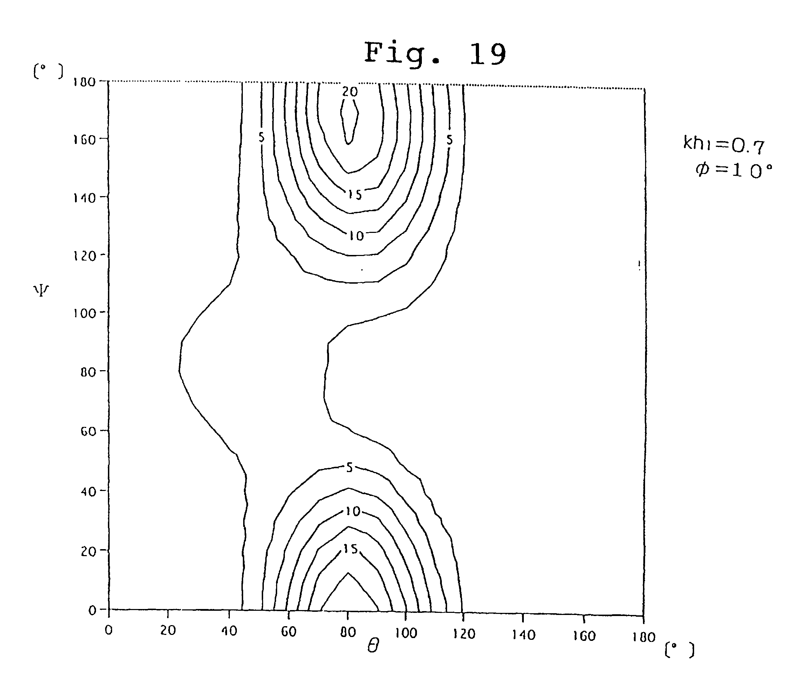

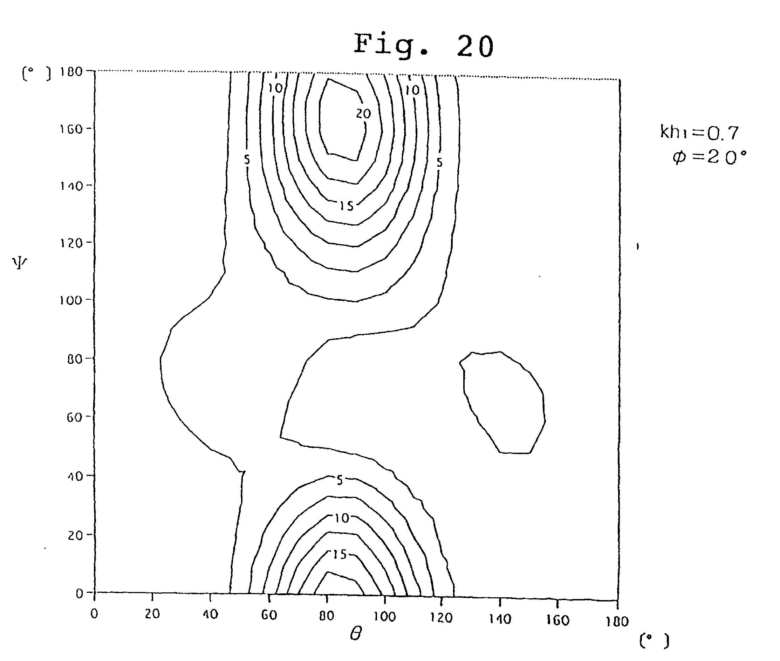

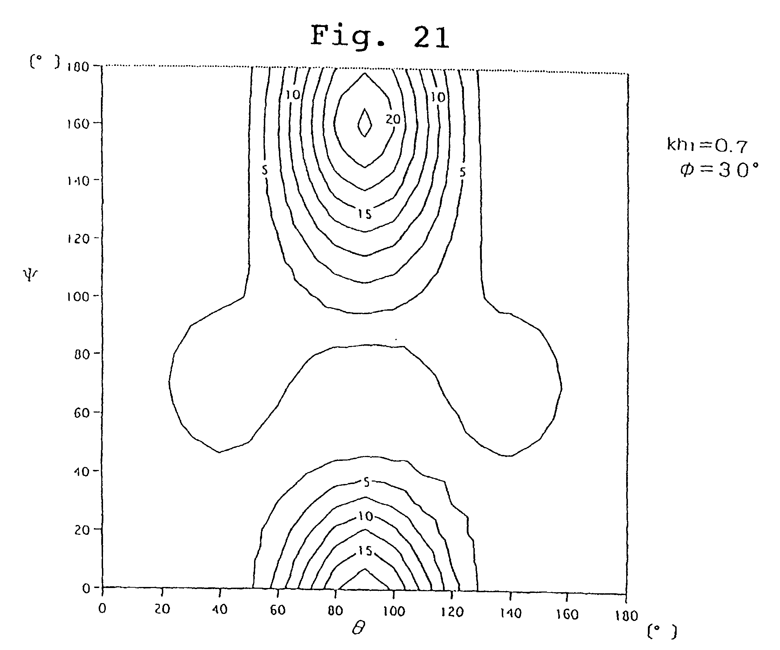

Figs. 6 to 21 are graphs showing contour lines obtained upon evaluating the electromechanical coupling coefficient $K^2$ [%] under conditions that $kh_1 = 0.20$, 0.325, 0.45, and 0.7, $\phi = 0°$, 10°, 20°, and 30°, $0° \leq \theta \leq 180°$, and $0° \leq \psi \leq 180°$. Note that the values $\theta$ and $\psi$ are plotted in units of 10° in these graphs.

Regions for satisfying the electromechanical coupling coefficient $K^2$ of 10% or more are obtained from Figs. 6 to 21. Taking the symmetry of the $LiNbO_3$ crystal into consideration, it is confirmed that, when the propagation velocity V is 8,000 m/s or more, and the electromechanical coupling coefficient $K^2$ is 10% or more, the value $\phi$ is arbitrarily set within the range of $0° \leq \phi \leq 360°$, and the remaining parameters $kh_1$, $\theta$, and $\psi$ are set, on the orthogonal coordinate system $(kh_1, \theta, \psi)$, in the internal regions of the four hexahedrons represented by (i) or (ii).

(Second Embodiment)

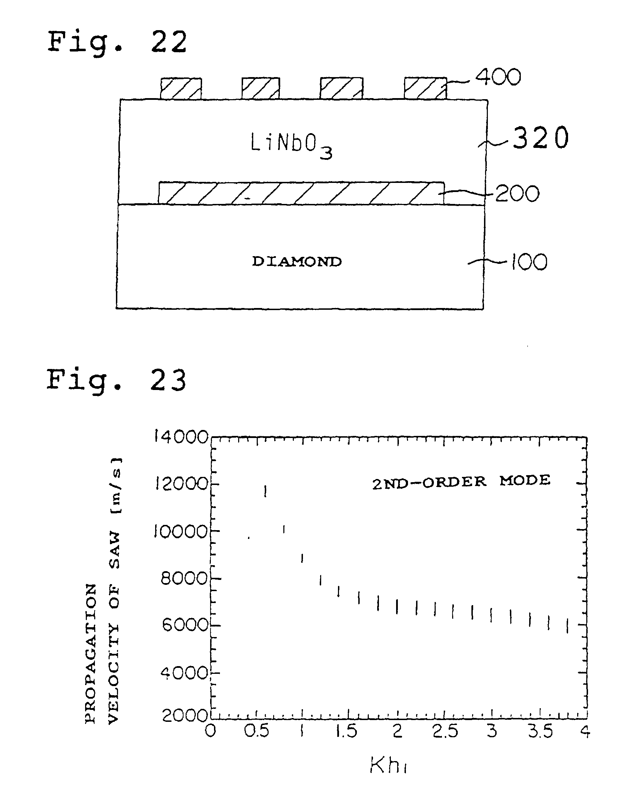

Fig. 22 is a sectional view showing the structure of an SAW device according to the second embodiment of the present invention. As shown in Fig. 22, the SAW device of the second embodiment is different from that of the first embodiment only in that an SAW in the 2nd-order mode is used, and an $LiNbO_3$ layer 320 is formed in place of the $LiNbO_3$ layer 310.

The $LiNbO_3$ layer 320 is formed by bonding a cut single crystal $LiNbO_3$ thin plate to diamond 100 having a short-circuit electrode 200 formed on its polished surface, and then polishing the single crystal $LiNbO_3$

thin plate.

For the LiNbO$_3$ layer 320, a thickness $t_1$ [μm] and a crystal orientation ($\theta$[°],$\phi$[°],$\psi$[°]) are selected from the following values. Note that $kh_1$ (= $2\pi(t_1/\lambda)$; $\lambda$ = the wavelength [μm] of an SAW) is used instead of the thickness $t_1$, as in the first embodiment.

(i) $0 \leq \phi \leq 15$, $45 + 60j \leq \phi \leq 75 + 60j$ (j = an integer of 0 to 4), or $345 \leq \phi \leq 360$. For integer pairs (i,k), i. e., (0,0), (0,1), (1,0), and (1,1) on an orthogonal coordinate system ($kh_1$,$\theta$,$\psi$), values in the internal regions of four hexahedrons each of which has, as its opposing bottom surfaces, a planar rectangular region with its vertexes at points $A_{21}^{ik}$, $B_{21}^{ik}$, $C_{21}^{ik}$, and $D_{21}^{ik}$ and a planar rectangular region with its vertexes at points $A_{22}^{ik}$, $B_{22}^{ik}$, $C_{22}^{ik}$, and $D_{22}^{ik}$,
where

point $A_{21}^{ik}$ = (0.6,60+180i,40+180k)
point $B_{21}^{ik}$ = (0.6,110+180i,40+180k)
point $C_{21}^{ik}$ = (0.6,110+180i,120+180k)
point $D_{21}^{ik}$ = (0.6,60+180i,120+180k)
point $A_{22}^{ik}$ = (0.85,50+180i,70+180k)
point $B_{22}^{ik}$ = (0.85,130+180i,0+180k)
point $C_{22}^{ik}$ = (0.85,130+180i,180+180k)
point $D_{22}^{ik}$ = (0.85,50+180i,100+180k).

(ii) $0 \leq \phi \leq 15$, $45 + 60j \leq \phi \leq 75 + 60j$ (j = an integer of 0 to 4), or $345 \leq \phi \leq 360$. For the integer pairs (i, k), i.e., (0,0), (0,1), (1,0), and (1,1) on the orthogonal coordinate system ($kh_1$,$\theta$,$\psi$), values in the internal regions of four hexahedrons each of which has, as its opposing bottom surfaces, the planar rectangular region with its vertexes at the points $A_{22}^{ik}$, $B_{22}^{ik}$, $C_{22}^{ik}$, and $D_{22}^{ik}$ and a planar rectangular region with its vertexes at points $A_{23}^{ik}$, $B_{23}^{ik}$, $C_{23}^{ik}$, and $D_{23}^{ik}$,
where

point $A_{23}^{ik}$ = (1.1, 40+180i, 60+180k)
point $B_{23}^{ik}$ = (1.1,140+180i,0+180k)
point $C_{23}^{ik}$ = (1.1,140+180i,180+180k)
point $D_{23}^{ik}$ = (1.1,40+180i,110+180k).

(iii) $15 + 60j \leq \phi) \leq 45 + 60j$ (j = an integer of 0 to 5). For the integer pairs (i,k), i.e., (0,0), (0,1), (1,0), and (1,1) on the orthogonal coordinate system ($kh_1$,$\theta$, $\psi$), values in the internal regions of four hexahedrons each of which has, as its opposing bottom surfaces, a planar rectangular region with its vertexes at points $A_{24}^{ik}$, $B_{24}^{ik}$, $C_{24}^{ik}$, and $D_{24}^{ik}$ and a planar rectangular region with its vertexes at points $A_{25}^{ik}$, $B_{25}^{ik}$, $C_{25}^{ik}$, and $D_{25}^{ik}$,
where

point $A_{24}^{ik}$ = (0.6,60+180i,30+180k)
point $B_{24}^{ik}$ = (0.6,120+180i,30+180k)
point $C_{24}^{ik}$ = (0.6,120+180i,100+180k)
point $D_{24}^{ik}$ = (0.6,60+180i,100+180k)

point $A_{25}^{ik}$ = (0.85,50+180i,30+180k)
point $B_{25}^{ik}$ = (0.85,130+180i,30+180k)
point $C_{25}^{ik}$ = (0.85,130+180i,110+180k)
point $D_{25}^{ik}$ = (0.85,50+180i,110+180k).

(iv) $15 + 60 j \leq \phi \leq 45 + 60j$ (j = an integer of 0 to 5). For the integer pairs (i,k), i.e., (0,0), (0,1), (1,0), and (1,1) on the orthogonal coordinate system ($kh_1$,$\theta$, $\psi$), values in the internal regions of four hexahedrons each of which has, as its opposing bottom surfaces, the planar rectangular region with its vertexes at the points $A_{25}^{ik}$, $B_{25}^{ik}$, $C_{25}^{ik}$, and $D_{25}^{ik}$ and a planar rectangular region with its vertexes at points $A_{26}^{ik}$, $B_{26}^{ik}$, $C_{26}^{ik}$, and $D_{26}^{ik}$,
where

point $A_{25}^{ik}$ = (1.1, 40+180i , 30+180k)
point $B_{26}^{ik}$ = (1.1,140+180i,30+180k)
point $C_{26}^{ik}$ = (1.1,140+180i,120+180k)
point $D_{26}^{ik}$ = (1.1,40+180i,120+180k).

In the structure of the SAW device according to the second embodiment, a propagation velocity V is exclusively determined by $kh_1$ of the LiNbO$_3$ layer 320. Fig. 23 is a graph showing the relationship between $kh_1$ of the LiNbO$_3$ layer 320 and the propagation velocity V of an SAW in the 2nd-order mode in the SAW device of the second embodiment. It is confirmed from Fig. 23 that, when $kh_1$ is equal to or smaller than 1.1, a propagation velocity V equal to or higher than 8,000 m/s is ensured.

The present inventors set the thickness of the diamond 100 at 20 μm, and evaluated an electromechanical coupling coefficient $K^2$ while changing $kh_1$ within the above-described limitation for $kh_1$ and simultaneously changing the values $\theta$, $\phi$, and $\psi$.

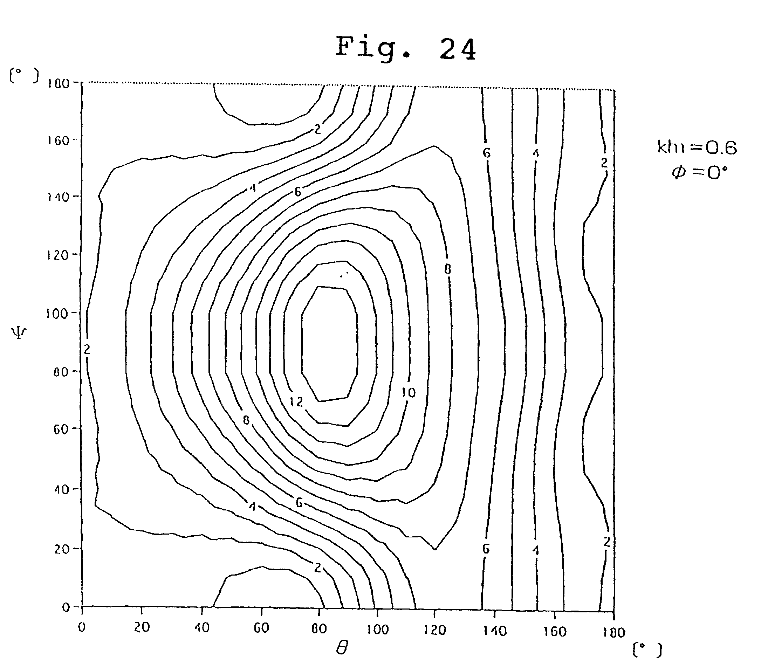

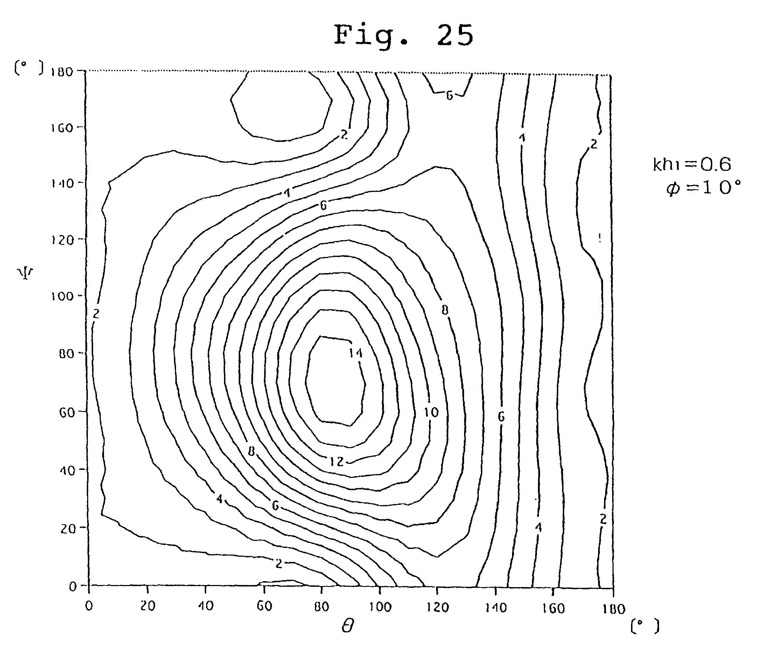

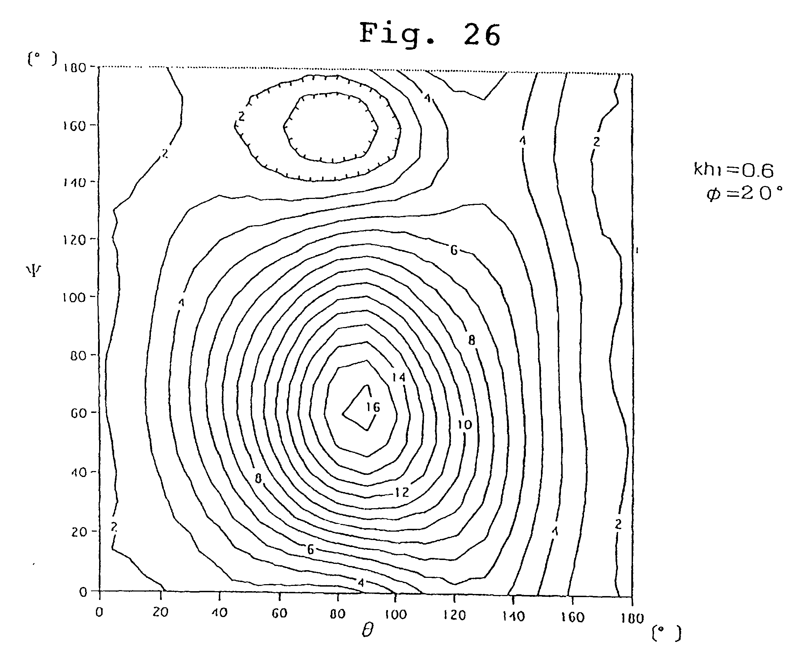

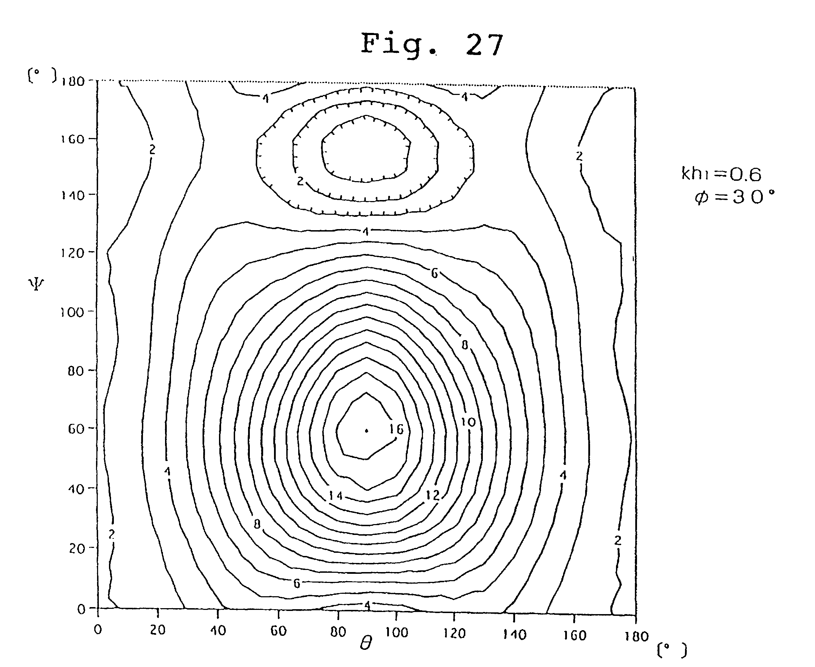

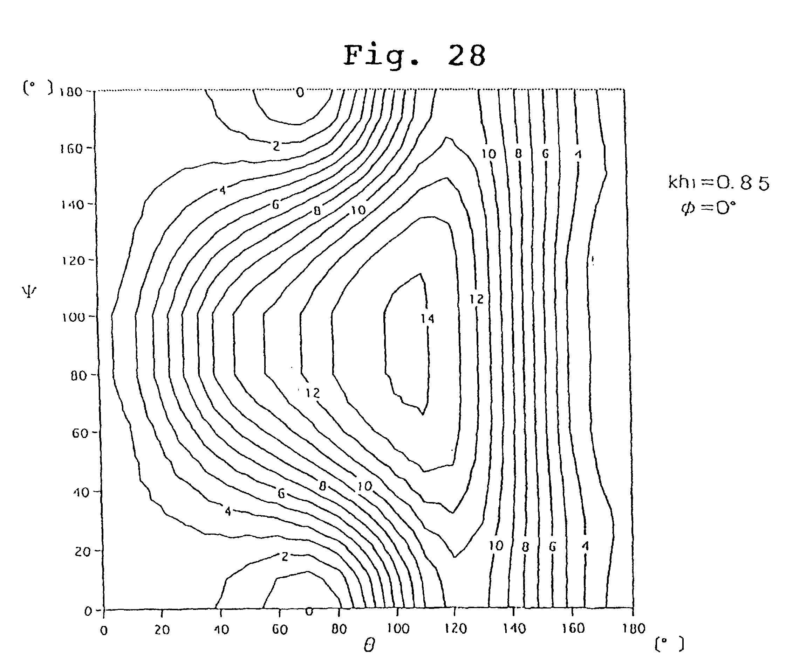

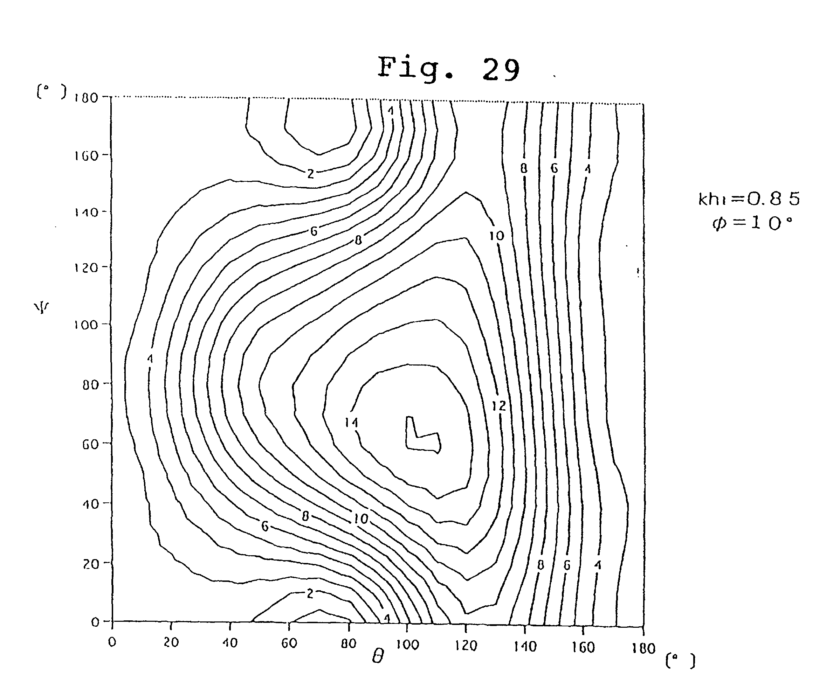

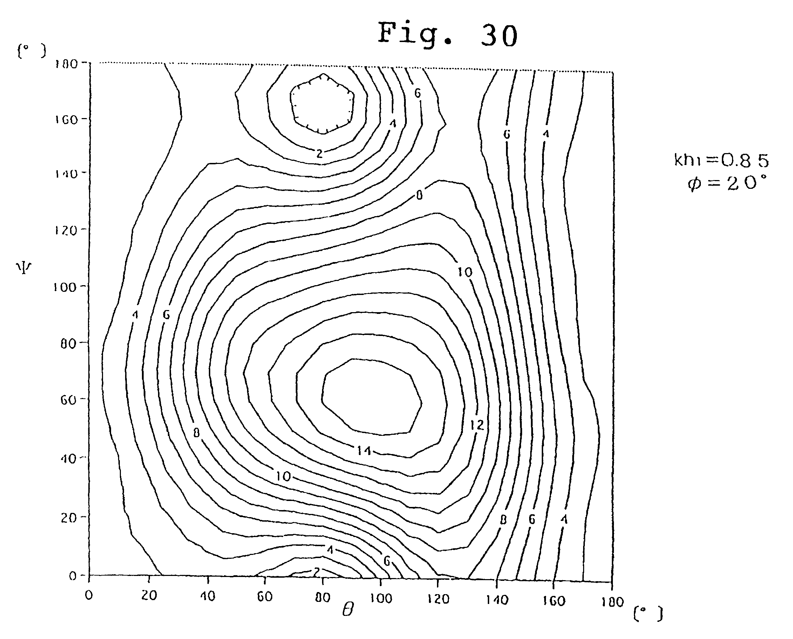

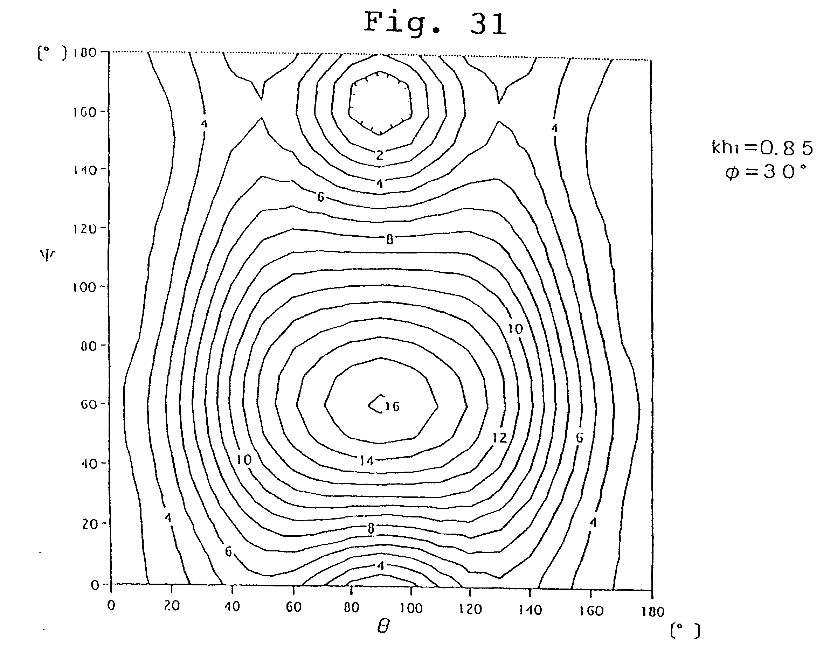

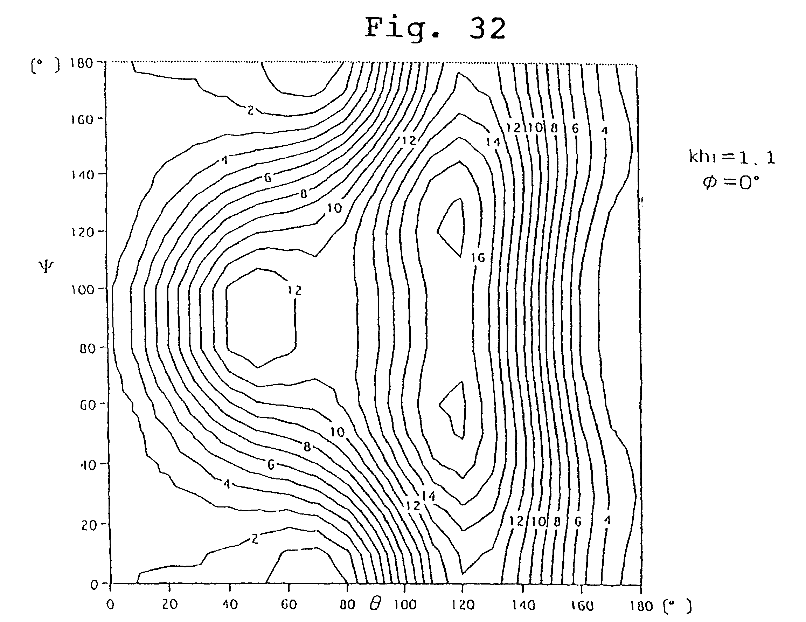

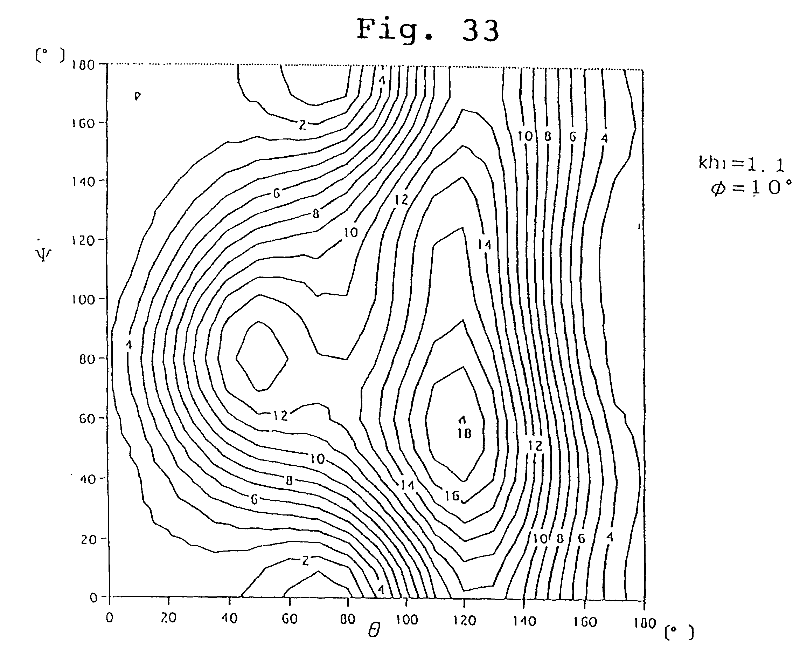

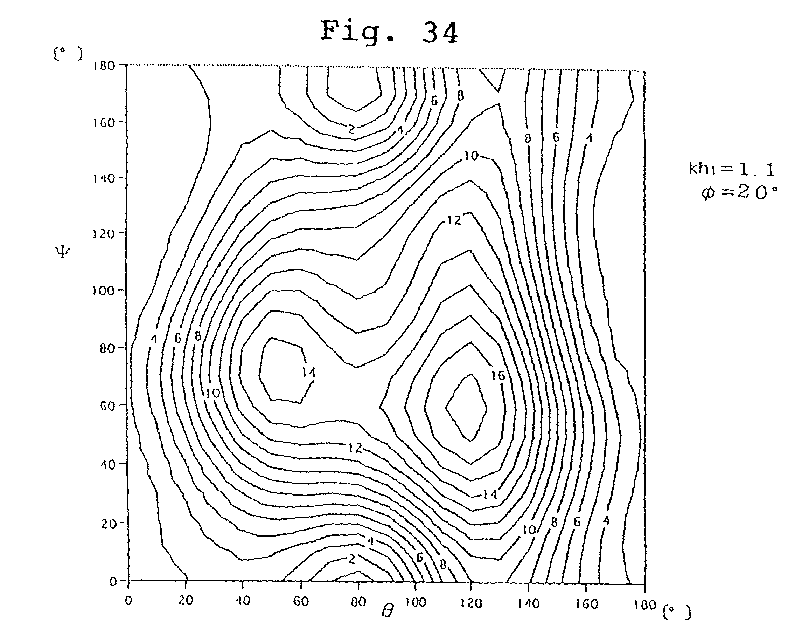

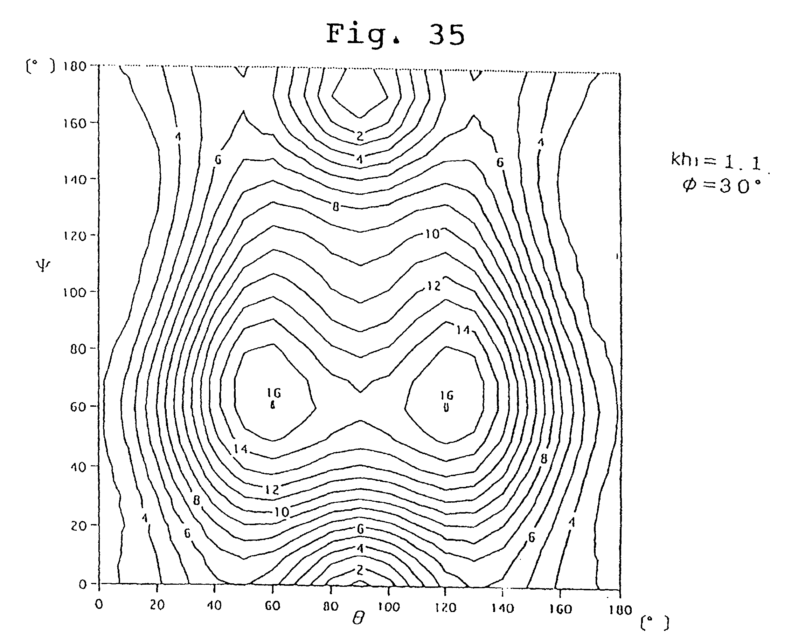

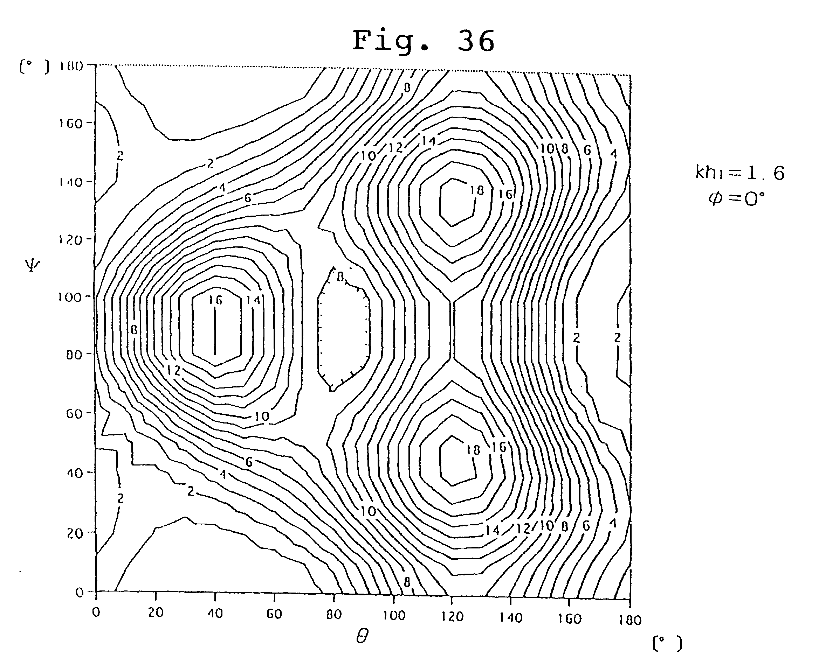

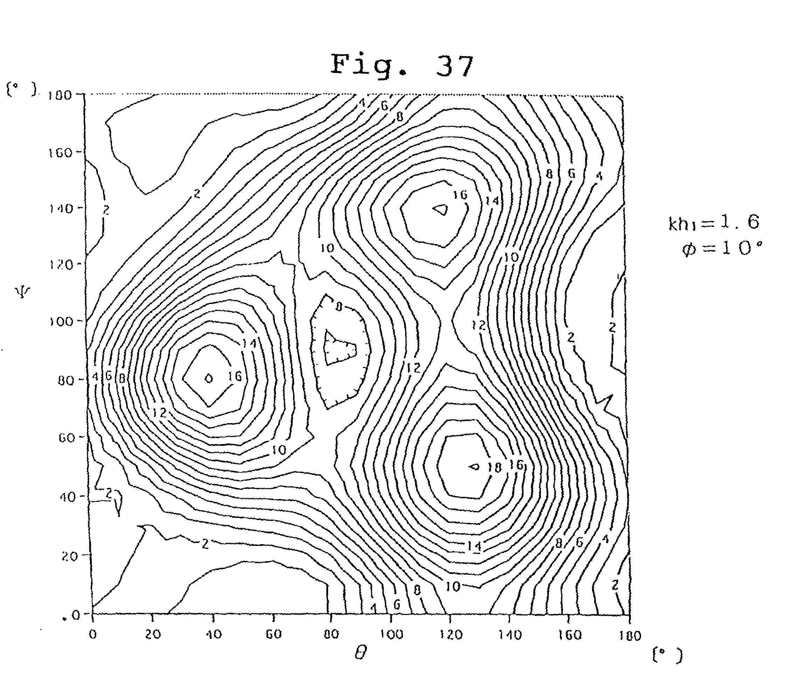

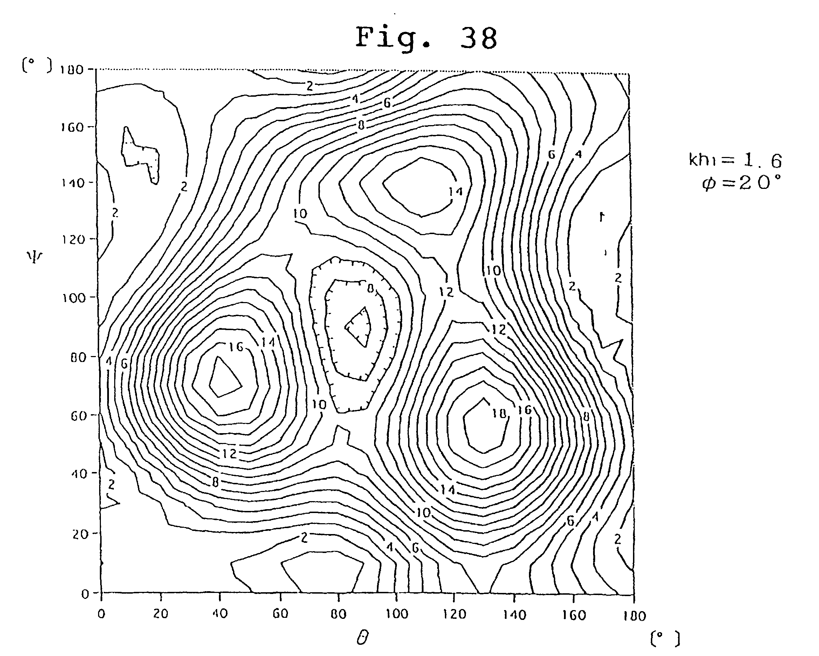

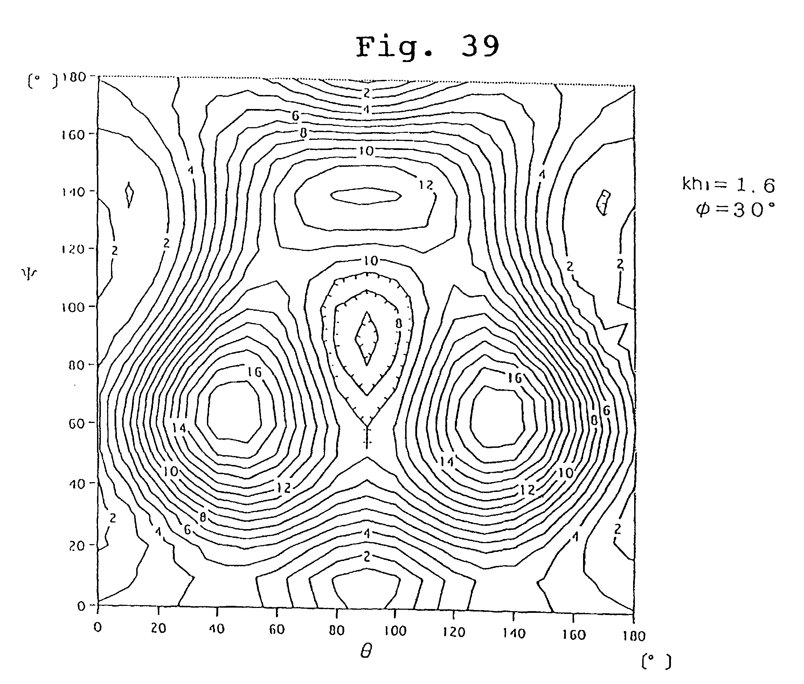

Figs. 24 to 39 are graphs showing contour lines obtained upon evaluating the electromechanical coupling coefficient $K^2$ [%] under conditions that $kh_1$ = 0.6, 0.85, 1.1, and 1.6, $\phi$ = 0°, 10°, 20°, and 30°, $0° \leq \theta \leq$ 180°, and $0° \leq \psi \leq$ 180°. Note that the values $\theta$ and $\psi$ are plotted in units of 10° in these graphs.

Regions for satisfying the electromechanical coupling coefficient $K^2$ of 10% or more are obtained from Figs. 24 to 39. Taking the symmetry of the LiNbO$_3$ crystal into consideration, it is confirmed that, when the propagation velocity V is 8,000 m/s or more, and the electromechanical coupling coefficient $K^2$ is 10% or more, the four parameters $kh_1$, $\theta$, $\phi$, and $\psi$ are set in the internal regions of the four hexahedrons represented by (i), (ii), (iii), or (iv).

(Third Embodiment)

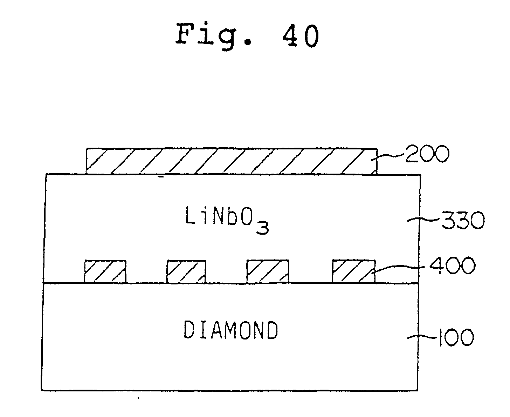

Fig. 40 is a sectional view showing the structure of an SAW device according to the third embodiment of the present invention. As shown in Fig. 40, the SAW device of the third embodiment comprises (a) diamond 100, (b) an interdigital transducer 400 formed on the diamond 100, (c) a single crystal $LiNbO_3$ layer 330 formed on the interdigital transducer 400, and (d) a short-circuit electrode 200 formed on the $LiNbO_3$ layer 330.

The SAW device of the third embodiment uses an SAW in the 1st-order mode.

The $LiNbO_3$ layer 330 is formed by bonding a cut single crystal $LiNbO_3$ thin plate to the diamond 100 having the interdigital transducer 400 formed on its polished surface, and then polishing the single crystal $LiNbO_3$ thin plate. For the interdigital transducer 400, preferably, a recessed portion is formed in the diamond 100 by reactive ion etching, the interdigital transducer 400 is formed with Al or the like in this recessed portion, and the interface to the $LiNbO_3$ layer 330 is entirely flattened.

For the $LiNbO_3$ layer 330, a thickness $t_1$ [µm] and a crystal orientation $(\theta[°],\phi[°],\psi[°])$ are selected from the following values. Note that $kh_1$ $(= 2\pi(t_1/\lambda)$; $\lambda$ = the wavelength [µm] of an SAW) is used instead of the thickness $t_1$, as in the first embodiment.

(i) $0 \leq \phi \leq 15$, $45 + 60j \leq \phi \leq 75 + 60j$ (j = an integer of 0 to 4), or $345 \leq \phi \leq 360$. For integer pairs (i,k), i. e., (0,0), (0,1), (1,0), and (1,1) on an orthogonal coordinate system $(kh_1,\theta,\psi)$, values in the internal regions of four quadrangular pyramids each of which has its vertex at a point $P_{31}^{ik}$ and, as its bottom surface, a planar rectangular region with its vertexes at points $A_{31}^{ik}$, $B_{31}^{ik}$, $C_{31}^{ik}$, and $D_{31}^{ik}$,
where

point $P_{31}^{ik} = (0.45,90+180i,150+180k)$
point $A_{31}^{ik} = (0.7,70+180i,130+180k)$
point $B_{31}^{ik} = (0.7,90+180i,130+180k)$
point $C_{31}^{ik} = (0.7,90+180i,180+180k)$
point $D_{31}^{ik} = (0.7,70+180i,180+180k)$.

(ii) $15 + 60j \leq \phi \leq 45 + 60j$ (j = an integer of 0 to 5). For the integer pairs (i,k), i.e., (0,0), (0,1), (1,0), and (1,1) on the orthogonal coordinate system $(kh_1,\theta,\psi)$, values in the internal regions of four hexahedrons each of which has, as its opposing bottom surfaces, a planar rectangular region with its vertexes at points $A_{32}^{ik}$, $B_{32}^{ik}$, $C_{32}^{ik}$, and $D_{32}^{ik}$ and a planar rectangular region with its vertexes at points $A_{33}^{ik}$, $B_{33}^{ik}$, $C_{33}^{ik}$, and $D_{33}^{ik}$,
where

point $A_{32}^{ik} = (0.45,80+180i,130+180k)$
point $B_{32}^{ik} = (0.45,100+180i,130+180k)$
point $C_{32}^{ik} = (0.45,100+180i,150+180k)$
point $D_{32}^{ik} = (0.45,80+180i,150+180k)$
point $A_{33}^{ik} = (0.7,70+180i,120+180k)$
point $B_{33}^{ik} = (0.7,110+180i,120+180k)$
point $C_{33}^{ik} = (0.7,110+180i,160+180k)$
point $D_{33}^{ik} = (0.7,70+180i,160+180k)$.

In the structure of the SAW device according to the third embodiment, a propagation velocity V is exclusively determined by $kh_1$ of the $LiNbO_3$ layer 330, as in the first embodiment, as shown in Fig. 5. Therefore, as in the first embodiment, it is confirmed that, when $kh_1$ is equal to or smaller than 1.1, a propagation velocity V equal to or higher than 8,000 m/s is ensured.

The present inventors set the thickness of the diamond 100 at 20 µm, and evaluated an electromechanical coupling coefficient $K^2$ while changing $kh_1$ within the above-described limitation for $kh_1$ and simultaneously changing the values $\theta$, $\phi$, and $\psi$.

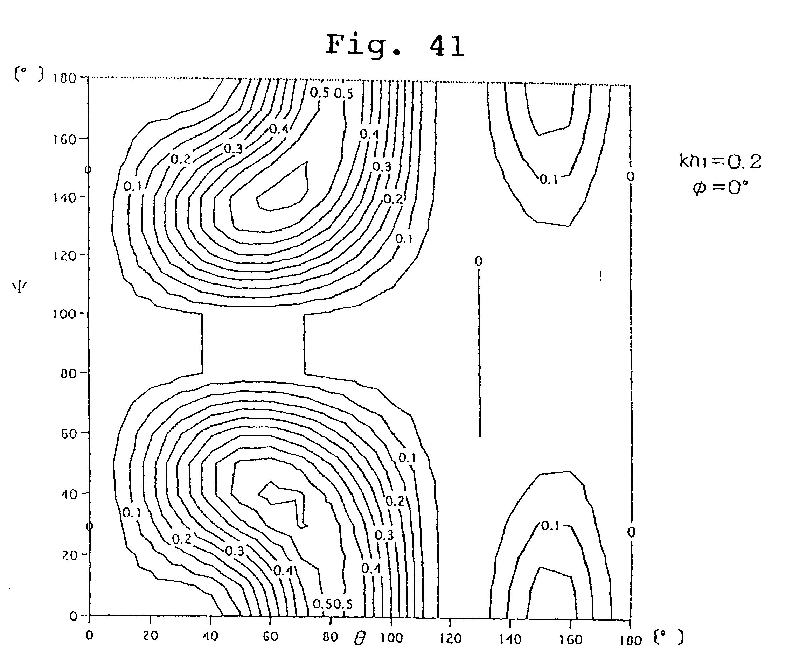

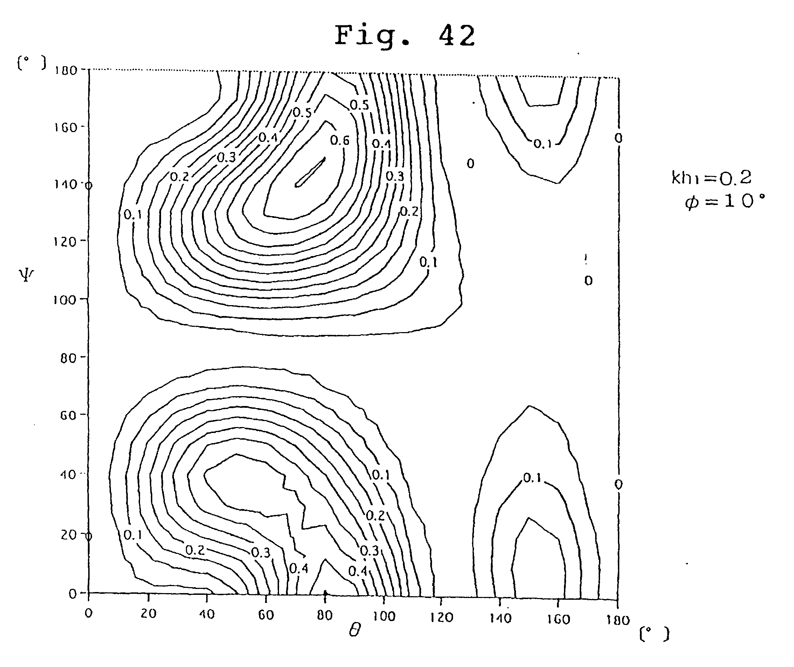

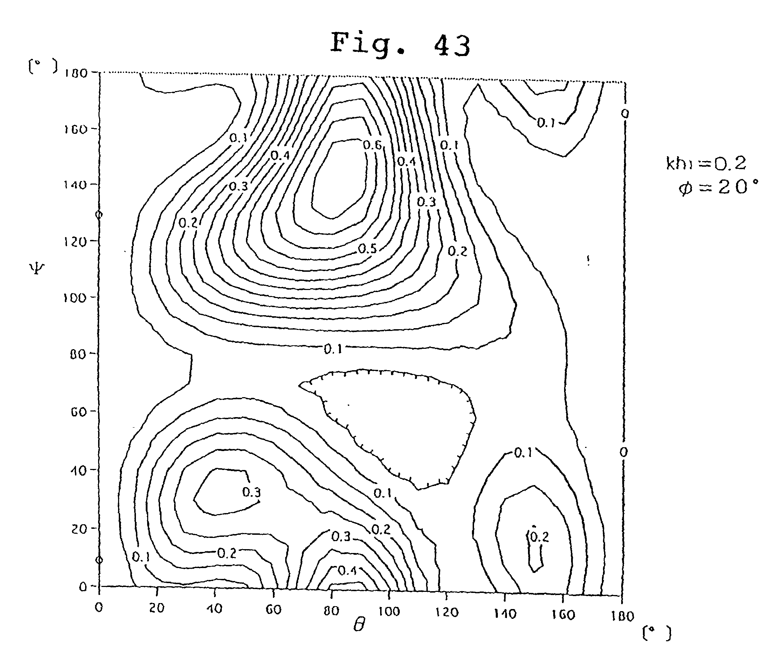

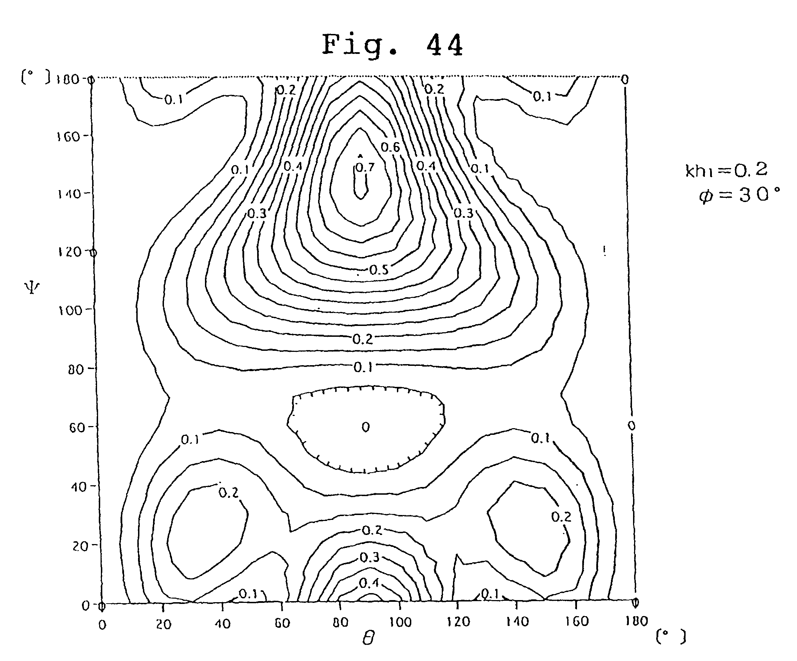

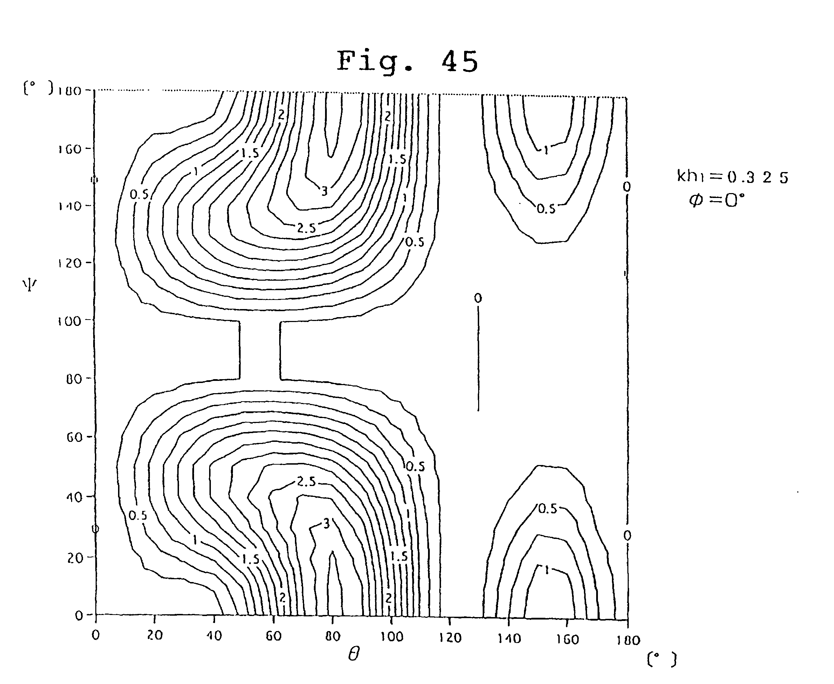

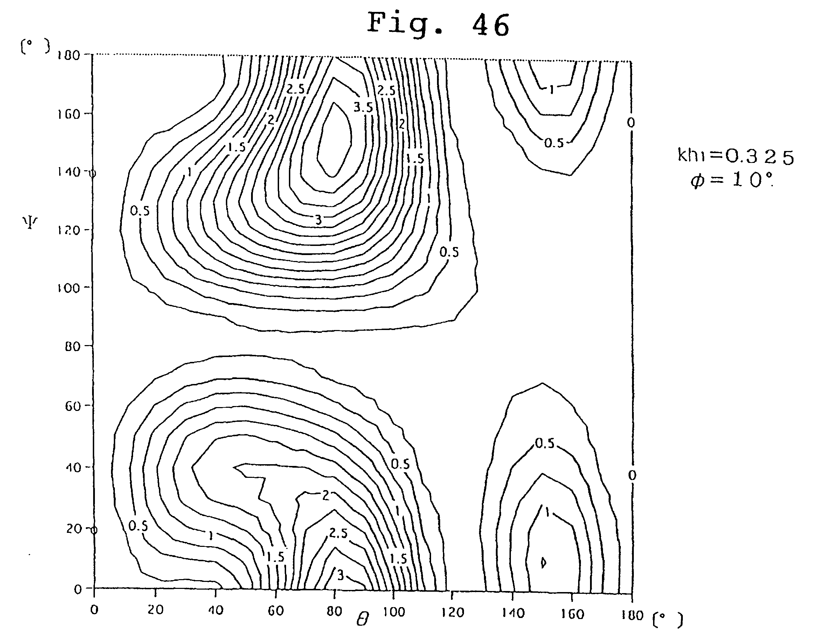

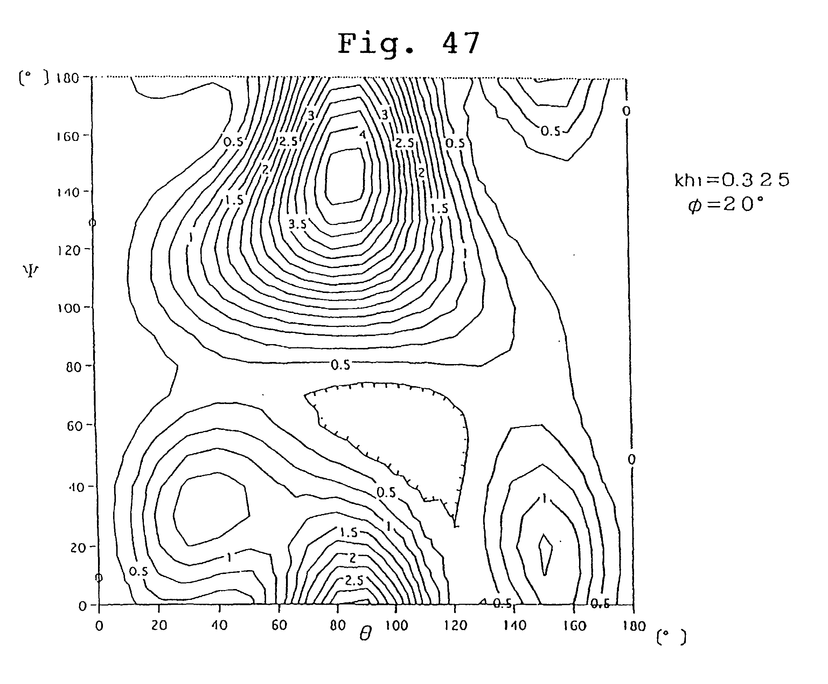

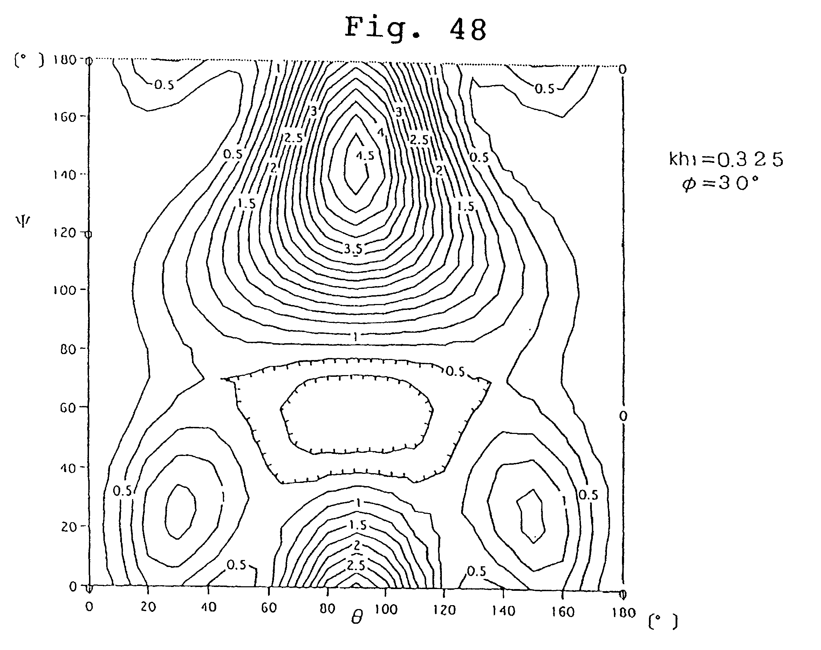

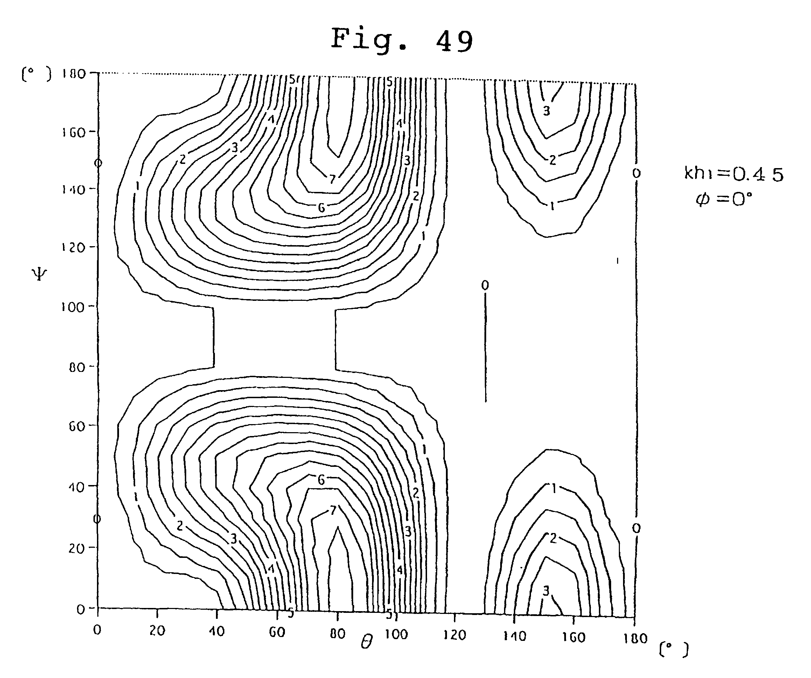

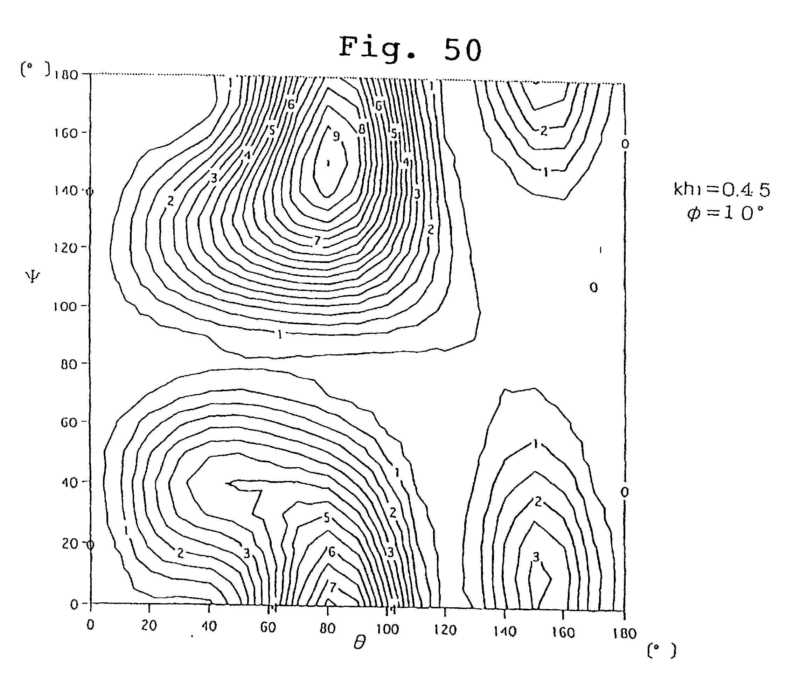

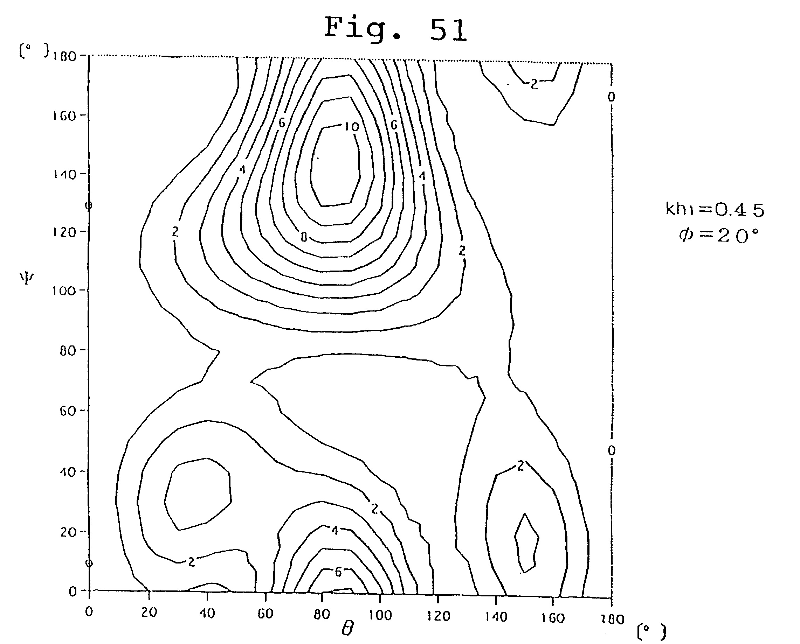

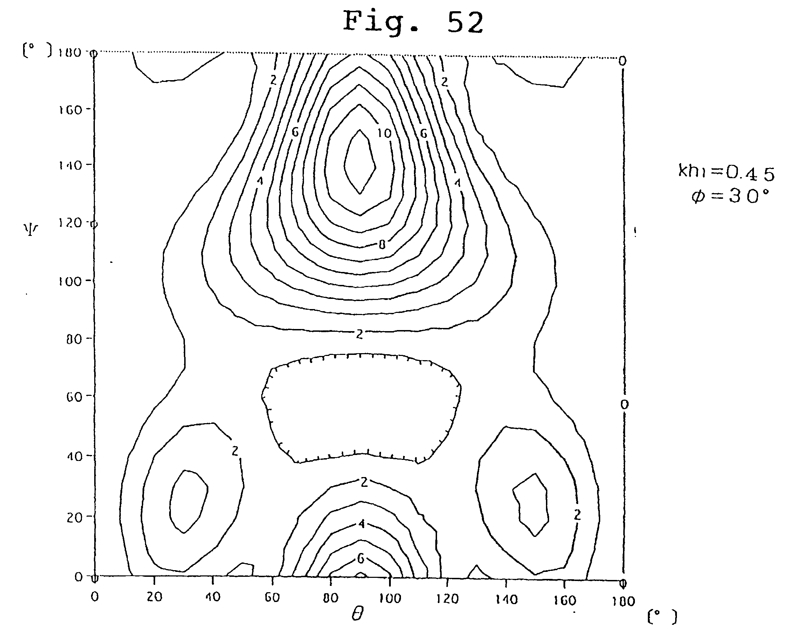

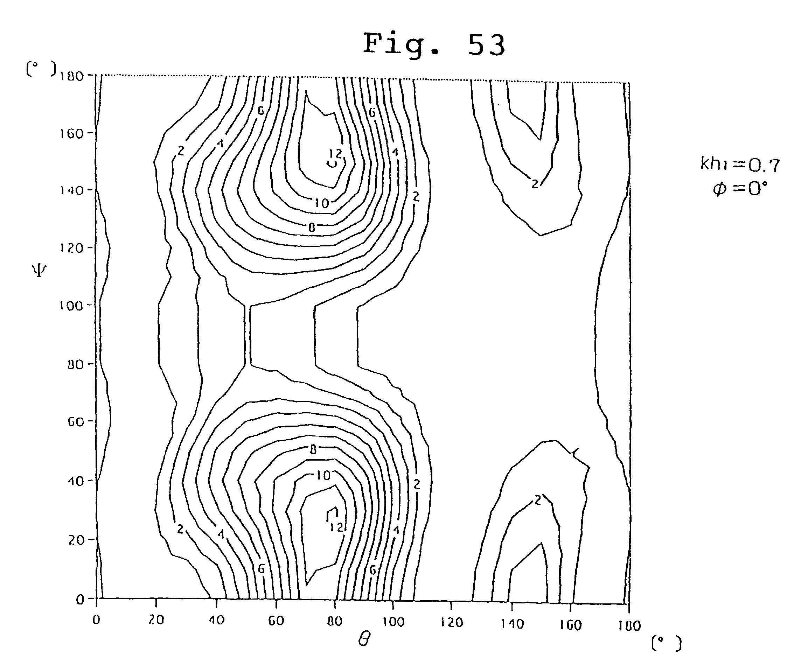

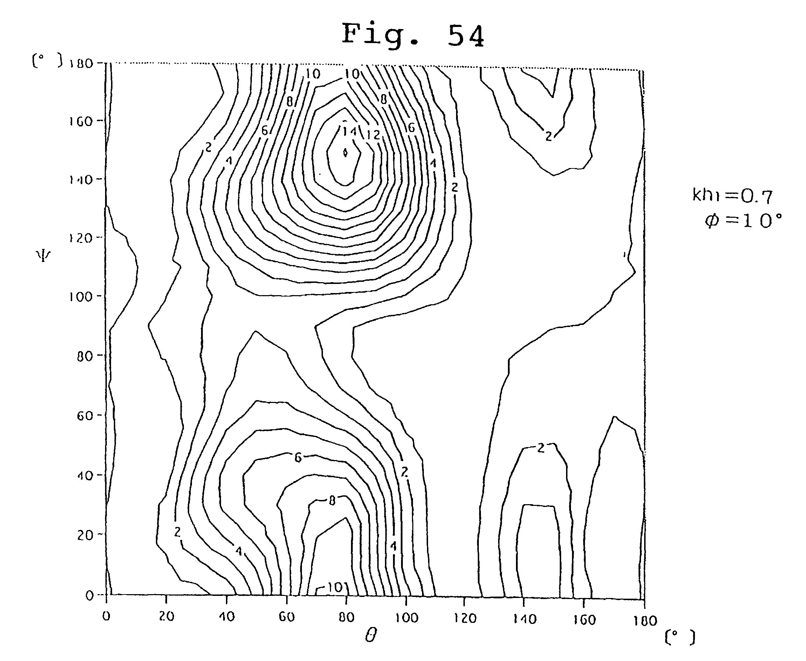

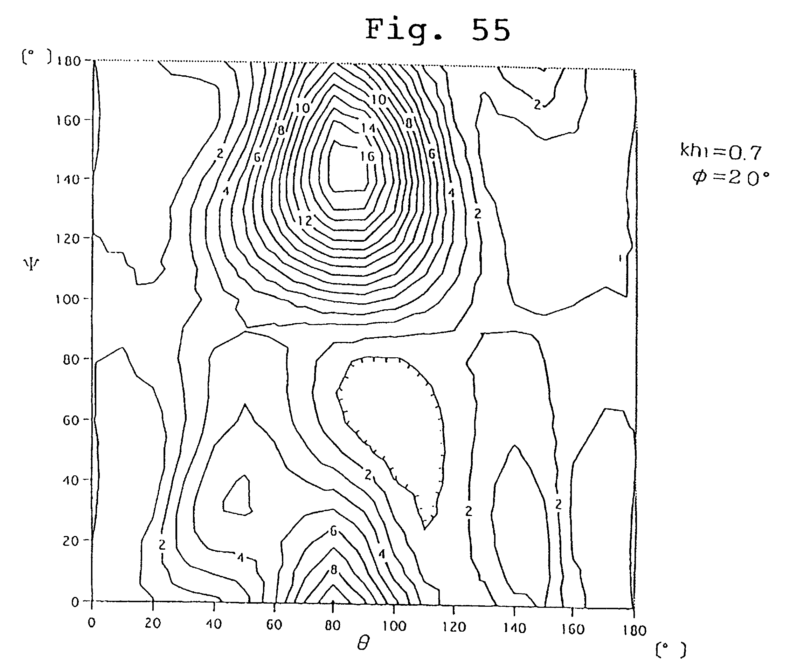

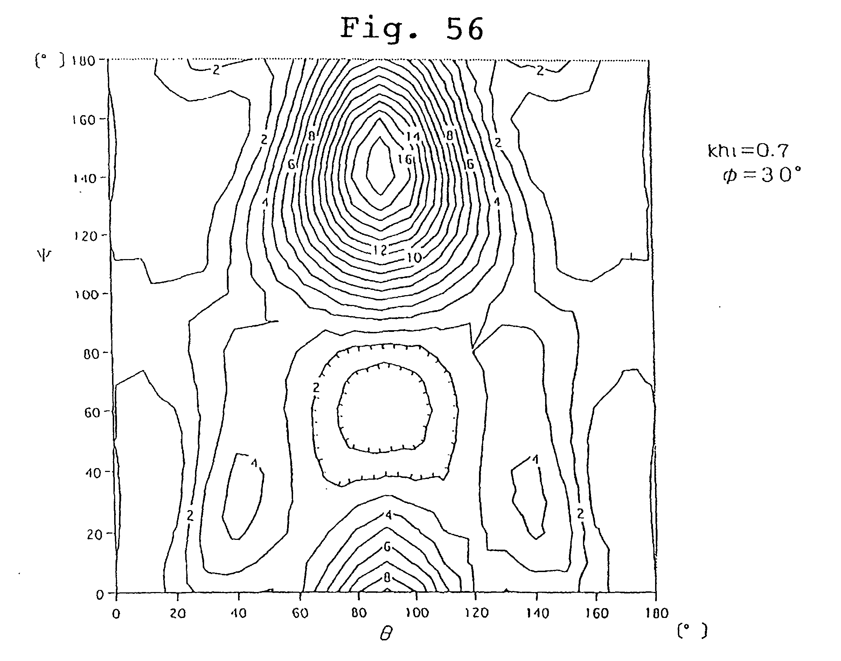

Figs. 41 to 56 are graphs showing contour lines obtained upon evaluating the electromechanical coupling coefficient $K^2$ [%] under conditions that $kh_1$ = 0.2, 0.325, 0.45, and 0.7, $\phi = 0°$, $10°$, $20°$, and $30°$, $0° \leq \theta \leq 180°$, and $0° \leq \psi \leq 180°$. Note that the values $\theta$ and $\psi$ are plotted in units of $10°$ in these graphs.

Regions for satisfying the electromechanical coupling coefficient $K^2$ of 10% or more are obtained from Figs. 41 to 56. Taking the symmetry of the $LiNbO_3$ crystal into consideration, it is confirmed that, when the propagation velocity V is 8,000 m/s or more, and the electromechanical coupling coefficient $K^2$ is 10% or more, the four parameters $kh_1$, $\theta$, $\phi$, and $\psi$ are set in the internal regions of the four quadrangular pyramids represented by (i) or the four hexahedrons represented by (ii).

(Fourth Embodiment)

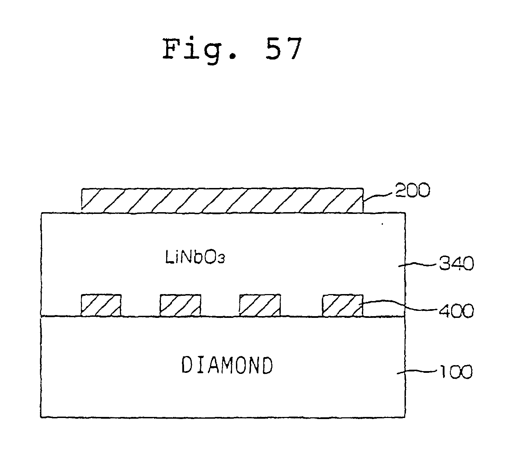

Fig. 57 is a sectional view showing the structure of an SAW device according to the fourth embodiment of the present invention. As shown in Fig. 57, the SAW device of the fourth embodiment is different from that of the third embodiment only in that an SAW in the 2nd-order mode is used, and an $LiNbO_3$ layer 340 is formed in place of the $LiNbO_3$ layer 330.

The $LiNbO_3$ layer 340 is formed by bonding a cut single crystal $LiNbO_3$ thin plate to diamond 100 having a short-circuit electrode 200 formed on its polished surface, and then polishing the single crystal $LiNbO_3$ thin plate. As in the third embodiment, for an interdigital transducer 400, preferably, a recessed portion is formed in the diamond 100 by reactive ion etching, the interdigital transducer 400 is formed with Al or the like in this recessed portion, and the interface to the $LiNbO_3$ layer 340 is entirely flattened.

For the $LiNbO_3$ layer 340, a thickness $t_1$ [µm] and a crystal orientation $(\theta[°],\phi[°],\psi[°])$ are selected from the following values. Note that $kh_1$ $(= 2\pi(t_1/\lambda)$; $\lambda$ = the wavelength [µm] of an SAW) is used instead of the thickness $t_1$, as in the first embodiment.

(i) $0 \leq \phi \leq 15$, $45 + 60j \leq \phi \leq 75 + 60j$ (j = an integer of 0 to 4), or $345 \leq \phi \leq 360$. For integer pairs (i,k), i. e., (0,0), (0,1), (1,0), and (1,1) on an orthogonal coordinate system $(kh_1,\theta,\psi)$, values in the internal regions of four hexahedrons each of which has, as its opposing bottom surfaces, a planar rectangular region with its vertexes at points $A_{41}^{ik}$, $B_{41}^{ik}$, $C_{41}^{ik}$, and $D_{41}^{ik}$ and a planar rectangular region with its vertexes at points $A_{42}^{ik}$, $B_{42}^{ik}$, $C_{42}^{ik}$, and $D_{42}^{ik}$,
where

> point $A_{41}^{ik}$ = (0.6,70+180i,40+180k)
> point $B_{41}^{ik}$ = (0.6,100+180i,40+180k)
> point $C_{41}^{ik}$ = (0.6,100+180i,110+180k)
> point $D_{41}^{ik}$ = (0.6,70+180i,110+180k)
> point $A_{42}^{ik}$ = (0.85,70+180i,60+180k)
> point $B_{42}^{ik}$ = (0.85,120+180i,0+180k)
> point $C_{42}^{ik}$ = (0.85,120+180i,180+180k)
> point $D_{42}^{ik}$ = (0.85,70+180i,100+180k).

(ii) $0 \leq \phi \leq 15$, $45 + 60j \leq \phi \leq 75 + 60j$ (j = an integer of 0 to 4), or $345 \leq \phi \leq 360$. For the integer pairs (i, k), i.e., (0,0), (0,1), (1,0), and (1,1) on the orthogonal coordinate system $(kh_1,\theta,\psi)$, values in the internal regions of four hexahedrons each of which has, as its opposing bottom surfaces, the planar rectangular region with its vertexes at the points $A_{42}^{ik}$, $B_{42}^{ik}$, $C_{42}^{ik}$, and $D_{42}^{ik}$ and a planar rectangular region with its vertexes at points $A_{43}^{ik}$, $B_{43}^{ik}$, $C_{43}^{ik}$, and $D_{43}^{ik}$,
where

> point $A_{43}^{ik}$ = (1.1,90+180i,0+180k)
> point $B_{43}^{ik}$ = (1.1,130+180i,0+180k)
> point $C_{43}^{ik}$ = (1.1,130+180i,180+180k)
> point $D_{43}^{ik}$ = (1.1,90+180i,180+180k).

(iii) $15 + 60j \leq \phi \leq 45 + 60j$ (j = an integer of 0 to 5). For the integer pairs (i,k), i.e., (0,0), (0,1), (1,0), and (1,1) on the orthogonal coordinate system $(kh_1,\theta,\psi)$, values in the internal regions of four hexahedrons each of which has, as its opposing bottom surfaces, a planar rectangular region with its vertexes at points $A_{44}^{ik}$, $B_{44}^{ik}$, $C_{44}^{ik}$, and $D_{44}^{ik}$ and a planar rectangular region with its vertexes at points $A_{45}^{ik}$, $B_{45}^{ik}$, $C_{45}^{ik}$, and $D_{45}^{ik}$,
where

> point $A_{44}^{ik}$ = (0.6,70+180i,20+180k)
> point $B_{44}^{ik}$ = (0.6,110+180i,20+180k)
> point $C_{44}^{ik}$ = (0.6,100+180i,90+180k)
> point $D_{44}^{ik}$ = (0.6,70+180i,90+180k)
> point $A_{45}^{ik}$ = (0.85,60+180i,10+180k)
> point $B_{45}^{ik}$ = (0.85,120+180i,10+180k)
> point $C_{45}^{ik}$ = (0.85,120+180i,90+180k)
> point $D_{45}^{ik}$ = (0.85,60+180i,90+180k).

(iv) $15 + 60j \leq \phi \leq 45 + 60j$ (j = an integer of 0 to 5). For the integer pairs (i,k), i.e., (0,0), (0,1), (1,0), and (1,1) on the orthogonal coordinate system $(kh_1,\theta,\psi)$, values in the internal regions of four hexahedrons each of which has, as its opposing bottom surfaces, the planar rectangular region with its vertexes at the points $A_{45}^{ik}$, $B_{45}^{ik}$, $C_{45}^{ik}$, and $D_{45}^{ik}$ and

a planar rectangular region with its vertexes at points $A_{46}^{ik}$, $B_{46}^{ik}$, $C_{46}^{ik}$, and $D_{46}^{ik}$
where

> point $A_{46}^{ik}$ = (1.1,80+180i,10+180k)
> point $B_{46}^{ik}$ = (1.1,120+180i,10+180k)
> point $C_{46}^{ik}$ = (1.1,130+180i,80+180k)
> point $D_{46}^{ik}$ = (1.1,50+180i,80+180k).

In the structure of the SAW device according to the fourth embodiment, a propagation velocity V is exclusively determined by $kh_1$ of the $LiNbO_3$ layer 320. Fig. 23 is a graph showing the relationship between $kh_1$ of the $LiNbO_3$ layer 340 and the propagation velocity V of an SAW in the 1st-order mode in the SAW device of the fourth embodiment. It is confirmed from Fig. 23 that, when $kh_1$ is equal to or smaller than 1.1, a propagation velocity V equal to or higher than 8,000 m/s is ensured.

The present inventors set the thickness of the diamond 100 at 20 $\mu$m, and evaluated an electromechanical coupling coefficient $K^2$ while changing $kh_1$ within the above-described limitation for $kh_1$ and simultaneously changing the values $\theta$, $\phi$, and $\psi$.

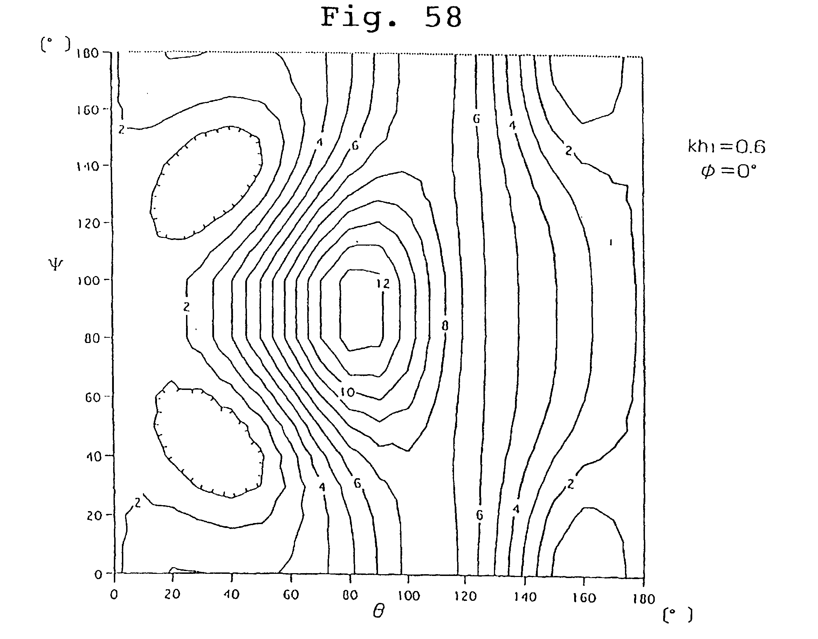

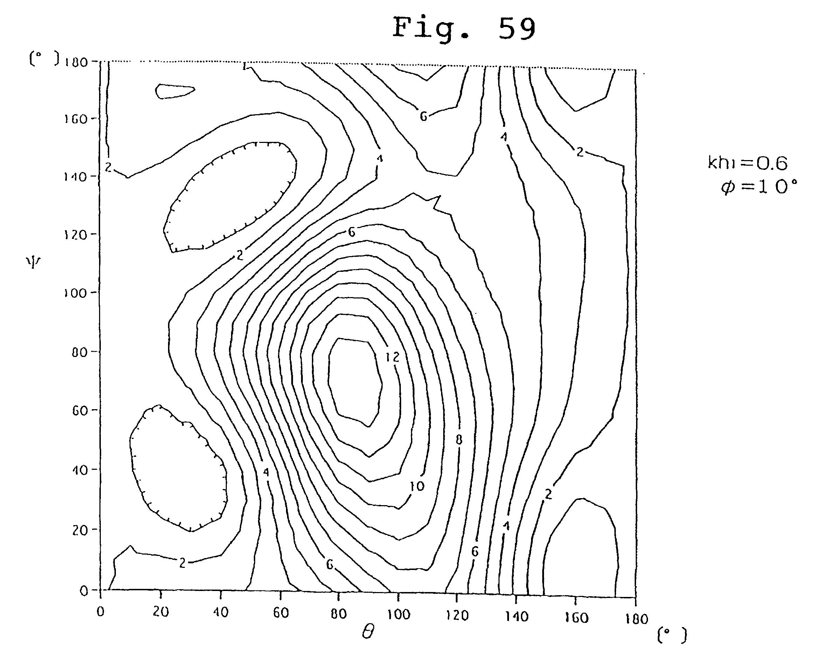

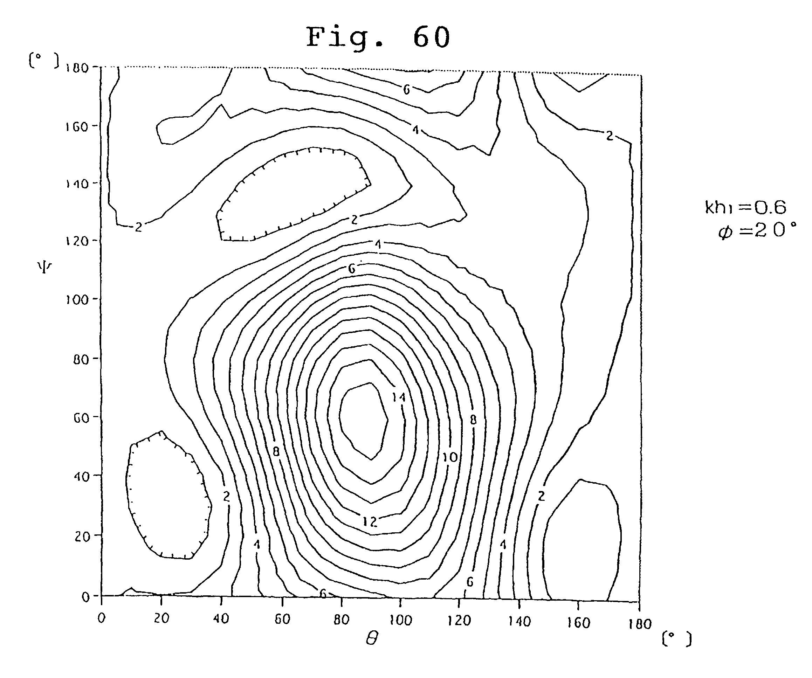

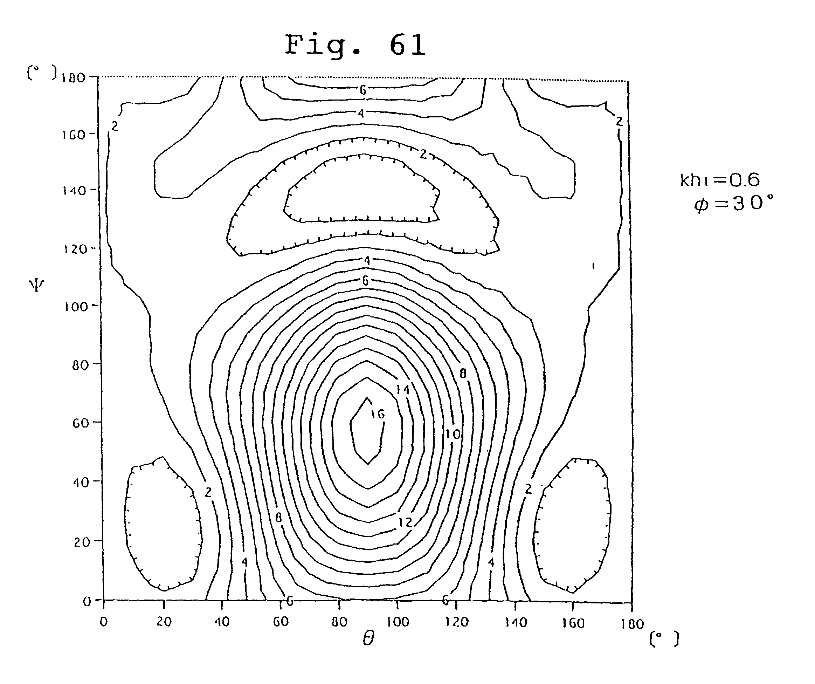

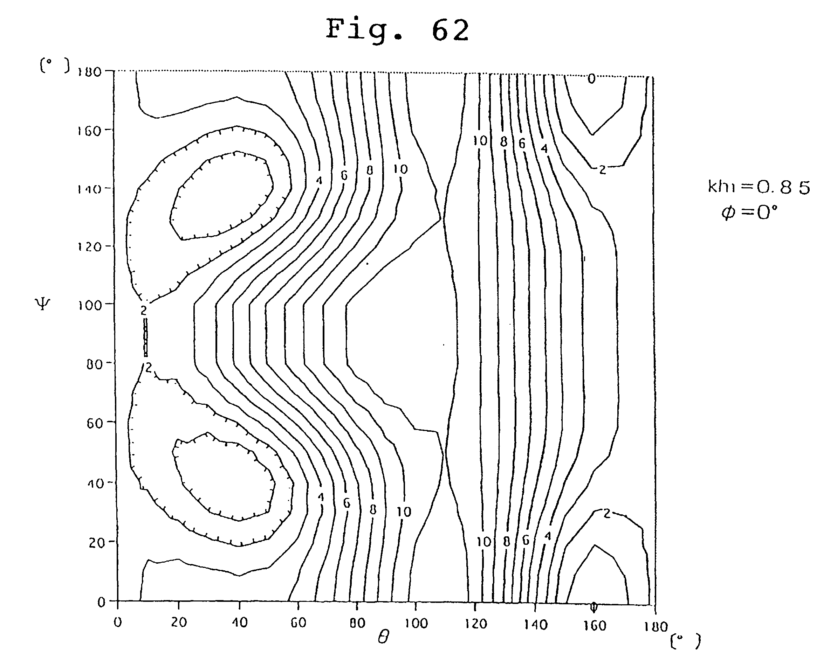

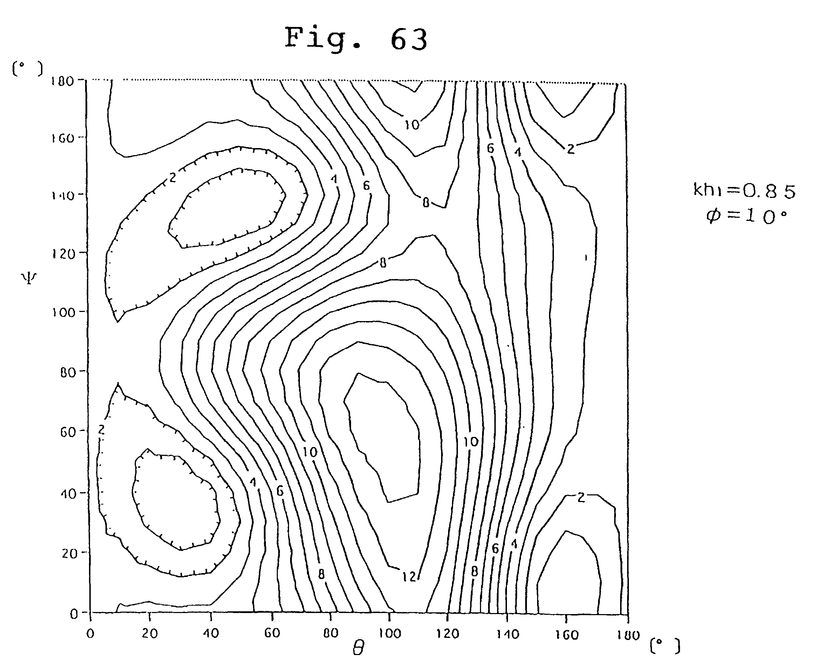

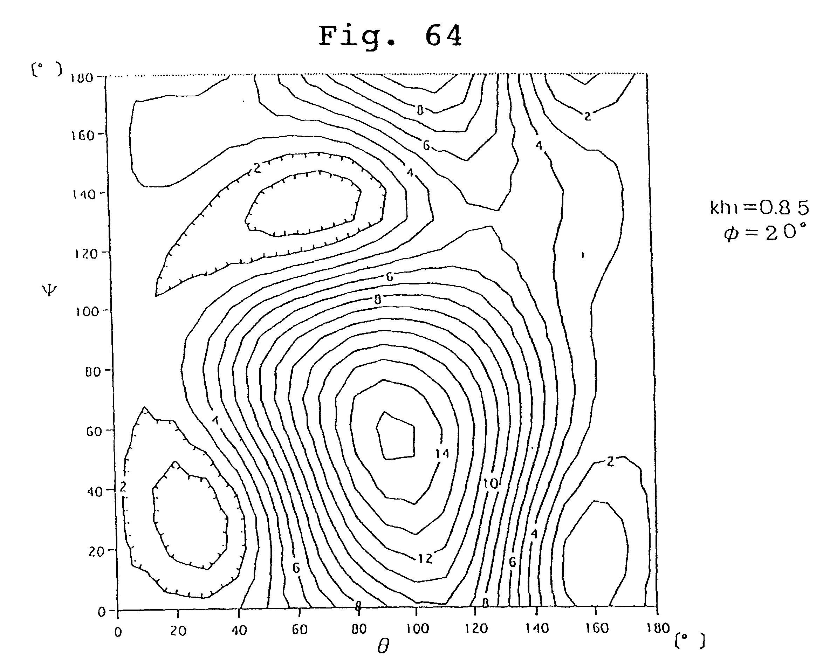

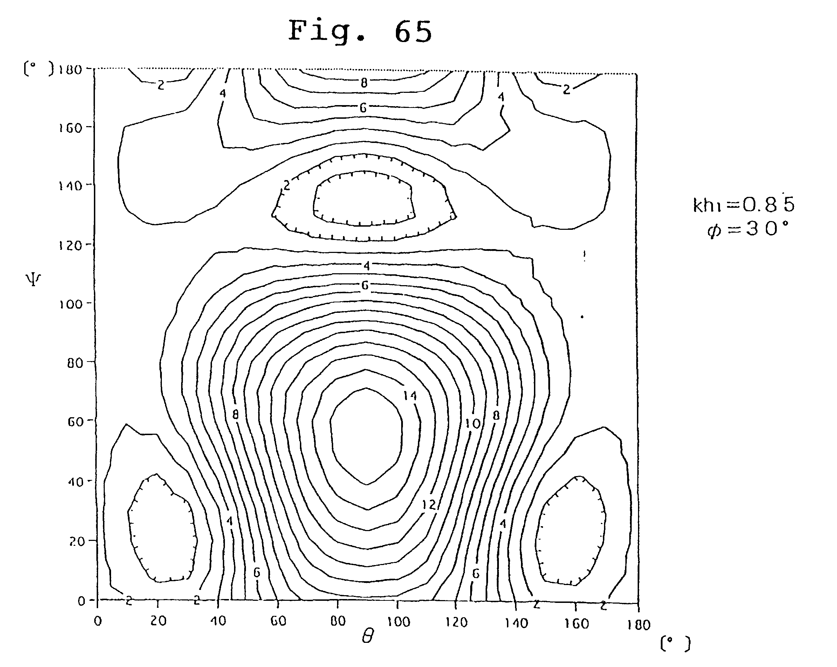

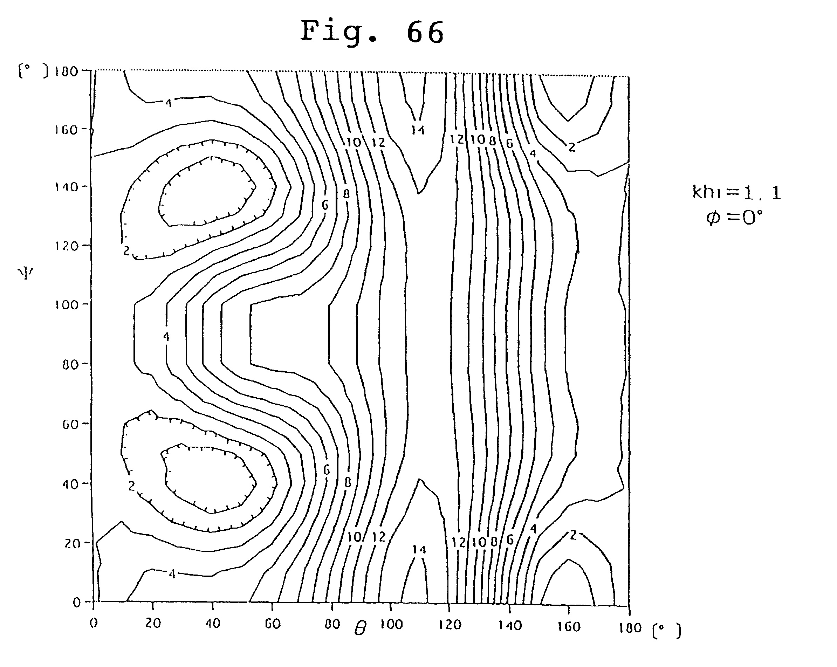

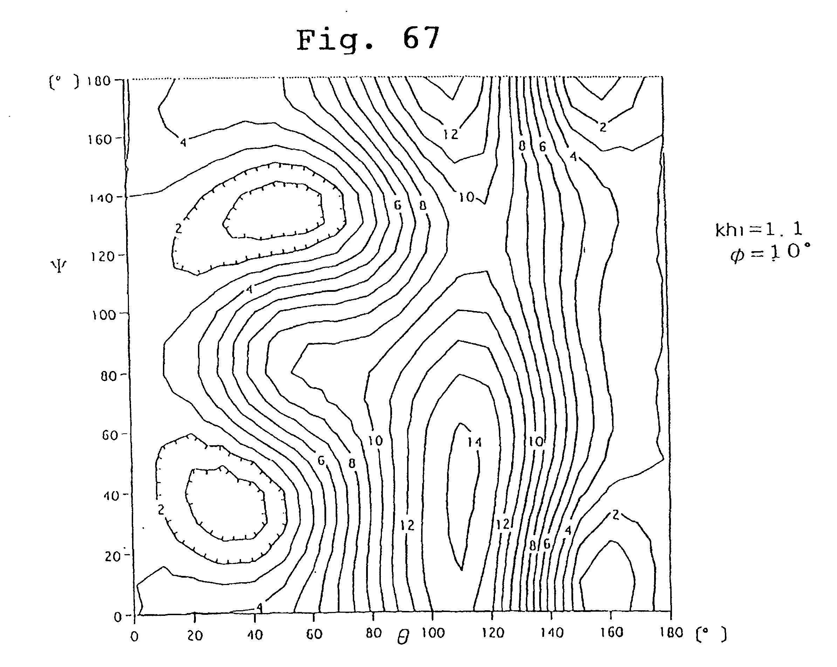

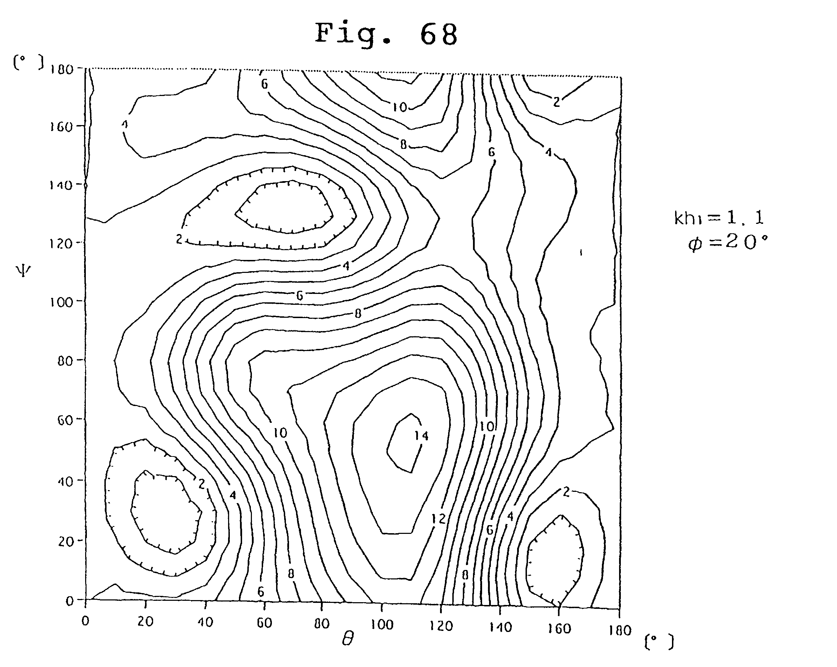

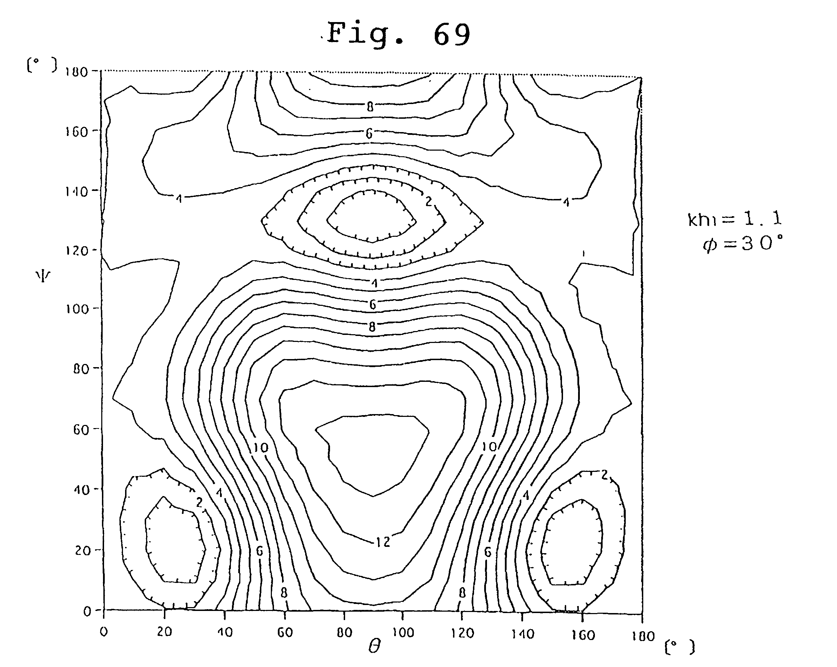

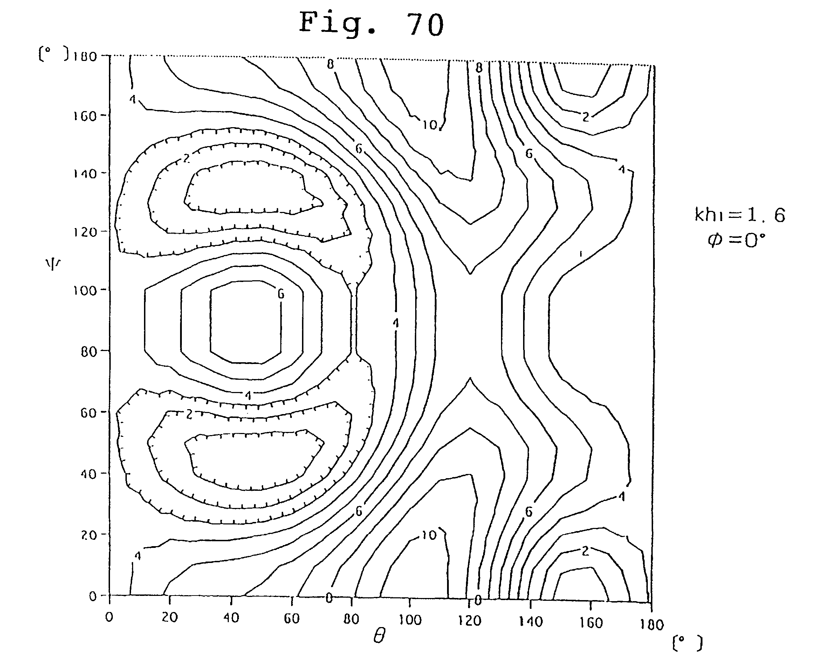

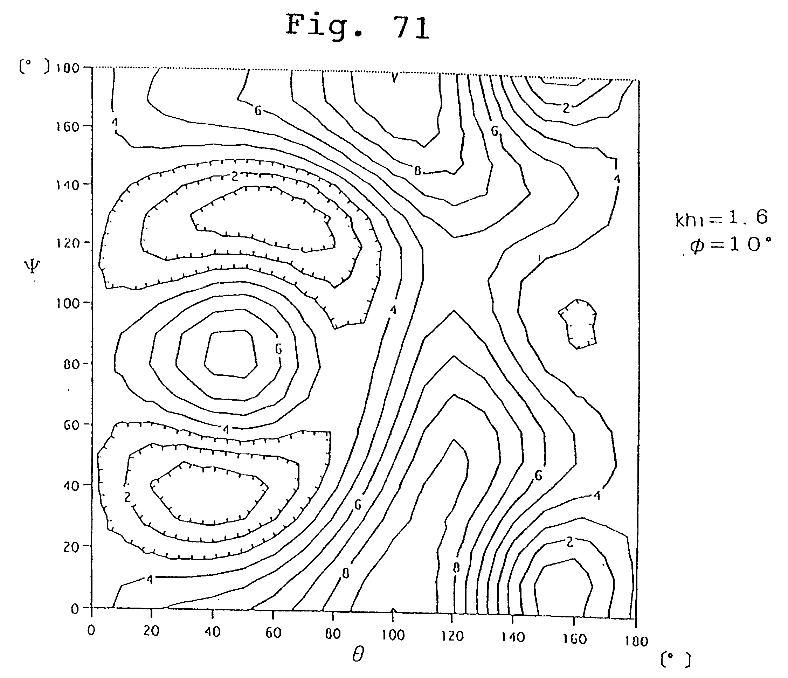

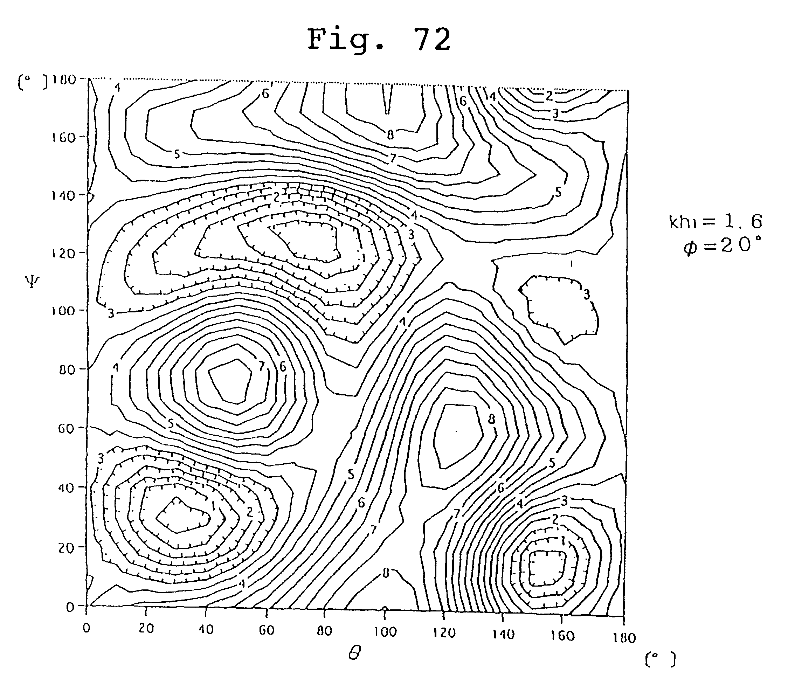

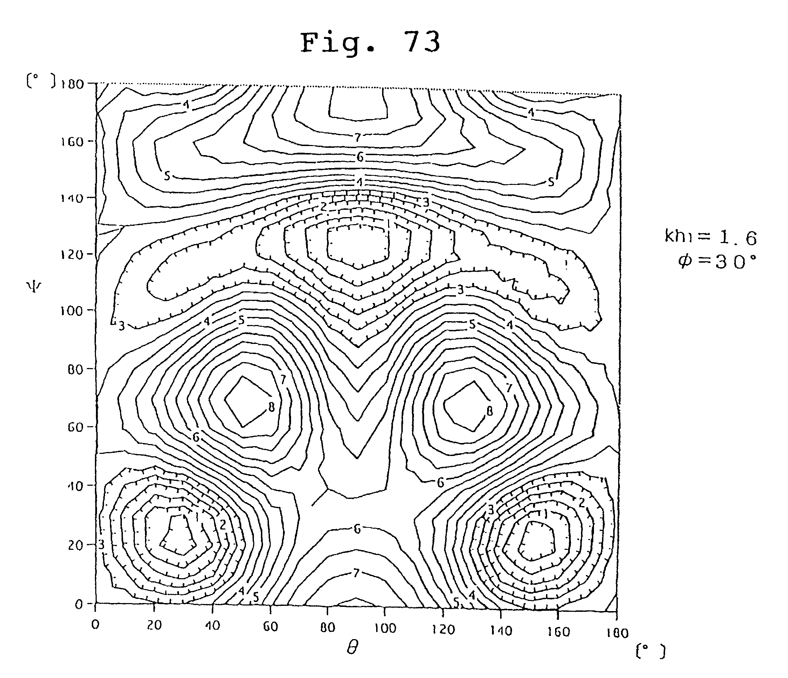

Figs. 58 to 73 are graphs showing contour lines obtained upon evaluating the electromechanical coupling coefficient K' [%] under conditions that $kh_1$ = 0.6, 0.85, 1.1, and 1.6, $\phi$ = 0°, 10°, 20°, and 30°, $0° \leq \theta \leq 180°$, and $0° \leq \psi \leq 180°$. Note that the values $\theta$ and $\psi$ are plotted in units of 10° in these graphs.

Regions for satisfying the electromechanical coupling coefficient $K^2$ of 10% or more are obtained from Figs. 58 to 73. Taking the symmetry of the $LiNbO_3$ crystal into consideration, it is confirmed that, when the propagation velocity V is 8,000 m/s or more, and the electromechanical coupling coefficient $K^2$ is 10% or more, the four parameters $kh_1$, $\theta$, $\phi$, and $\psi$ are set in the internal regions of the four hexahedrons represented by (i), (ii), (iii), or (iv).

(Fifth Embodiment)

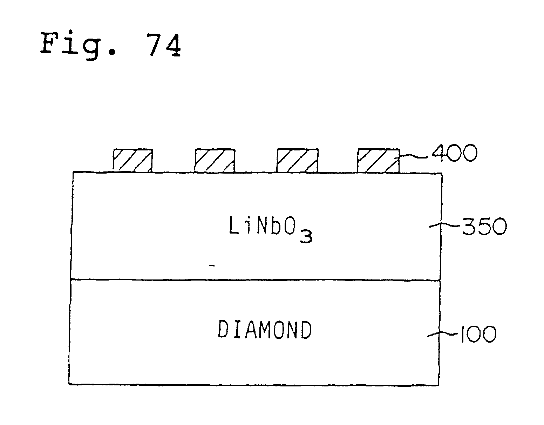

Fig. 74 is a sectional view showing the structure of an SAW device according to the fifth embodiment of the present invention. As shown in Fig. 74, the SAW device of the fifth embodiment comprises (a) diamond 100, (b) a single crystal $LiNbO_3$ layer 350 formed on an interdigital transducer 400, and (c) the interdigital transducer 400 formed on the diamond 100.

The SAW device of the fifth embodiment uses an SAW in the 1st-order mode.

The $LiNbO_3$ layer 350 is formed by bonding a cut single crystal $LiNbO_3$ thin plate to the diamond 100 having the interdigital transducer 400 formed on its polished surface, and then polishing the single crystal $LiNbO_3$ thin plate.

For the $LiNbO_3$ layer 350, a thickness $t_1$ [$\mu$m] and a crystal orientation $(\theta[°],\phi[°],\psi[°])$ are selected from the following values. Note that $kh_1$ (= $2\pi(t_1/\lambda)$ ; $\lambda$ = the

wavelength [μm] of an SAW) is used instead of the thickness $t_1$, as in the first embodiment.

(i) For integer pairs (i,k), i.e., (0,0), (0,1), (1,0), and (1,1) on an orthogonal coordinate system $(kh_1,\theta,\psi)$, values in the internal regions of four quadrangular pyramids each of which has its vertex at a point $P_{51}^{ik}$ and, as its bottom surface, a planar rectangular region with its vertexes at points $A_{51}^{ik}$, $B_{51}^{ik}$, $C_{51}^{ik}$, and $D_{51}^{ik}$,
where

point $P_{51}^{ik}$ = (0.6,90+180i,0+180k)
point $A_{51}^{ik}$ = (0.7,80+180i,0+180k)
point $B_{51}^{ik}$ = (0.7,110+180i,0+180k)
point $C_{51}^{ik}$ = (0.7,110+180i,10+180k)
point $D_{51}^{ik}$ = (0.7,80+180i,10+180k).

(ii) For the integer pairs (i,k), i.e., (0,0), (0,1), (1,0), and (1,1) on the orthogonal coordinate system $(kh_1, \theta,\psi)$, values in the internal regions of four quadrangular pyramids each of which has its vertex at a point $P_{52}^{ik}$ and, as its bottom surface, a planar rectangular region with its vertexes at points $A_{52}^{ik}$, $B_{52}^{ik}$, $C_{52}^{ik}$, and $D_{52}^{ik}$,
where

point $P_{52}^{ik}$ = (0.6,100+180i,0+180k)
point $A_{52}^{ik}$ = (0.7,90+180i,170+180k)
point $B_{52}^{ik}$ = (0.7,100+180i,170+180k)
point $C_{52}^{ik}$ = (0.7, 110+180i, 180+180k)
point $D_{52}^{ik}$ = (0.7,80+180i,180+180k).

In the structure of the SAW device according to the fifth embodiment, a propagation velocity V is exclusively determined by $kh_1$ of the $LiNbO_3$ layer 350, as in the first embodiment, as shown in Fig. 5. Therefore, as in the first embodiment, it is confirmed that, when $kh_1$ is equal to or smaller than 1.1, a propagation velocity V equal to or higher than 8,000 m/s is ensured.

The present inventors set the thickness of the diamond 100 at 20 μm, and evaluated an electromechanical coupling coefficient $K^2$ while changing $kh_1$ within the above-described limitation for $kh_1$ and simultaneously changing the values θ, φ, and ψ.

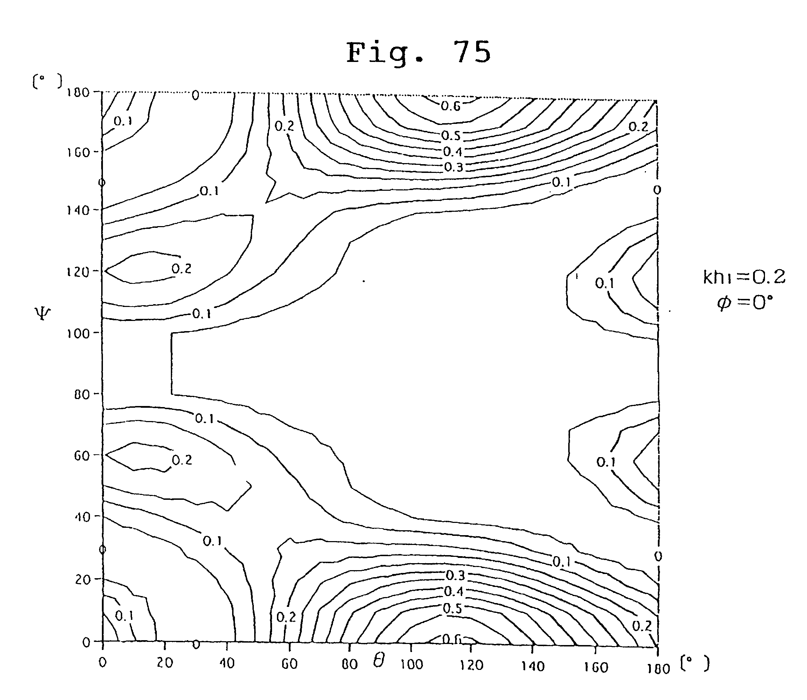

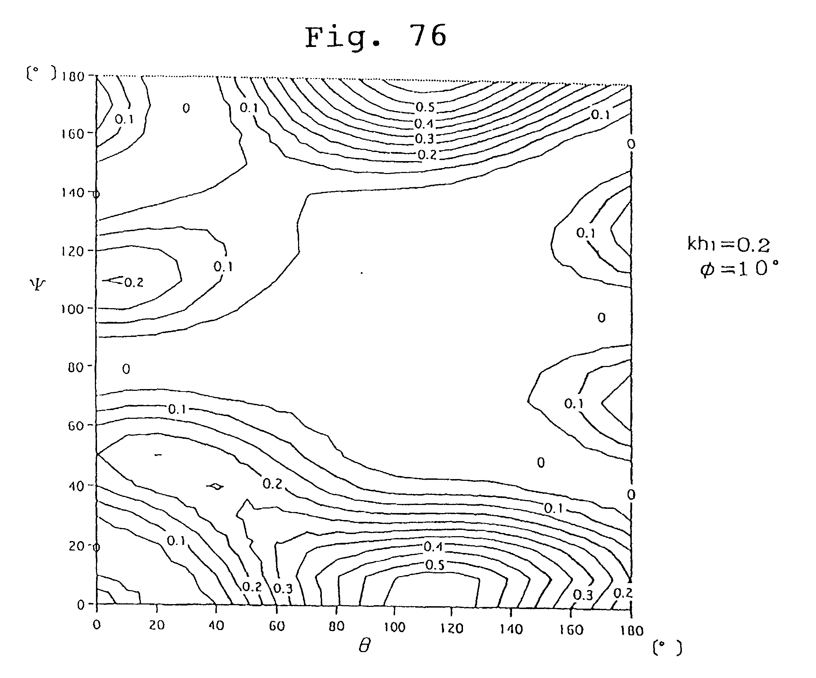

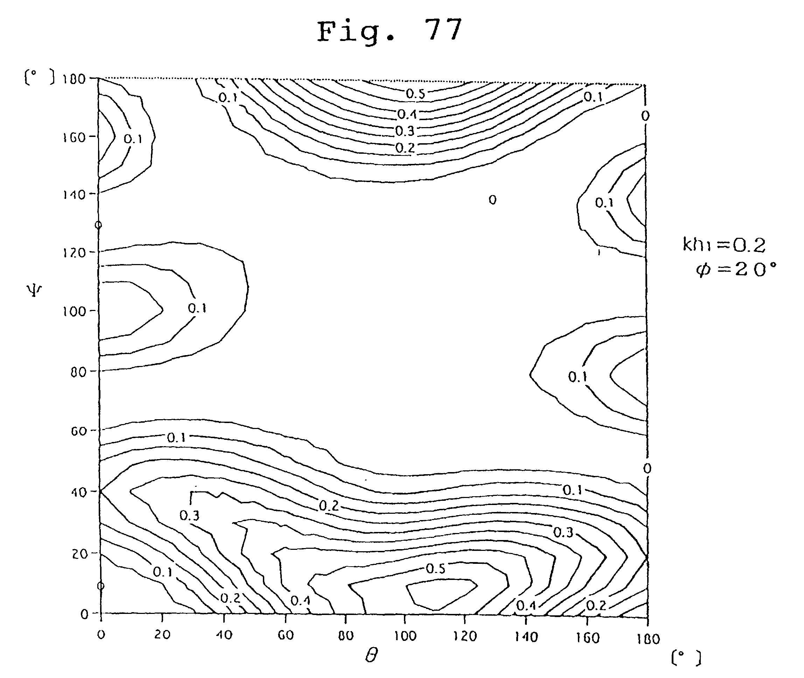

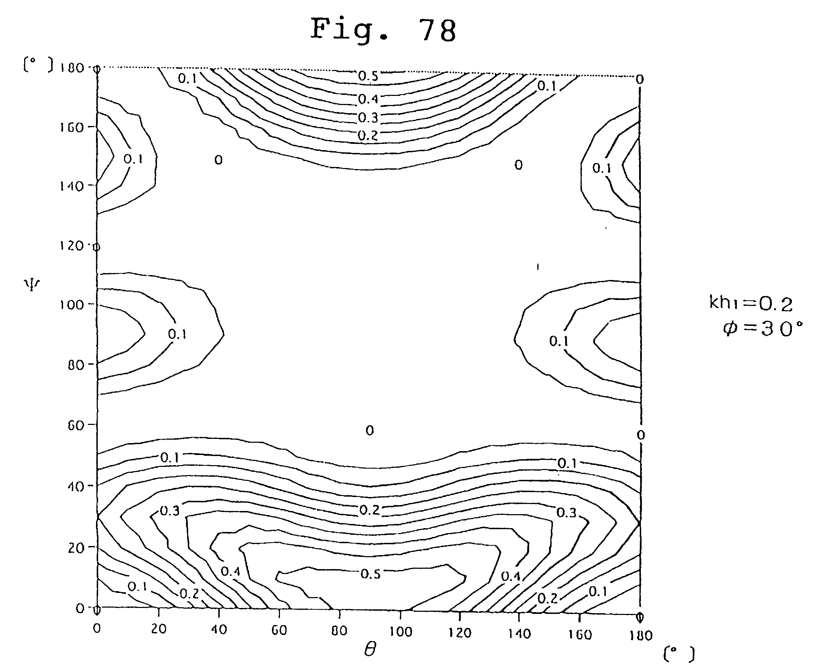

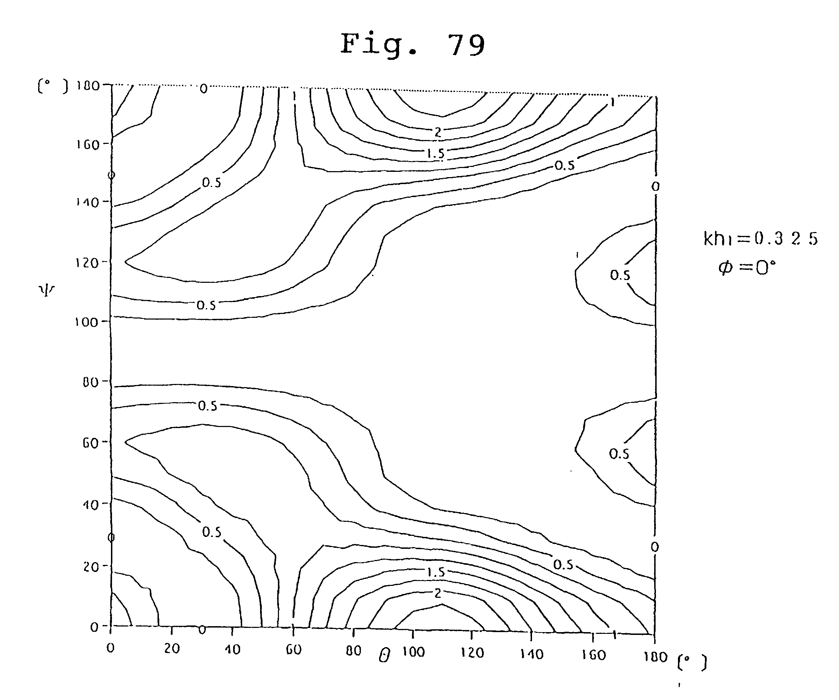

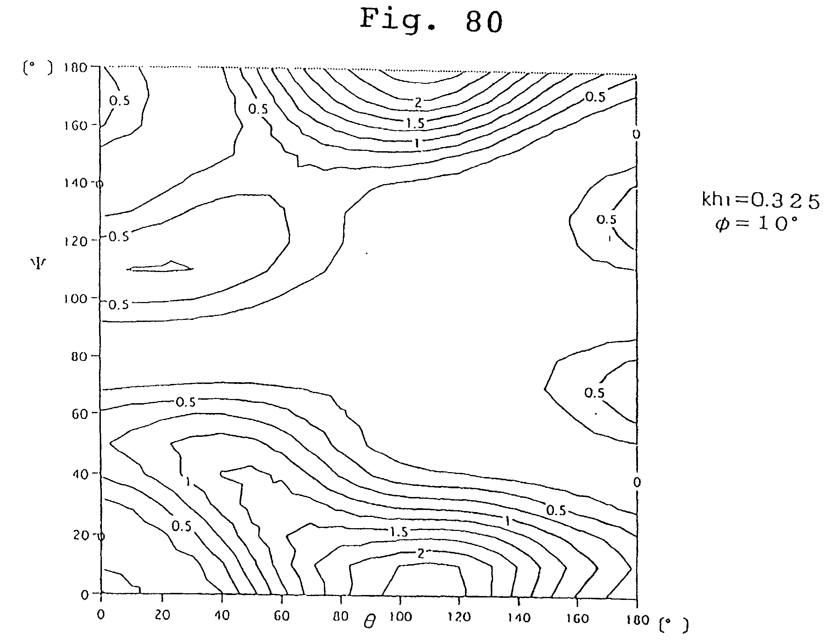

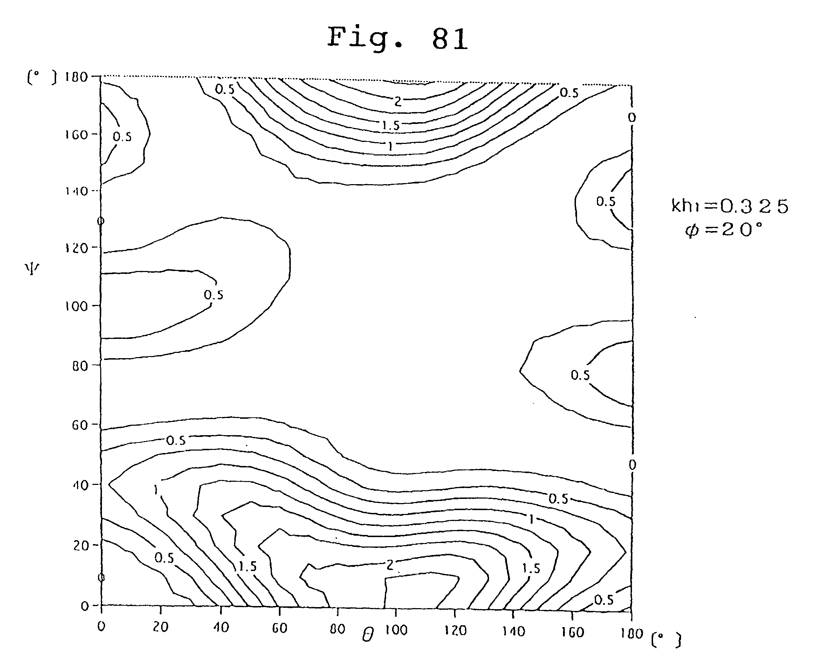

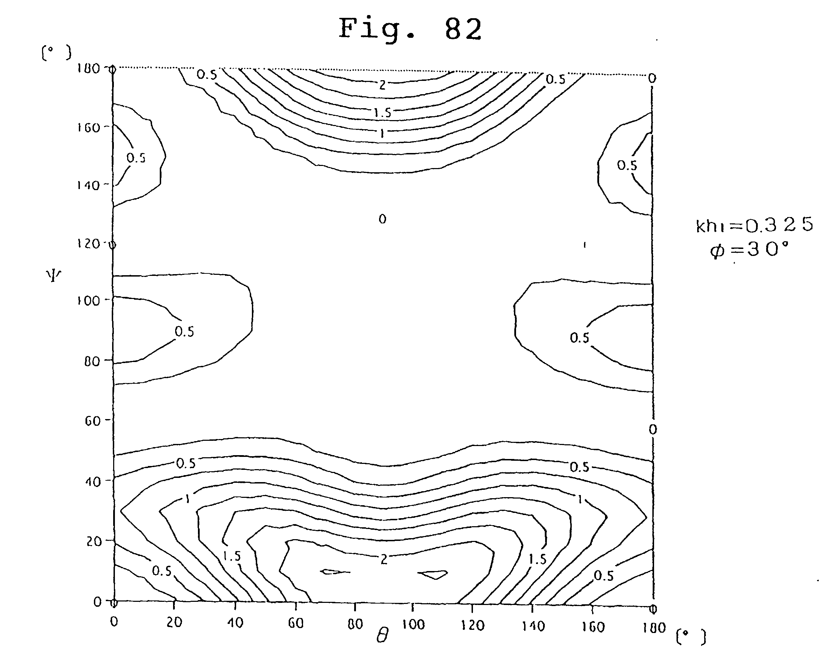

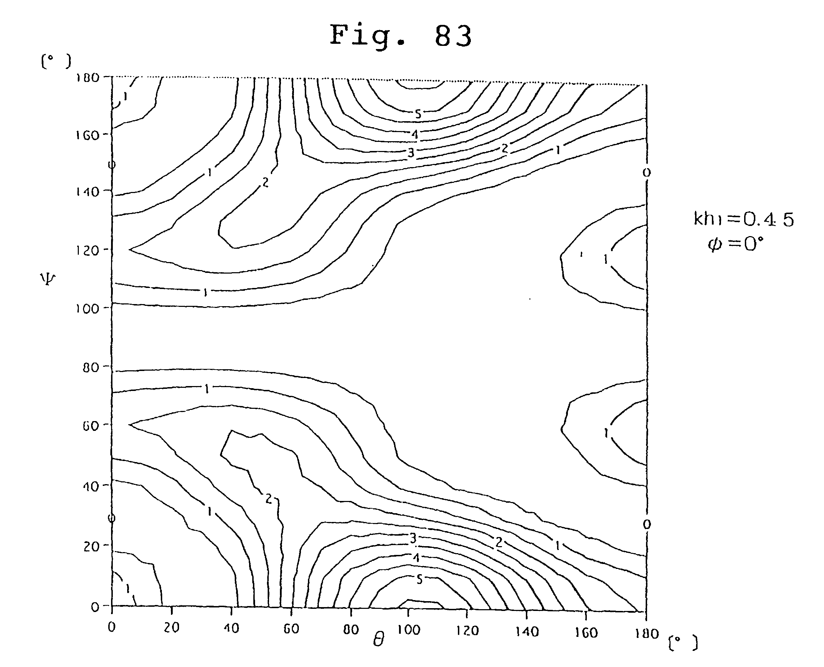

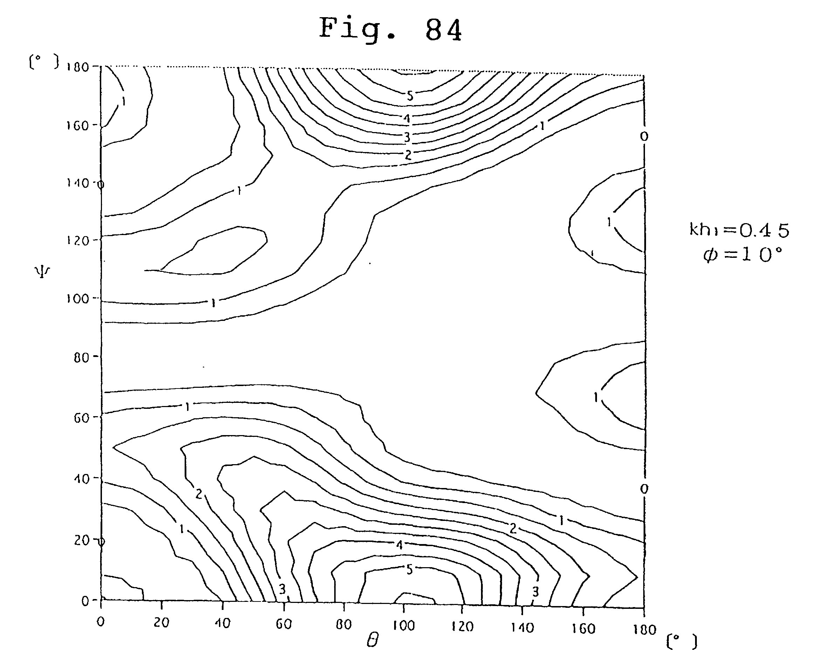

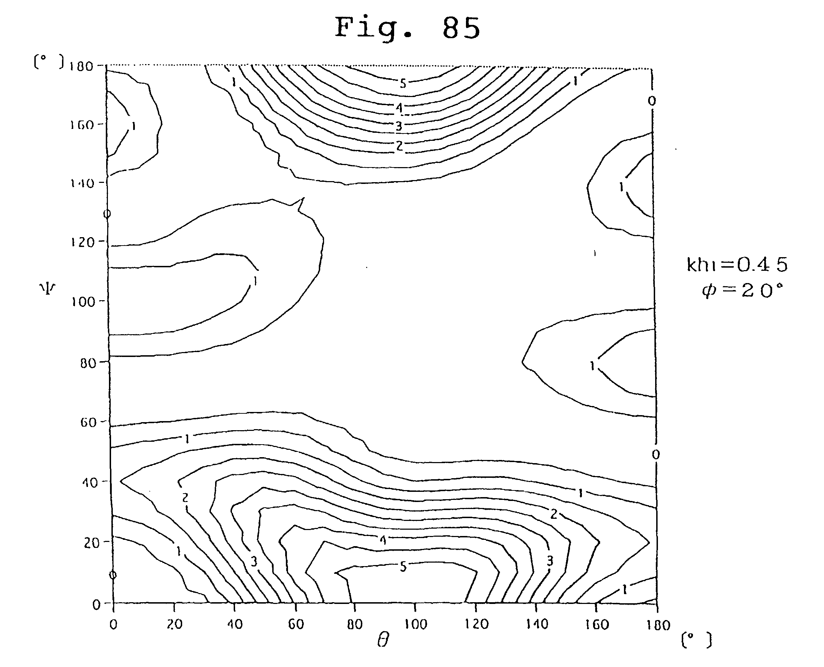

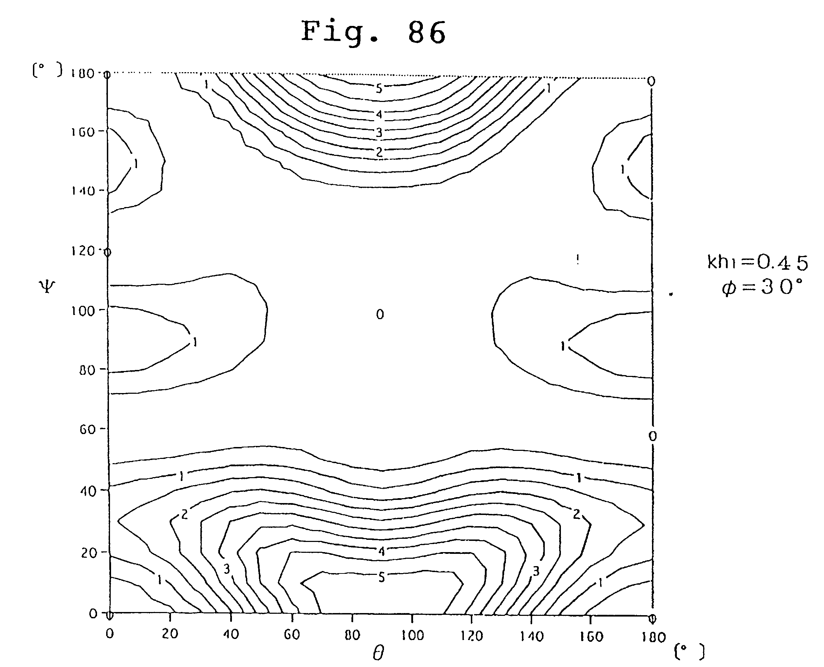

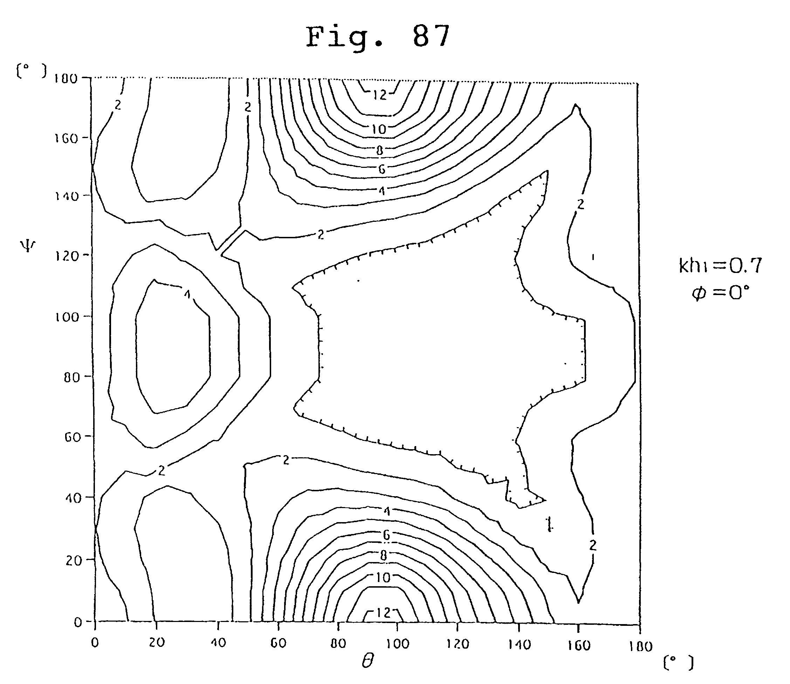

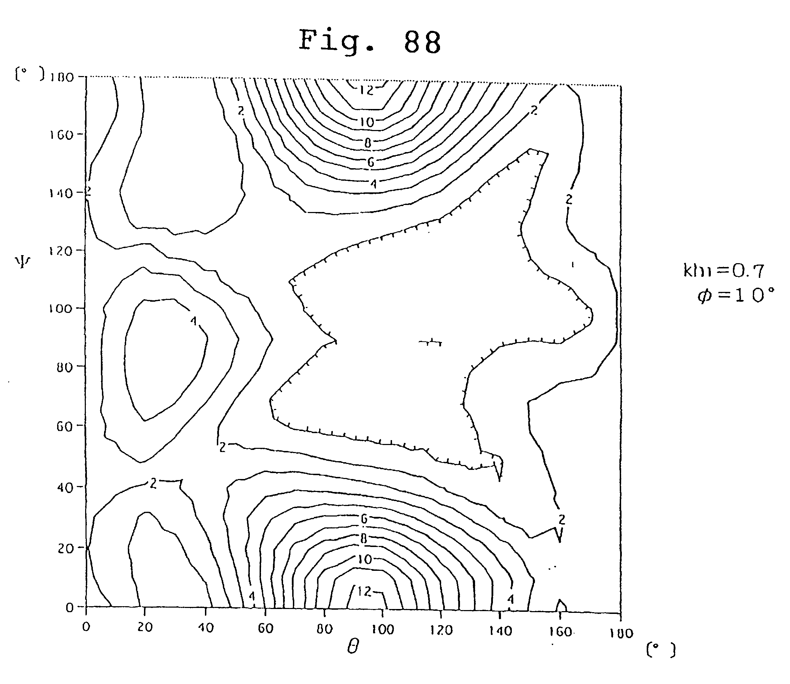

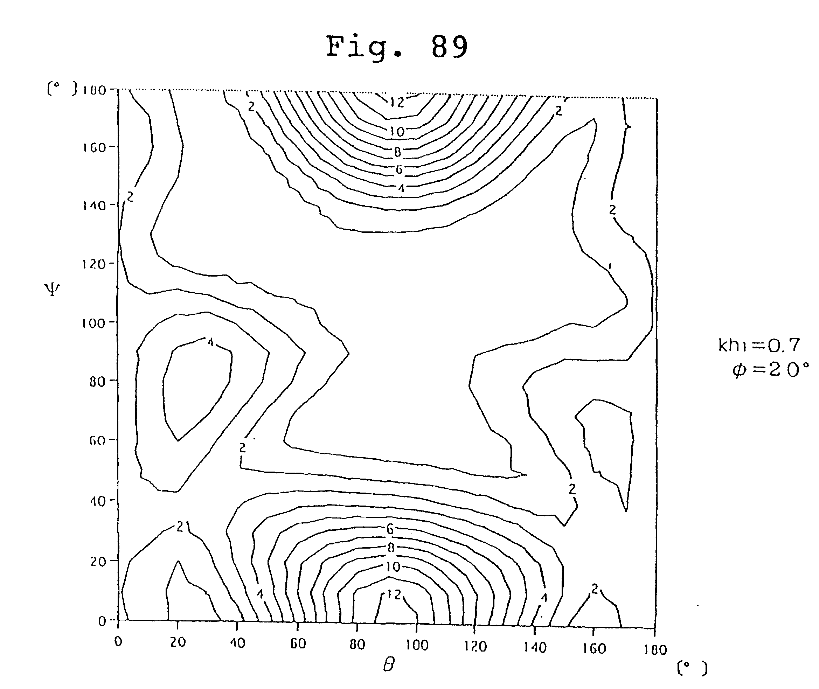

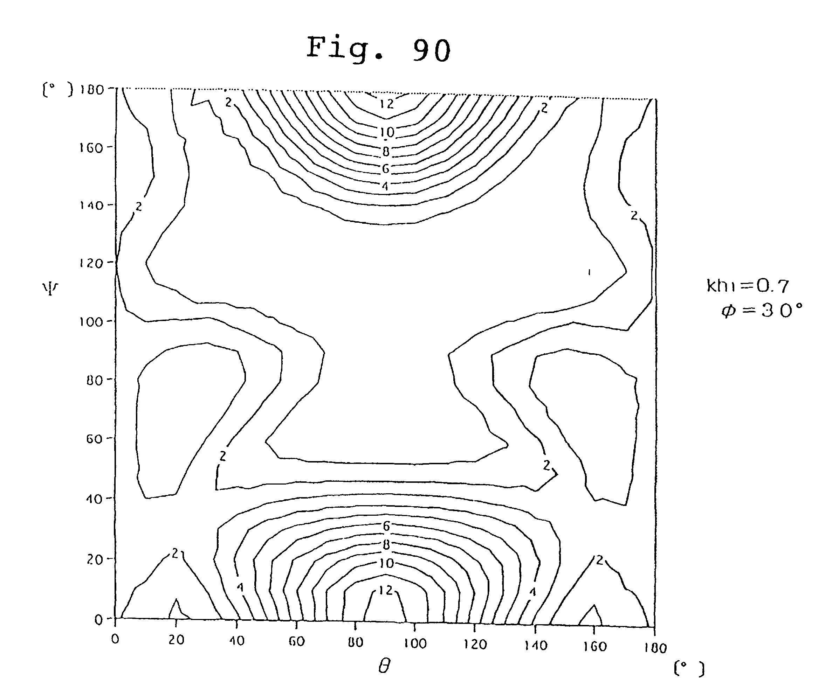

Figs. 75 to 90 are graphs showing contour lines obtained upon evaluating the electromechanical coupling coefficient $K^2$ [%] under conditions that $kh_1$ = 0.2, 0.325, 0.45, and 0.7, φ = 0°, 10°, 20°, and 30°, 0° ≤ θ ≤ 180°, and 0° ≤ ψ ≤ 180°. Note that the values θ and ψ are plotted in units of 10° in these graphs.

Regions for satisfying the electromechanical coupling coefficient $K^2$ of 10% or more are obtained from Figs. 75 to 90. Taking the symmetry of the $LiNbO_3$ crystal into consideration, it is confirmed that, when the propagation velocity V is 8,000 m/s or more, and the electromechanical coupling coefficient K' is 10% or more, the four parameters $kh_1$, θ, φ, and ψ are set in the internal regions of the four quadrangular pyramids represented by (i), (ii), (iii), or (iv).

(Sixth Embodiment)

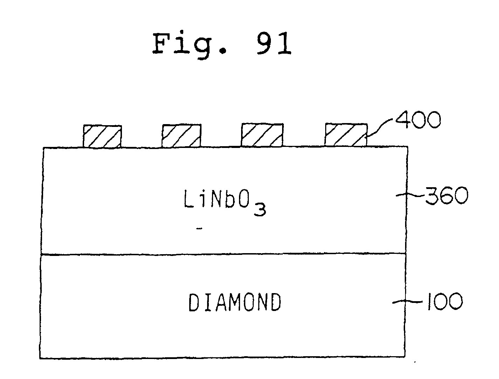

Fig. 91 is a sectional view showing the structure of an SAW device according to the sixth embodiment of the present invention. As shown in Fig. 91, the SAW device of the sixth embodiment is different from that of the fifth embodiment only in that an SAW in the 2nd-order mode is used, and an $LiNbO_3$ layer 360 is formed in place of the $LiNbO_3$ layer 350.

The $LiNbO_3$ layer 360 is formed by bonding a cut single crystal $LiNbO_3$ thin plate to diamond 100 having a short-circuit electrode 200 formed on its polished surface, and then polishing the single crystal $LiNbO_3$ thin plate, as in the fifth embodiment.

For the $LiNbO_3$ layer 360, a thickness $t_1$ [μm] and a crystal orientation (θ[°],φ[°],ψ[°]) are selected from the following values. Note that $kh_1$ (= $2\pi(t_1/\lambda)$; λ = the wavelength [μm] of-an SAW) is used instead of the thickness $t_1$, as in the first embodiment.

(i) 0 ≤ φ ≤ 15, 45 + 60j ≤ φ ≤ 75 + 60j (j = an integer of 0 to 4), or 345 ≤ φ ≤ 360. For integer pairs (i,k), i. e., (0,0), (0,1), (1,0), and (1,1) on an orthogonal coordinate system $(kh_1,\theta,\psi)$, values in the internal regions of four hexahedrons each of which has, as its opposing bottom surfaces, a planar rectangular region with its vertexes at points $A_{61}^{ik}$, $B_{61}^{ik}$, $C_{61}^{ik}$, and $D_{61}^{ik}$ and a planar rectangular region with its vertexes at points $A_{62}^{ik}$, $B_{62}^{ik}$, $C_{62}^{ik}$, and $D_{62}^{ik}$,
where

point $A_{61}^{ik}$ = (0.85,140+180i,40+180k)
point $B_{61}^{ik}$ = (0.85,160+180i,40+180k)
point $C_{61}^{ik}$ = (0.85,160+180i,60+180k)
point $D_{61}^{ik}$ = (0.85,140+180i,60+180k)
point $A_{62}^{ik}$ = (1.1,120+180i,30+180k)
point $B_{62}^{ik}$ = (1.1,170+180i,30+180k)
point $C_{62}^{ik}$ = (1.1,170+180i,70+180k)
point $D_{62}^{ik}$ = (1.1,120+180i,70+180k).

(ii) 0 ≤ φ ≤ 15, 45 + 60j ≤ φ ≤ 75 + 60j (j = an integer of 0 to 4), or 345 ≤ φ ≤ 360. For the integer pairs (i, k), i.e., (0,0), (0,1), (1,0), and (1,1) on the orthogonal coordinate system $(kh_1,\theta,\psi)$, values in the internal regions of four hexahedrons each of which has, as its opposing bottom surfaces, a planar rectangular region with its vertexes at points $A_{63}^{ik}$, $B_{63}^{ik}$, $C_{63}^{ik}$, and $D_{63}^{ik}$ and a planar rectangular region with its vertexes at points $A_{64}^{ik}$, $B_{64}^{ik}$, $C_{64}^{ik}$, and $D_{64}^{ik}$,
where

point $A_{63}^{ik}$ = (0.85,130+180i,130+180k)
point $B_{63}^{ik}$ = (0.85,160+180i,130+180k)
point $C_{63}^{ik}$ = (0.85,160+180i,150+180k)
point $D_{63}^{ik}$ = (0.85,130+180i,150+180k)

point $A_{64}{}^{ik}$ = (1.1,100+180i,140+180k)
point $B_{64}{}^{ik}$ = (1.1,140+180i,100+180k)
point $C_{64}{}^{ik}$ = (1.1,160+180i,160+180k)
point $D_{64}{}^{ik}$ = (1.1,130+180i,160+180k).

(iii) $0 \leq \phi \leq 15$, $45 + 60j \leq \phi \leq 75 + 60j$ (j = an integer of 0 to 4), or $345 \leq \phi \leq 360$. For the integer pairs (i, k), i.e., (0,0), (0,1), (1,0), and (1,1) on the orthogonal coordinate system $(kh_1,\theta,\psi)$, values in the internal regions of four quadrangular pyramids each of which has its vertex at a point $P_{65}{}^{ik}$ and, as its bottom surface, a planar rectangular region with its vertexes at points $A_{65}{}^{ik}$, $B_{65}{}^{ik}$, $C_{65}{}^{ik}$, and $D_{65}{}^{ik}$,
   where

point $P_{65}{}^{ik}$ = (0.85,30+180i,90+180k)
point $A_{65}{}^{ik}$ = (1.1,20+180i,70+180k)
point $B_{65}{}^{ik}$ = (1.1, 40+180i, 70+180k)
point $C_{65}{}^{ik}$ = (1.1, 40+180i, 110+180k)
point $D_{65}{}^{ik}$ = (1.1, 20+180i, 110+180k).

(iv) $15 + 60j \leq \phi \leq 45 + 60j$ (j = an integer of 0 to 5). For the integer pairs (i,k), i.e., (0,0), (0,1), (1,0), and (1,1) on the orthogonal coordinate system $(kh_1,\theta,\psi)$, values in the internal regions of four hexahedrons each of which has, as its opposing bottom surfaces, a planar rectangular region with its vertexes at points $A_{66}{}^{ik}$, $B_{66}{}^{ik}$, $C_{66}{}^{ik}$, and $D_{66}{}^{ik}$ and a planar rectangular region with its vertexes at points $A_{67}{}^{ik}$, $B_{67}{}^{ik}$, $C_{67}{}^{ik}$, and $D_{67}{}^{ik}$,
   where

point $A_{66}{}^{ik}$ = (0.6,20+180i,150+180k)
point $B_{66}{}^{ik}$ = (0.6,40+180i,150+180k)
point $C_{66}{}^{ik}$ = (0.6,40+180i,170+180k)
point $D_{66}{}^{ik}$ = (0.6,20+180i,170+180k)
point $A_{67}{}^{ik}$ = (0.85,50+180i,130+180k)
point $B_{67}{}^{ik}$ = (0.85,70+180i,140+180k)
point $C_{67}{}^{ik}$ = (0.85,50+180i,160+180k)
point $D_{67}{}^{ik}$ = (0.85,20+180i,160+180k).

(v) $15 + 60j \leq \phi \leq 45 + 60j$ (j = an integer of 0 to 5). For the integer pairs (i,k), i.e., (0,0), (0,1), (1,0), and (1,1) on the orthogonal coordinate system $(kh_1,\theta,\psi)$, values in the internal regions of four hexahedrons each of which has, as its opposing bottom surfaces, the planar rectangular region with its vertexes at the points $A_{67}{}^{ik}$, $B_{67}{}^{ik}$, $C_{67}{}^{ik}$, and $D_{67}{}^{ik}$ and a planar rectangular region with its vertexes at points $A_{68}{}^{ik}$, $B_{68}{}^{ik}$, $C_{68}{}^{ik}$, and $D_{68}{}^{ik}$,
   where

point $A_{68}{}^{ik}$ = (1.1,40+180i,120+180k)
point $B_{68}{}^{ik}$ = (1.1,90+180i,120+180k)
point $C_{68}{}^{ik}$ = (1.1,90+180i,160+180k)
point $D_{68}{}^{ik}$ = (1.1,40+180i,160+180k).

(vi) $15 + 60j \leq \phi \leq 45 + 60j$ (j = an integer of 0 to 5).

For the integer pairs (i,k), i.e., (0,0), (0,1), (1,0), and (1,1) on the orthogonal coordinate system $(kh_1,\theta,\psi)$, values in the internal regions of four hexahedrons each of which has, as its opposing bottom surfaces, a planar rectangular region with its vertexes at points $A_{69}{}^{ik}$, $B_{69}{}^{ik}$, $C_{69}{}^{ik}$, and $D_{69}{}^{ik}$ and a planar rectangular region with its vertexes at points $A_{6A}{}^{ik}$, $B_{6A}{}^{ik}$, $C_{6A}{}^{ik}$, and $D_{6A}{}^{ik}$,
   where

point $A_{69}{}^{ik}$ = (0.6,140+180i,150+180k)
point $B_{69}{}^{ik}$ = (0.6,160+180i,150+180k)
point $C_{69}{}^{ik}$ = (0.6,160+180i,160+180k)
point $D_{69}{}^{ik}$ = (0.6,140+180i,160+180k)
point $A_{6A}{}^{ik}$ = (0.85,100+180i,140+180k)
point $B_{6A}{}^{ik}$ = (0.85,130+180i,130+180k)
point $C_{6A}{}^{ik}$ = (0.85,160+180i,160+180k)
point $D_{6A}{}^{ik}$ = (0.85,130+180i,160+180k).

(vii) $15 + 60j \leq \phi \leq 45 + 60j$ (j = an integer of 0 to 5). For the integer pairs (i,k), i.e., (0,0), (0,1), (1,0), and (1,1) on the orthogonal coordinate system $(kh_1,\theta,\psi)$, values in the internal regions of four hexahedrons each of which has, as its opposing bottom surfaces, the planar rectangular region with its vertexes at the points $A_{6A}{}^{ik}$, $B_{6A}{}^{ik}$, $C_{6A}{}^{ik}$, and $D_{6A}{}^{ik}$ and a planar rectangular region with its vertexes at points $A_{6B}{}^{ik}$, $B_{6B}{}^{ik}$, $C_{6B}{}^{ik}$, and $D_{6B}{}^{ik}$,
   where

point $A_{6B}{}^{ik}$ = (1.1,100+180i,120+180k)
point $B_{6B}{}^{ik}$ = (1.1, 150+180i,120+180k)
point $C_{6B}{}^{ik}$ = (1.1, 150+180i,160+180k)
point $D_{6B}{}^{ik}$ = (1.1,100+180i,160+180k).

(viii) $15 + 60j \leq \phi \leq 45 + 60j$ (j = an integer of 0 to 5). For the integer pairs (i,k), i.e., (0,0), (0,1), (1,0), and (1,1) on the orthogonal coordinate system $(kh_1,\theta,\psi)$, values in the internal regions of four hexahedrons each of which has, as its opposing bottom surfaces, a planar rectangular region with its vertexes at points $A_{6C}{}^{ik}$, $B_{6C}{}^{ik}$, $C_{6C}{}^{ik}$, and $D_{6C}{}^{ik}$ and a planar rectangular region with its vertexes at points $A_{6D}{}^{ik}$, $B_{6D}{}^{ik}$, $C_{6D}{}^{ik}$, and $D_{6D}{}^{ik}$,
   where

point $A_{6C}{}^{ik}$ = (0.85,150+180i,50+180k)
point $B_{6C}{}^{ik}$ = (0.85,160+180i,50+180k)
point $C_{6C}{}^{ik}$ = (0.85,160+180i,60+180k)
point $D_{6C}{}^{ik}$ = (0.85,150+180i,60+180k)
point $A_{6D}{}^{ik}$ = (1.1,130+180i,40+180k)
point $B_{6D}{}^{ik}$ = (1.1,160+180i,40+180k)
point $C_{6D}{}^{ik}$ = (1.1,160+180i,90+180k)
point $D_{6D}{}^{ik}$ = (1.1,130+180i,90+180k).

(ix) $15 + 60j \leq \phi \leq 45 + 60j$ (j = an integer of 0 to 5). For the integer pairs (i,k), i.e., (0,0), (0,1), (1,0), and (1,1) on the orthogonal coordinate system $(kh_1,\theta,$

$\psi$), values in the internal regions of four quadrangular pyramids each of which has its vertex at a point $P_{6E}^{ik}$ and, as its bottom surface, a planar rectangular region with its vertexes at points $A_{6E}^{ik}$, $B_{6E}^{ik}$, $C_{6E}^{ik}$, and $D_{6E}^{ik}$,

where

point $P_{6E}^{ik} = (0.85,30+180i,70+180k)$
point $A_{6E}^{ik} = (1.1,20+180i,50+180k)$.
point $B_{6E}^{ik} = (1.1,40+180i,50+180k)$
point $C_{6E}^{ik} = (1.1,40+180i,90+180k)$
point $D_{6E}^{ik} = (1.1,20+180i,90+180k)$.

In the structure of the SAW device according to the sixth embodiment, a propagation velocity V is exclusively determined by $kh_1$ of the $LiNbO_3$ layer 360, as in the second embodiment, as shown in Fig. 23. Therefore, it is confirmed that, when $kh_1$ is equal to or smaller than 1.1, a propagation velocity V equal to or higher than 8,000 m/s is ensured.

The present inventors set the thickness of the diamond 100 at 20 $\mu$m, and evaluated an electromechanical coupling coefficient $K^2$ while changing $kh_1$ within the above-described limitation for $kh_1$ and simultaneously changing the values $\theta$, $\phi$, and $\psi$.

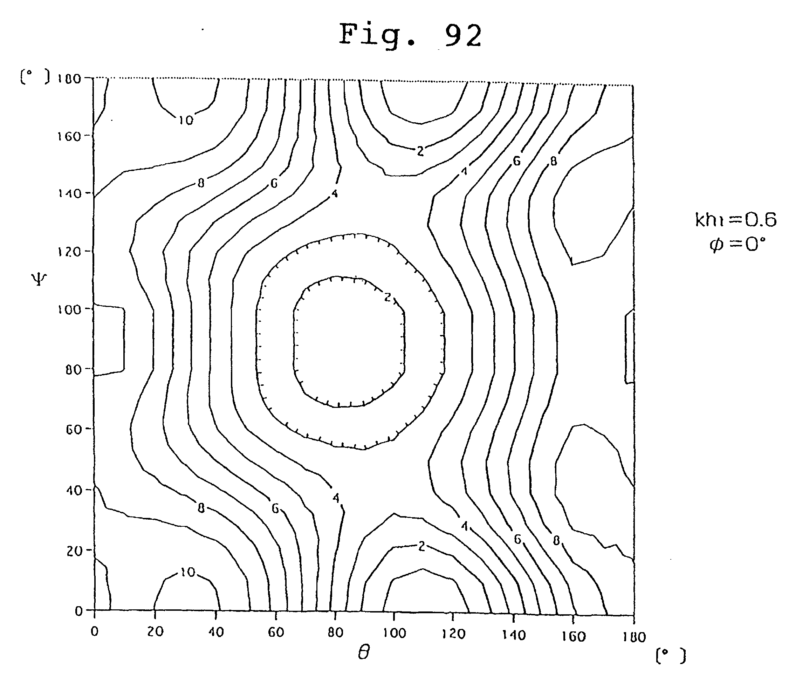

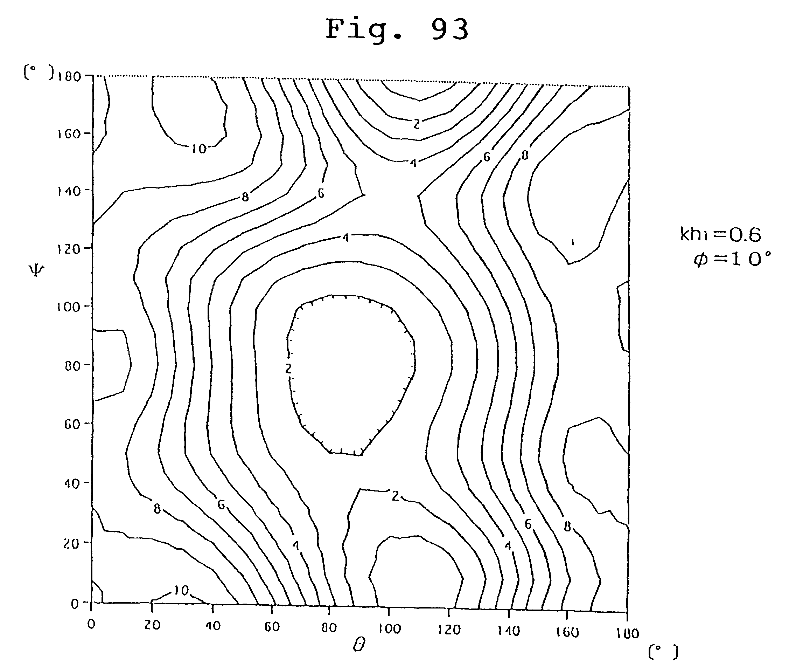

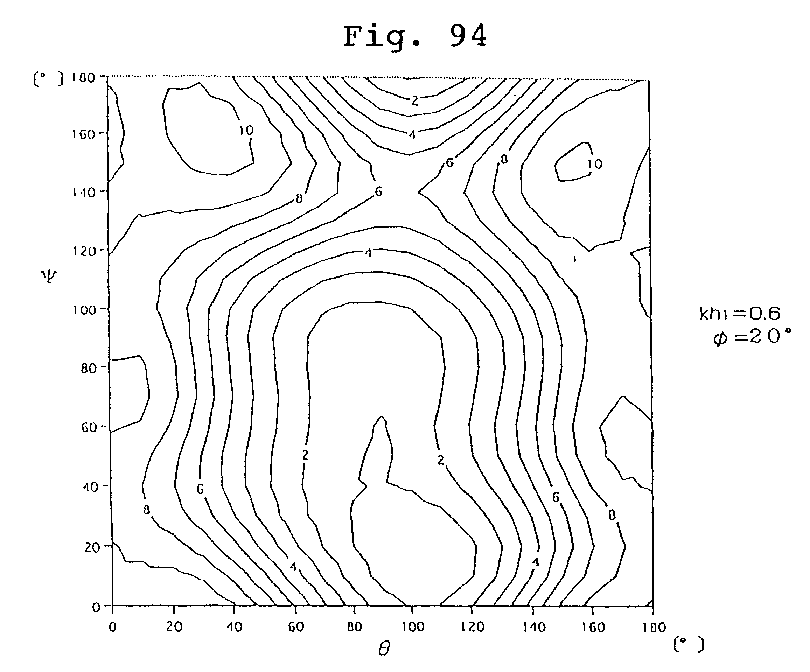

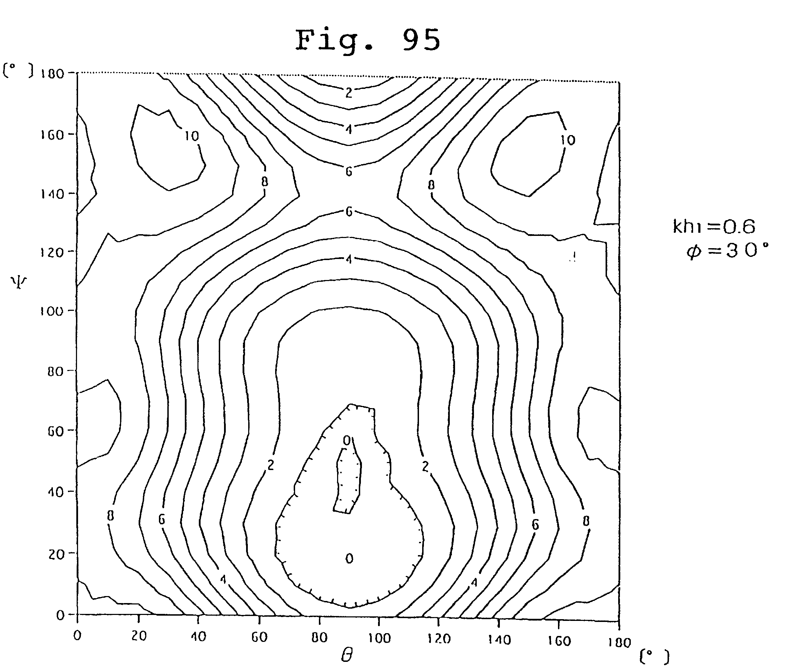

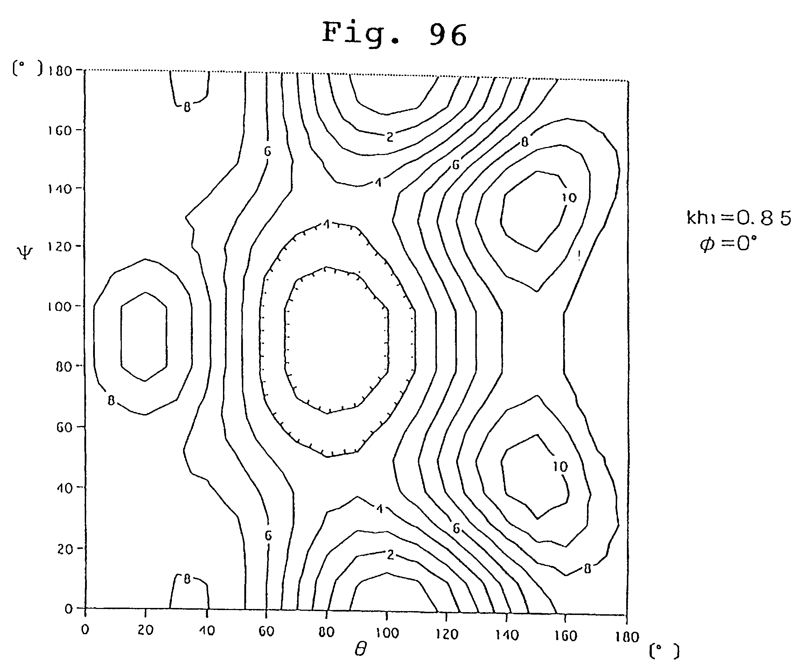

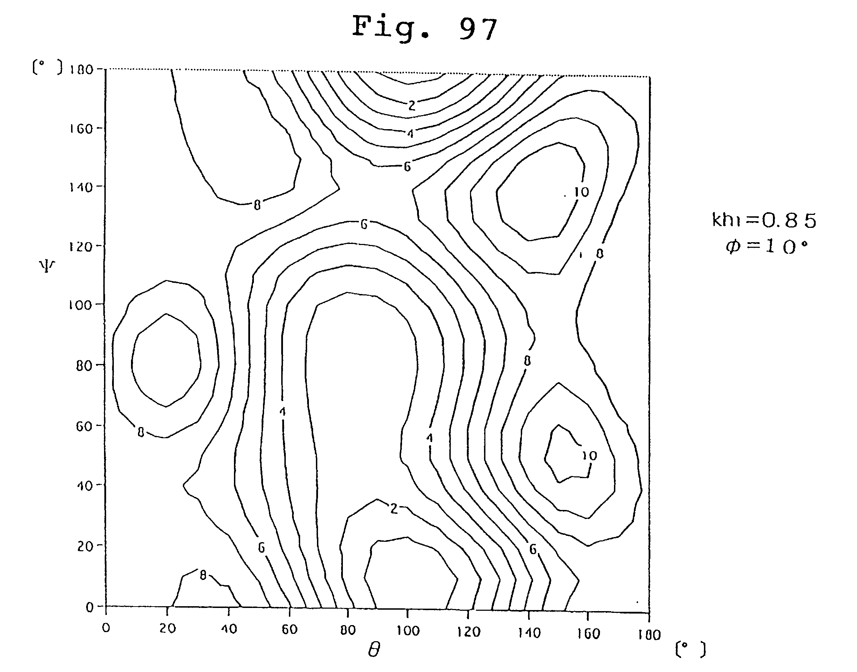

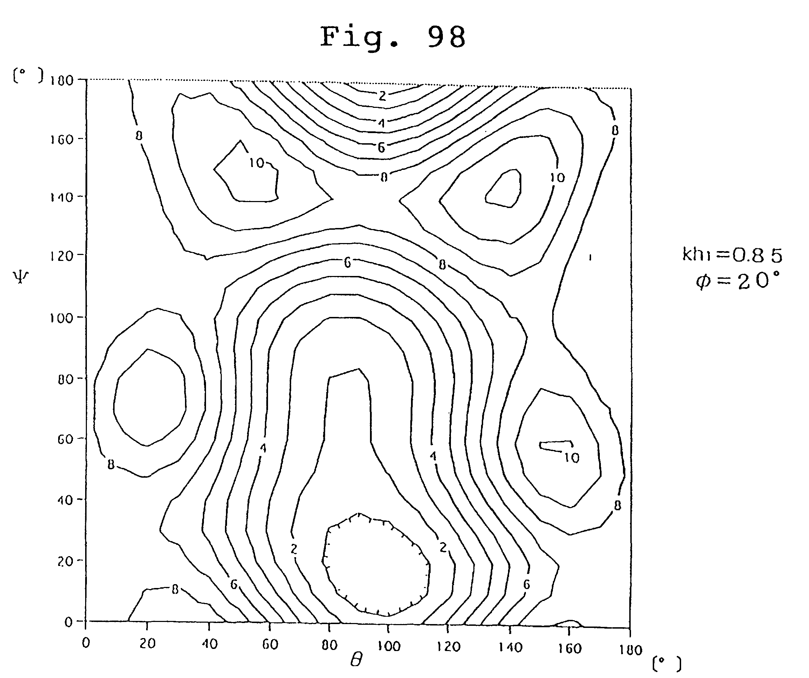

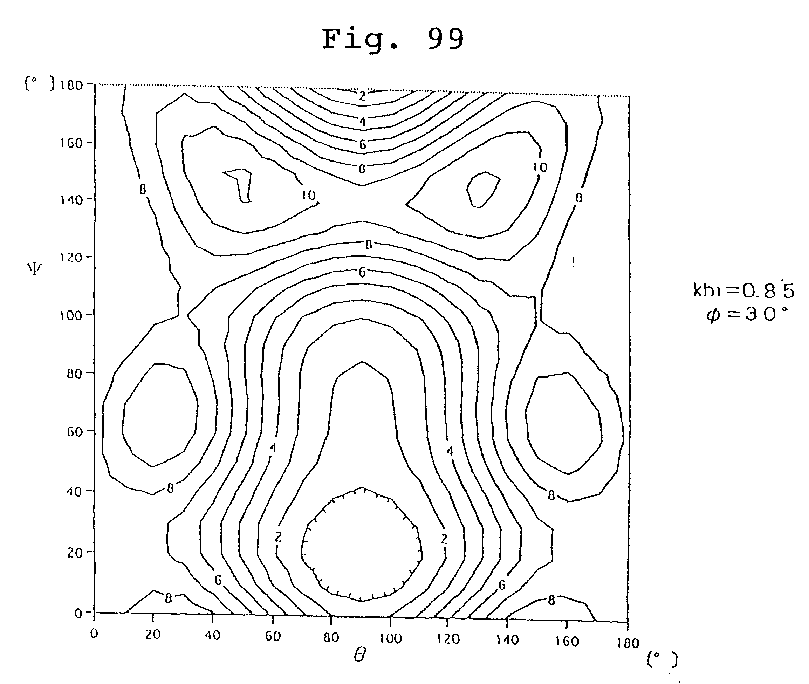

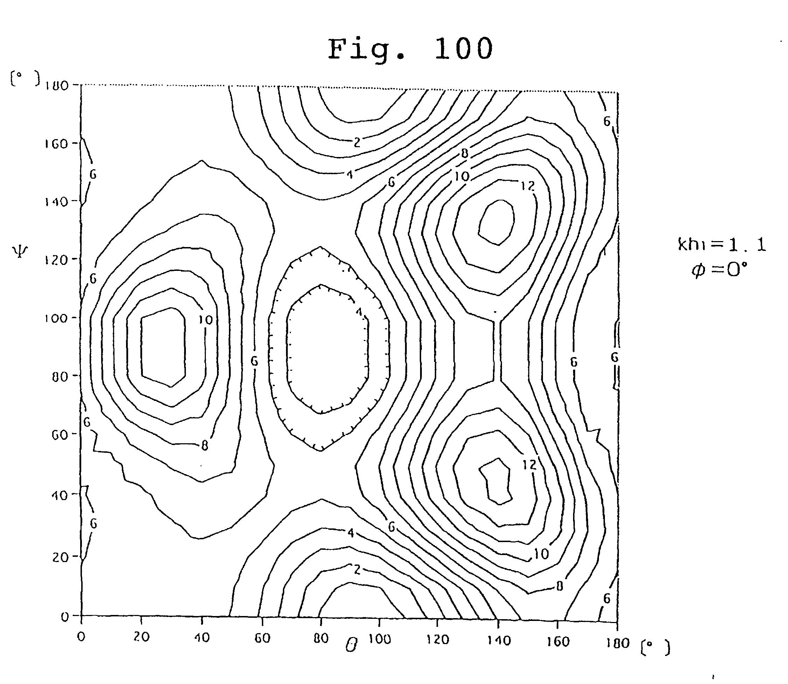

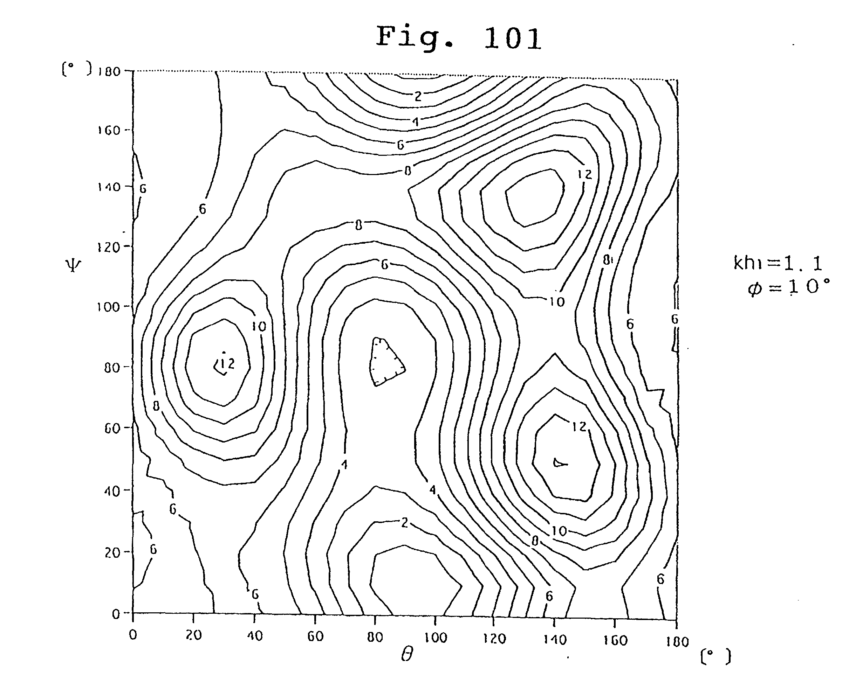

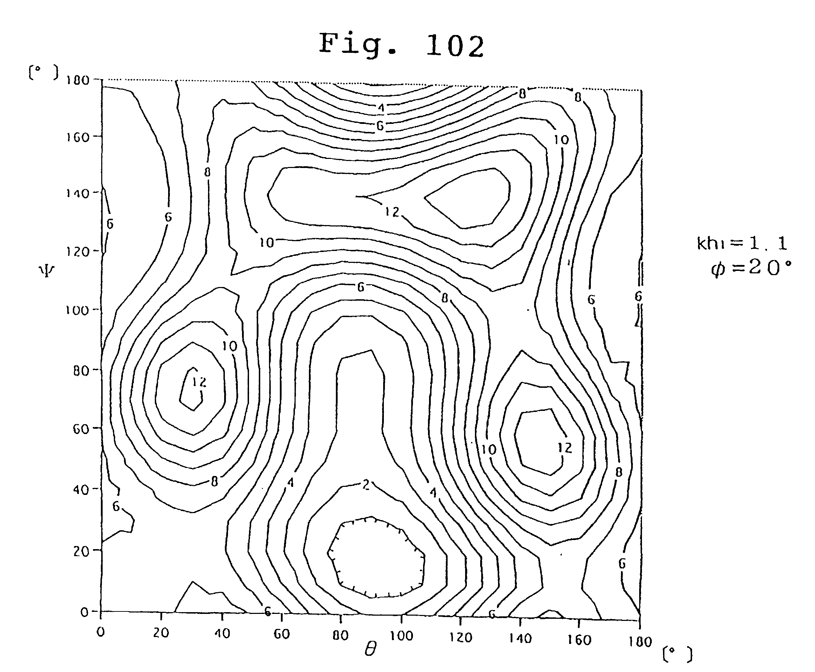

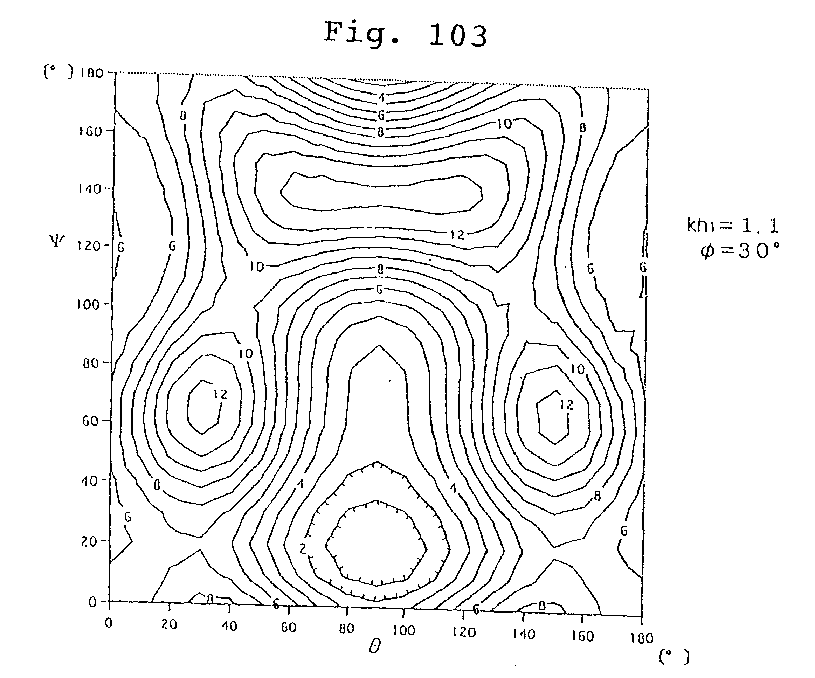

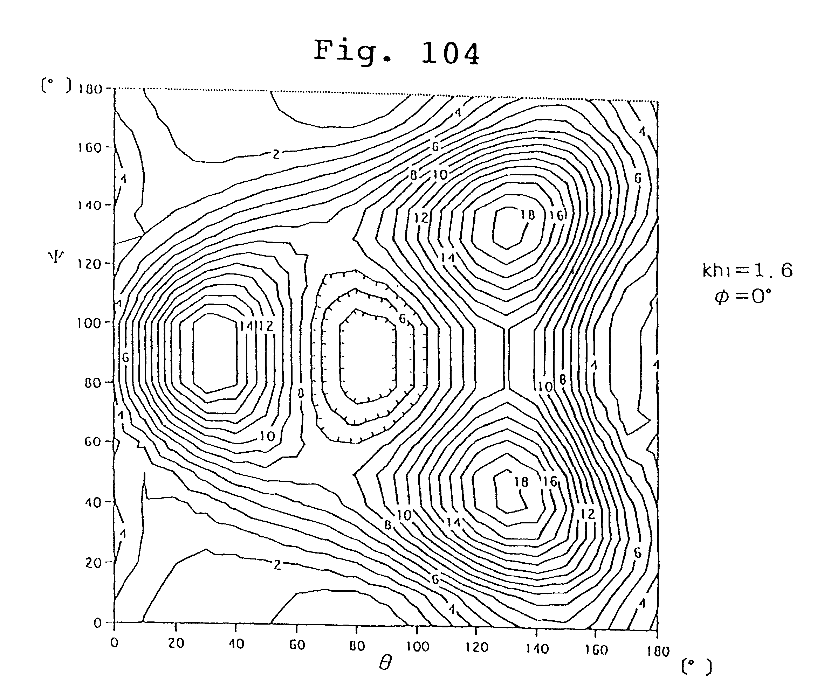

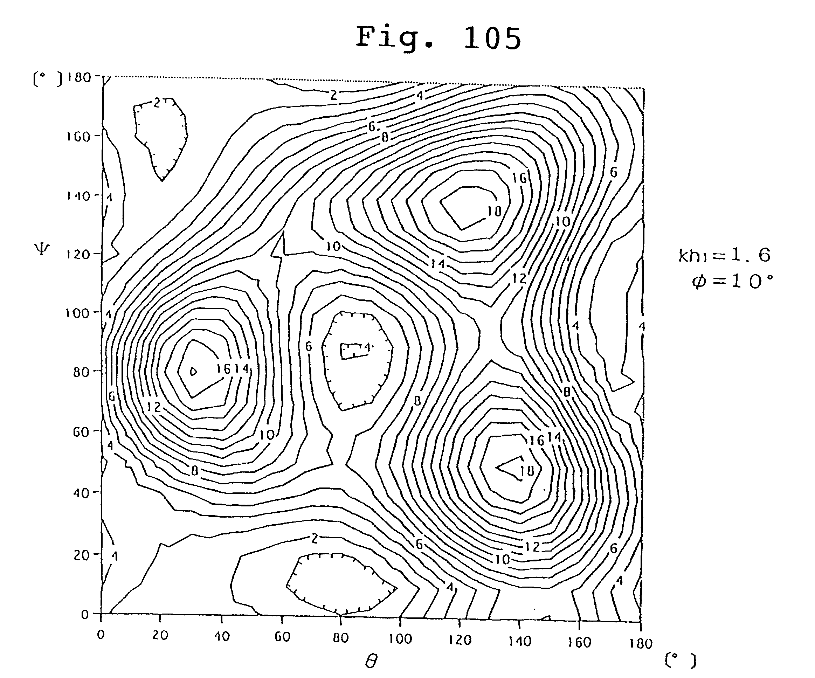

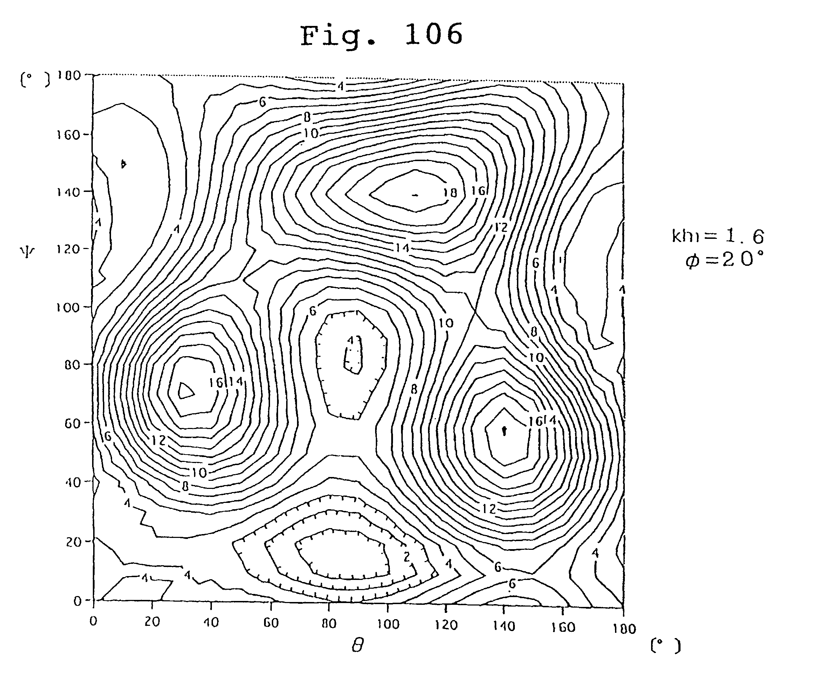

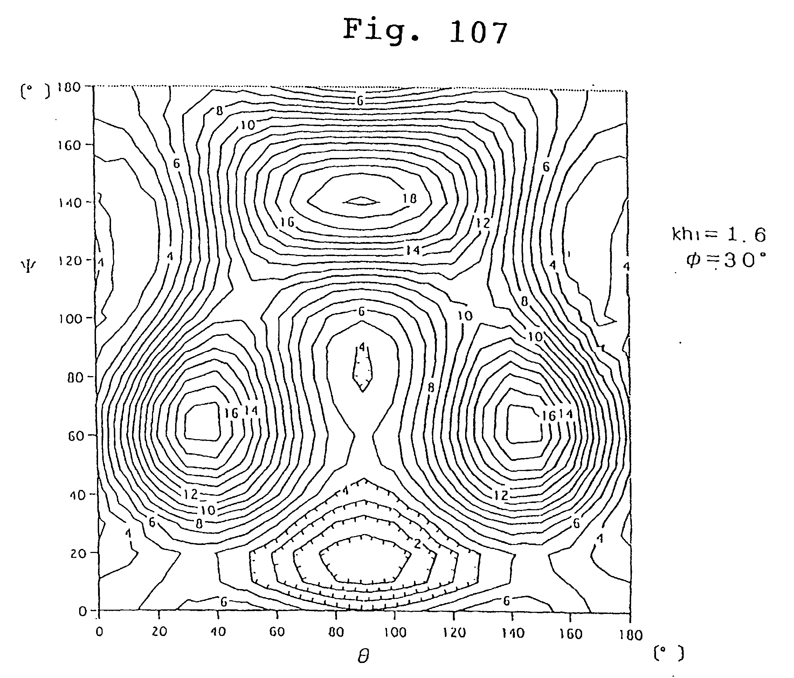

Figs. 92 to 107 are graphs showing contour lines obtained upon evaluating the electromechanical coupling coefficient $K^2$ [%] under conditions that $kh_1 = 0.6, 0.85, 1.1,$ and $1.6, \phi = 0°, 10°, 20°,$ and $30°, 0° \leq \theta \leq 180°$, and $0° \leq \psi \leq 180°$. Note that the values $\theta$ and $\psi$ are plotted in units of $10°$ in these graphs.

Regions for satisfying the electromechanical coupling coefficient $K^2$ of 10% or more are obtained from Figs. 92 to 107. Taking the symmetry of the $LiNbO_3$ crystal into consideration, it is confirmed that, when the propagation velocity V is 8,000 m/s or more, and the electromechanical coupling coefficient $K^2$ is 10% or more, the four parameters $kh_1$, $\theta$, $\phi$, and $\psi$ are set in the internal regions of the four hexahedrons represented by (i), (ii), (iv), (v), (vi), (vii), or (viii), or the four quadrangular pyramids represented by (iii) or (ix).

(Seventh Embodiment)

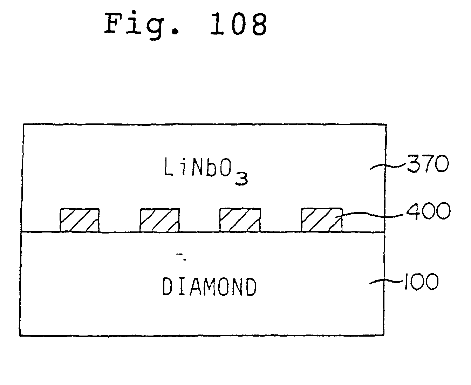

Fig. 108 is a sectional view showing the structure of an SAW device according to the seventh embodiment of the present invention. As shown in Fig. 108, the SAW device of the seventh embodiment comprises (a) diamond 100, (b) an interdigital transducer 400 formed on the diamond 100, and (c) a single crystal $LiNbO_3$ layer 370 formed on the interdigital transducer 400.

The SAW device of the seventh embodiment uses an SAW in the 2nd-order mode.

The $LiNbO_3$ layer 370 is formed by bonding a cut single crystal $LiNbO_3$ thin plate to the diamond 100 having the interdigital transducer 400 formed on its polished surface, and then polishing the single crystal $LiNbO_3$ thin plate. As in the third embodiment, for the interdigital transducer 400, preferably, a recessed portion is formed in the diamond 100 by reactive ion etching, the interdigital transducer 400 is formed with Al or the like in this recessed portion, and the interface to the $LiNbO_3$ layer 370 is entirely flattened.

For the $LiNbO_3$ layer 370, a thickness $t_1$ [$\mu$m] and a crystal orientation $(\theta[°],\phi[°],\psi[°])$ are selected from the following values. Note that $kh_1$ $(= 2\pi(t_1/\lambda)$; $\lambda$ = the wavelength [$\mu$m] of an SAW) is used instead of the thickness $t_1$, as in the first embodiment.

$15 + 60j \leq \phi \leq 45 + 60j$ (j = an integer of 0 to 5). For integer pairs (i,k), i.e., (0,0), (0,1), (1,0), and (1,1) on an orthogonal coordinate system ($kh_1,\theta,\psi$), values in the internal regions of four hexahedrons each of which has, as its opposing bottom surfaces, a planar rectangular region with its vertexes at points $A_{71}^{ik}$, $B_{71}^{ik}$, $C_{71}^{ik}$, and $D_{71}^{ik}$ and a planar rectangular region with its vertexes at points $A_{72}^{ik}$, $B_{72}^{ik}$, $C_{72}^{ik}$, and $D_{72}^{ik}$,

where

point $A_{71}^{ik} = (0.85,50+180i,160+180k)$
point $B_{71}^{ik} = (0.85,100+180i,160+180k)$
point $C_{71}^{ik} = (0.85,90+180i,170+180k)$
point $D_{71}^{ik} = (0.85,50+180i,170+180k)$
point $A_{72}^{ik} = (1.1,40+180i,150+180k)$
point $B_{72}^{ik} = (1.1,140+180i,150+180k)$
point $C_{72}^{ik} = (1.1,140+180i,180+180k)$
point $D_{72}^{ik} = (1.1,40+180i,180+180k)$.

In the structure of the SAW device according to the seventh embodiment, a propagation velocity V is exclusively determined by $kh_1$ of the $LiNbO_3$ layer 370, as in the second embodiment, as shown in Fig. 23. Therefore, it is confirmed that, when $kh_1$ is equal to or smaller than 1.1, a propagation velocity V equal to or higher than 8,000 m/s is ensured.

The present inventors set the thickness of the diamond 100 at 20 $\mu$m, and evaluated an electromechanical coupling coefficient $K^2$ while changing $kh_1$ within the above-described limitation for $kh_1$ and simultaneously changing the values $\theta$, $\phi$, and $\psi$.

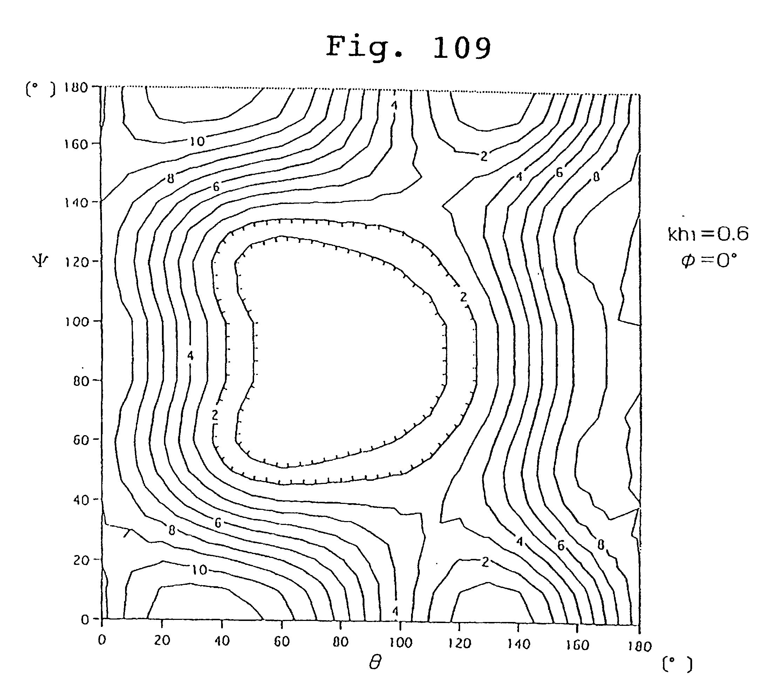

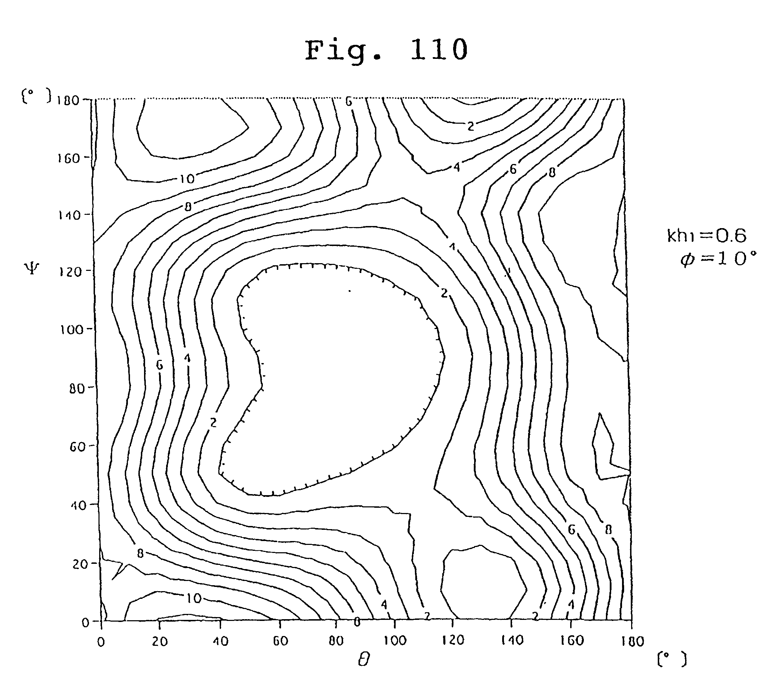

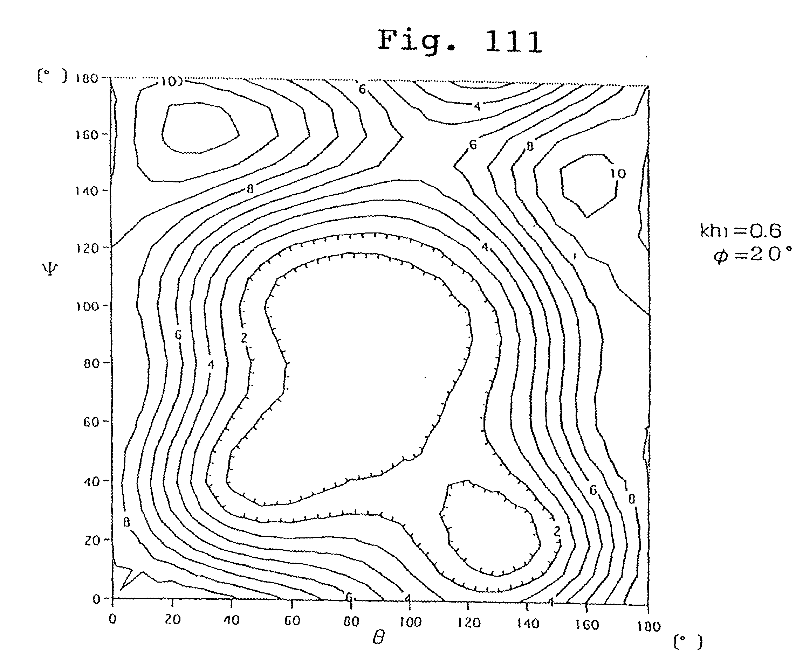

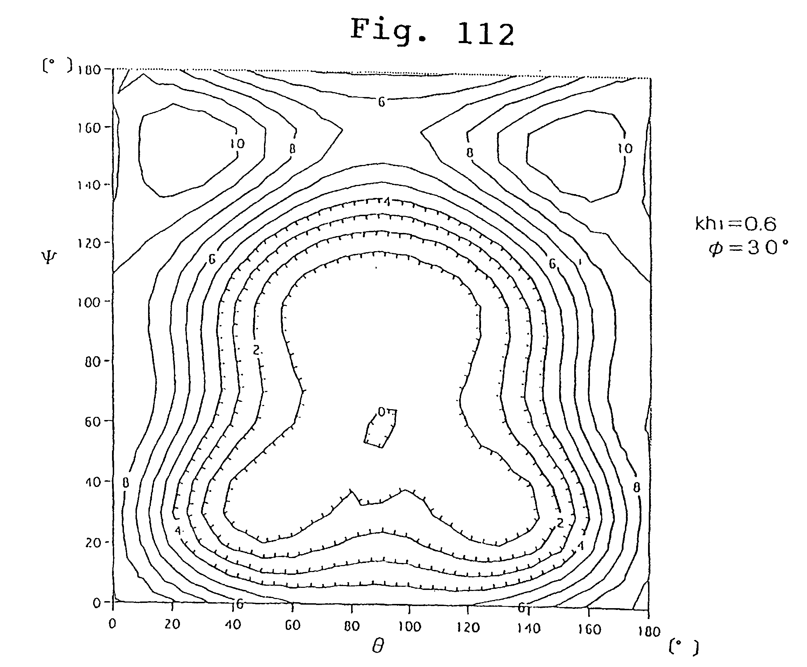

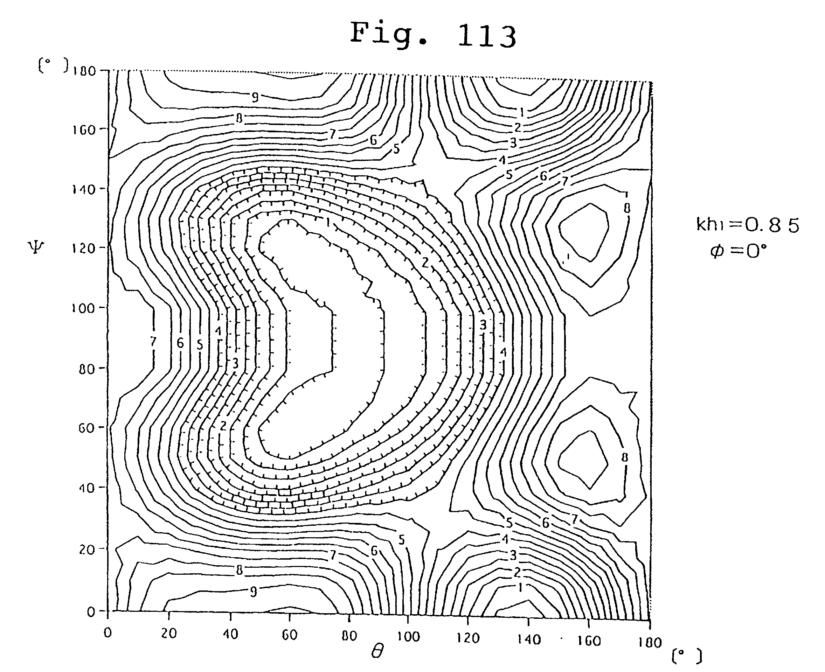

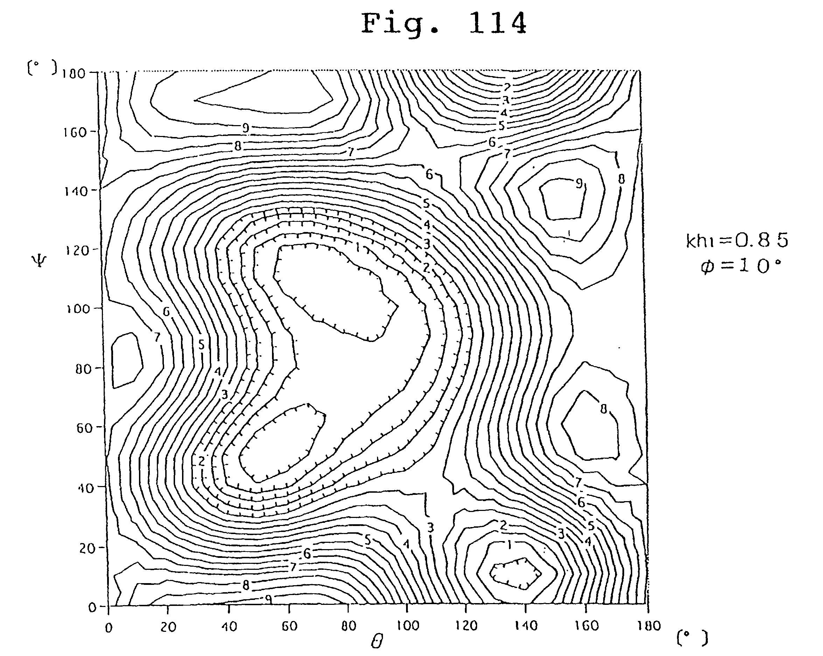

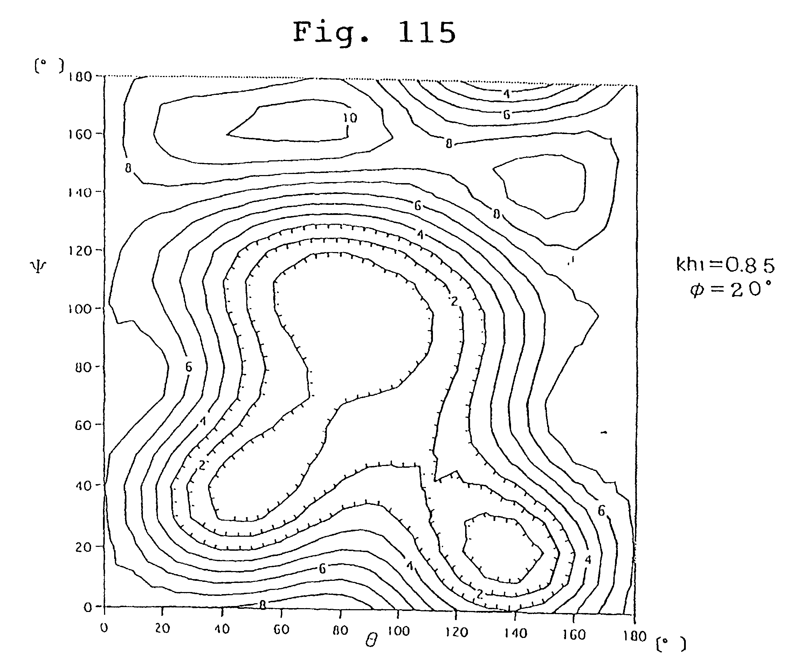

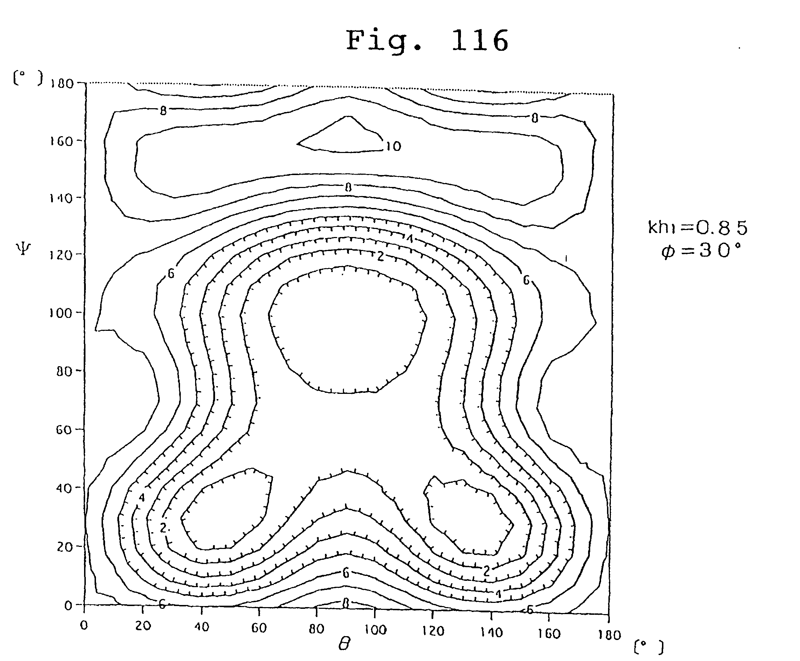

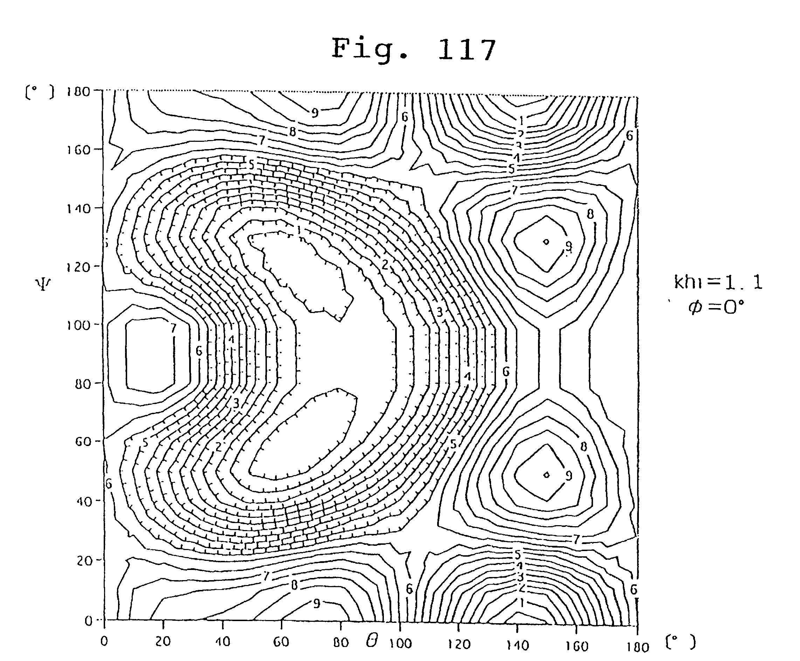

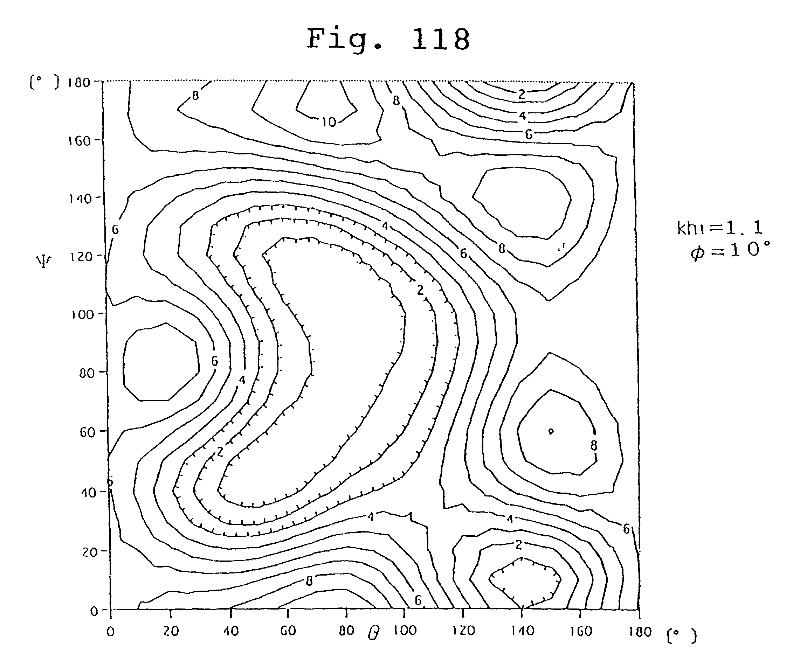

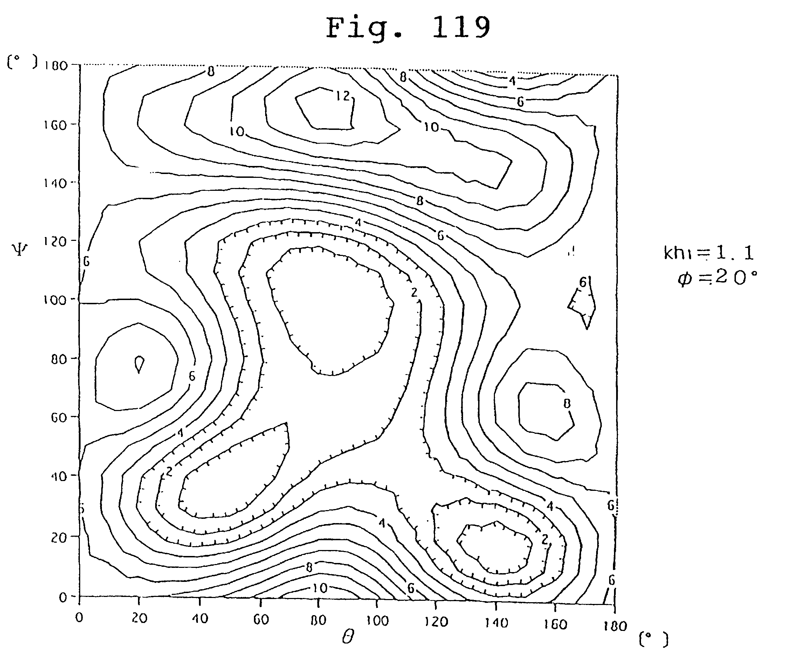

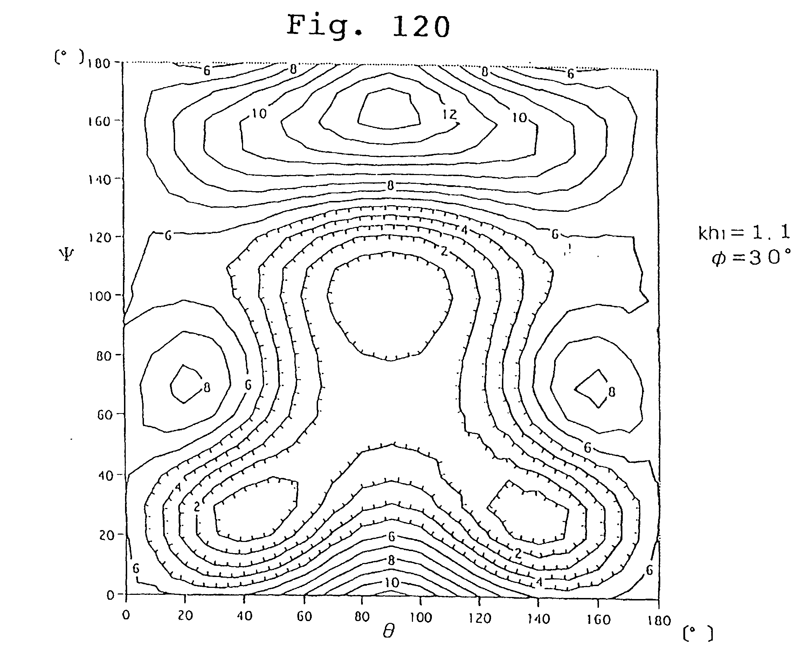

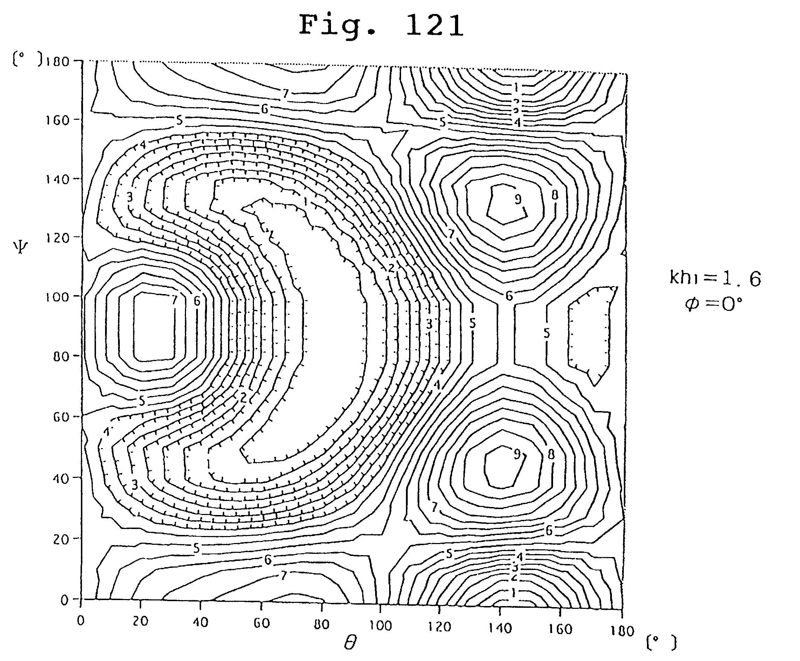

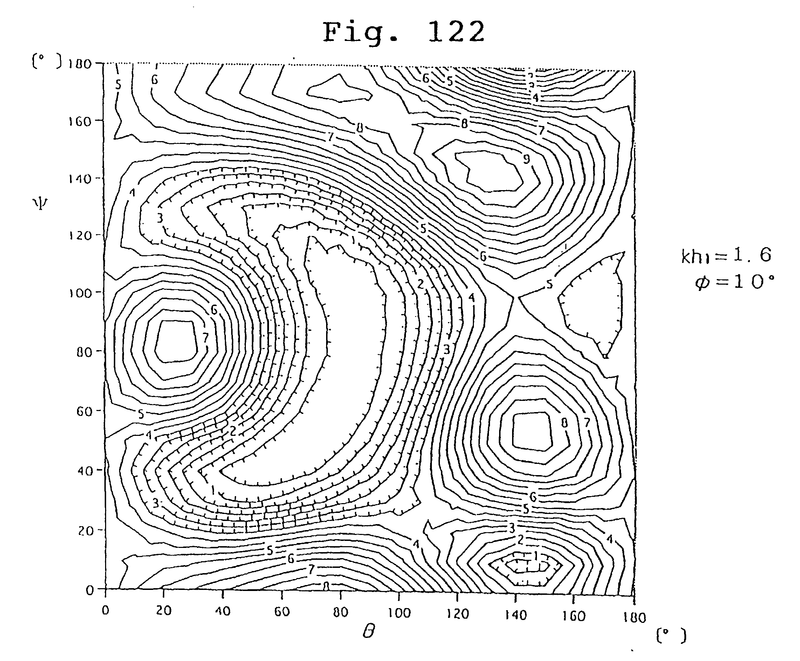

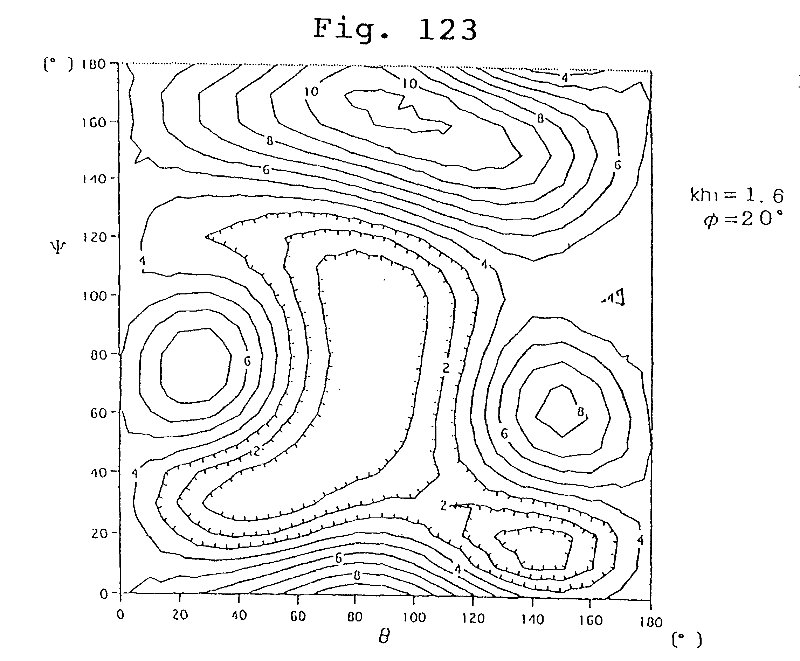

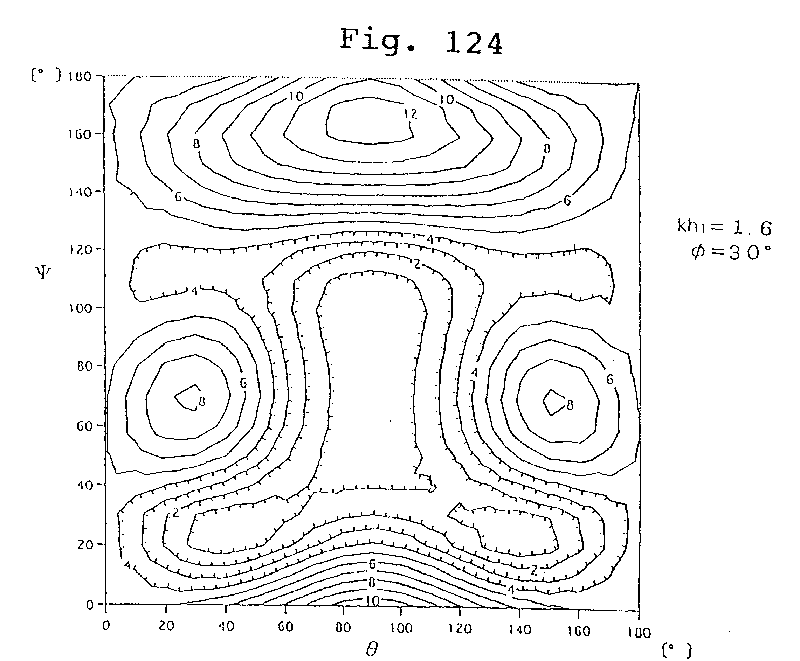

Figs. 109 to 124 are graphs showing contour lines obtained upon evaluating the electromechanical coupling coefficient $K^2$ [%] under conditions that $kh_1 = 0.6, 0.85, 1.1,$ and $1.6, \phi = 0°, 10°, 20°,$ and $30°, 0° \leq \theta \leq 180°$, and $0° \leq \psi \leq 180°$. Note that the values $\theta$ and $\psi$ are plotted in units of $10°$ in these graphs.

Regions for satisfying the electromechanical coupling coefficient $K^2$ of 10% or more are obtained from Figs. 109 to 124. Taking the symmetry of the $LiNbO_3$ crystal into consideration, it is confirmed that, when the propagation velocity V is 8,000 m/s or more, and the electromechanical coupling coefficient $K^2$ is 10% or more, the four parameters $kh_1$, $\theta$, $\phi$, and $\psi$ are set in the internal regions of the above four hexahedrons.

The present inventors evaluated an electromechanical coupling coefficient $K^2$ of an SAW device having the same structure as in the seventh embodiment and using the 1st-order mode while changing $kh_1$ and simultaneously changing the values $\theta$, $\phi$, and $\psi$.

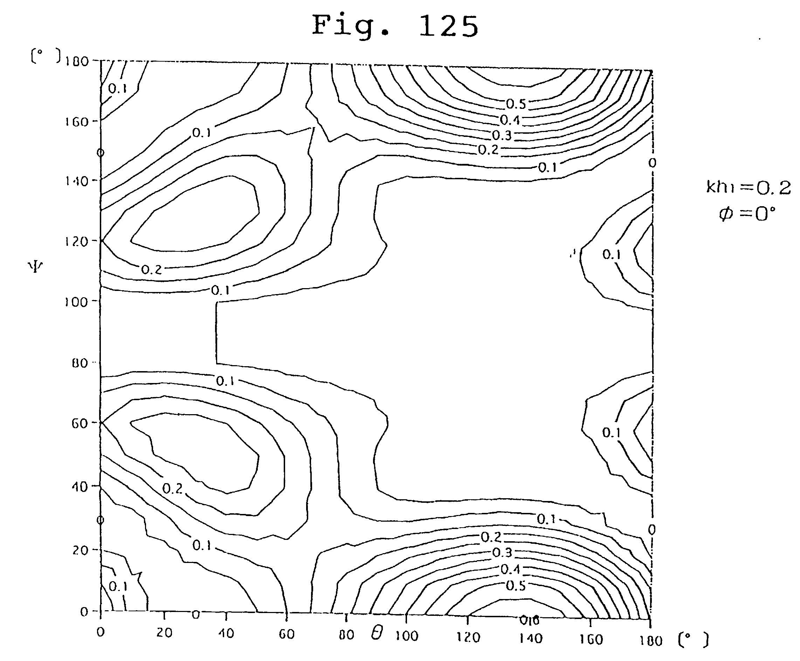

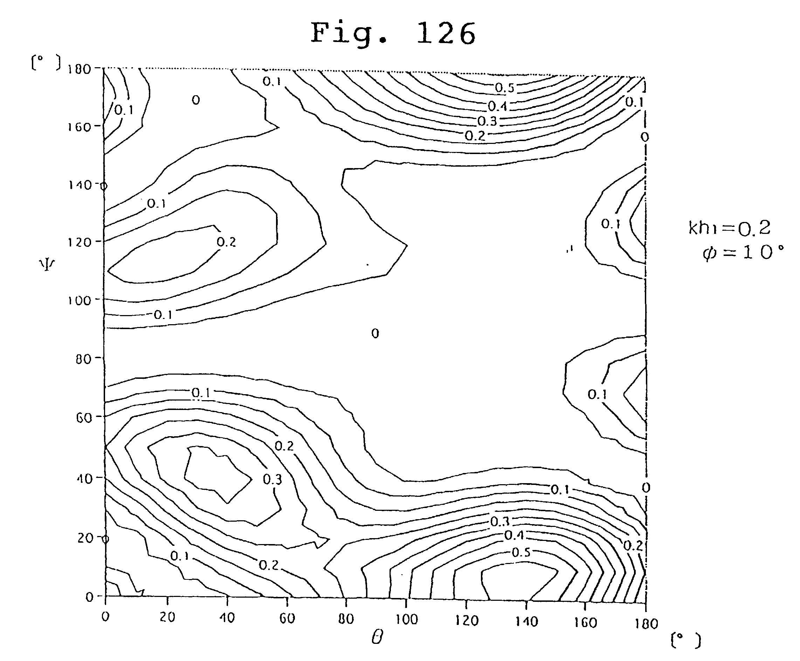

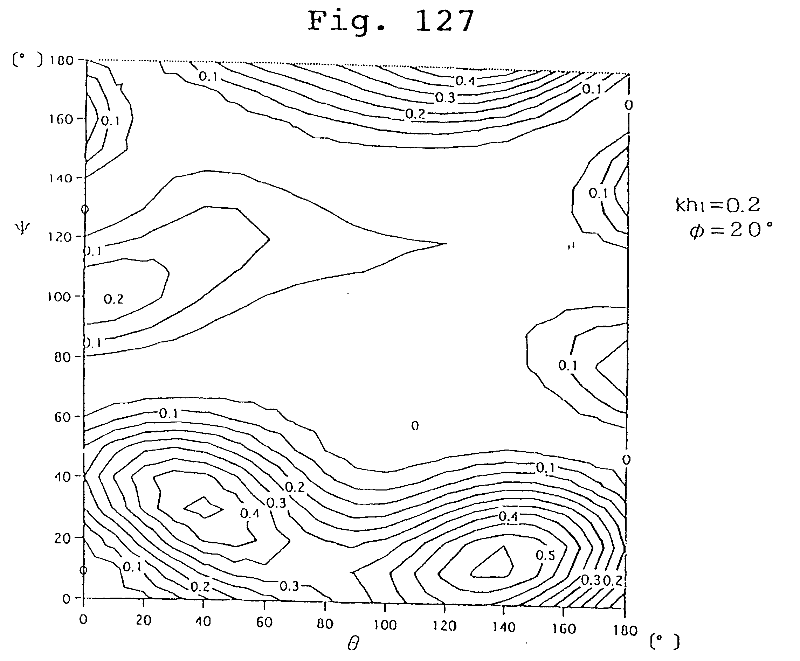

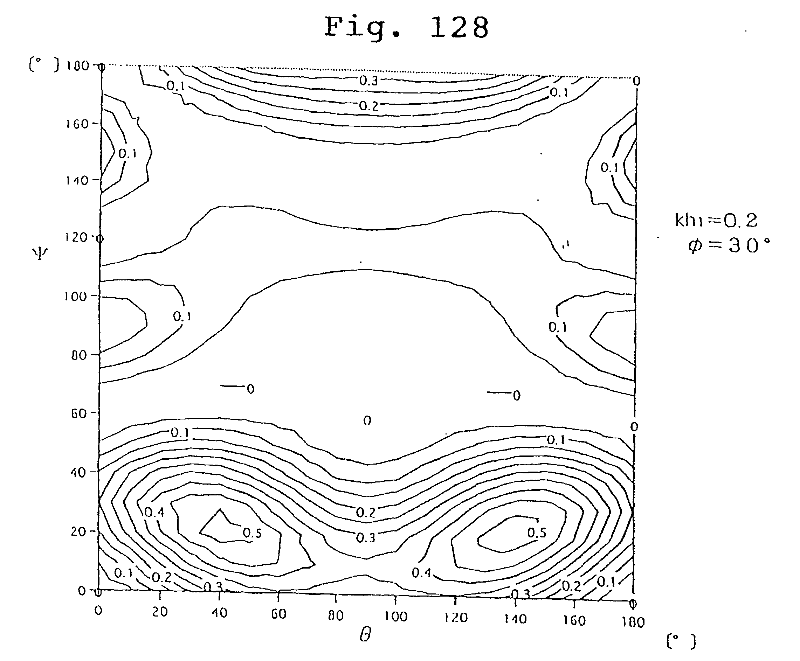

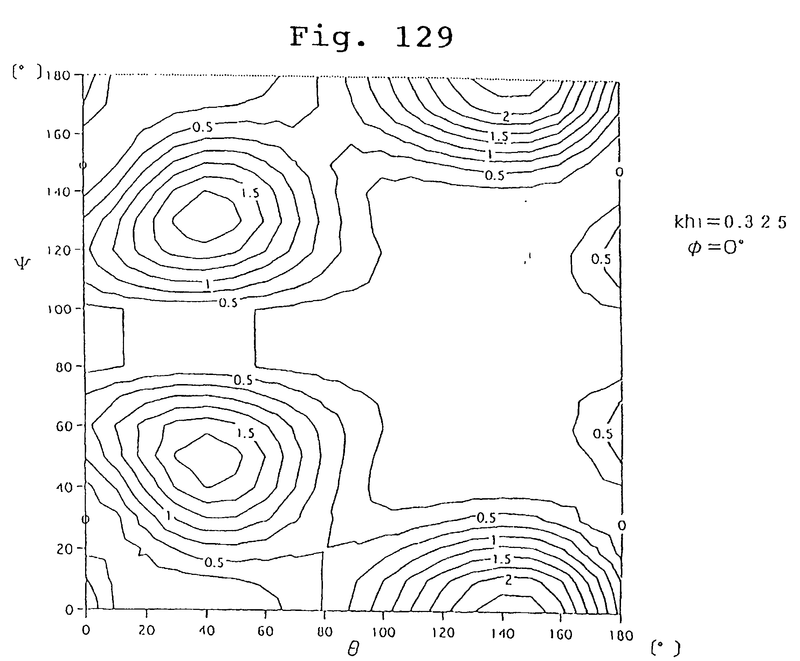

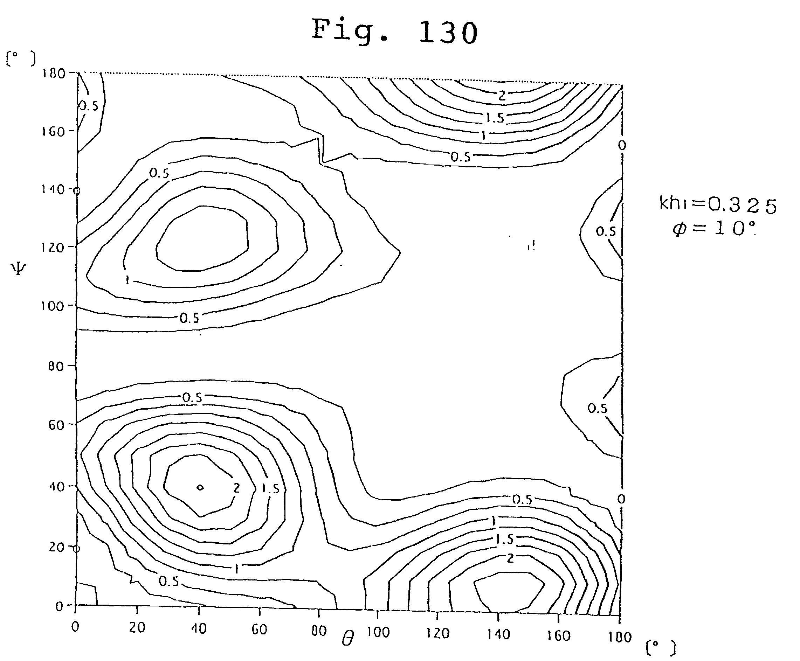

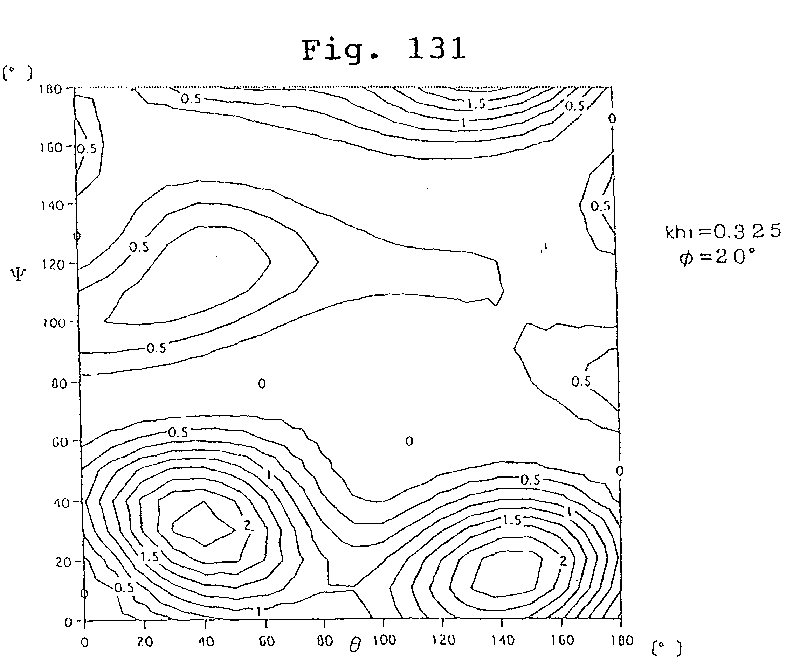

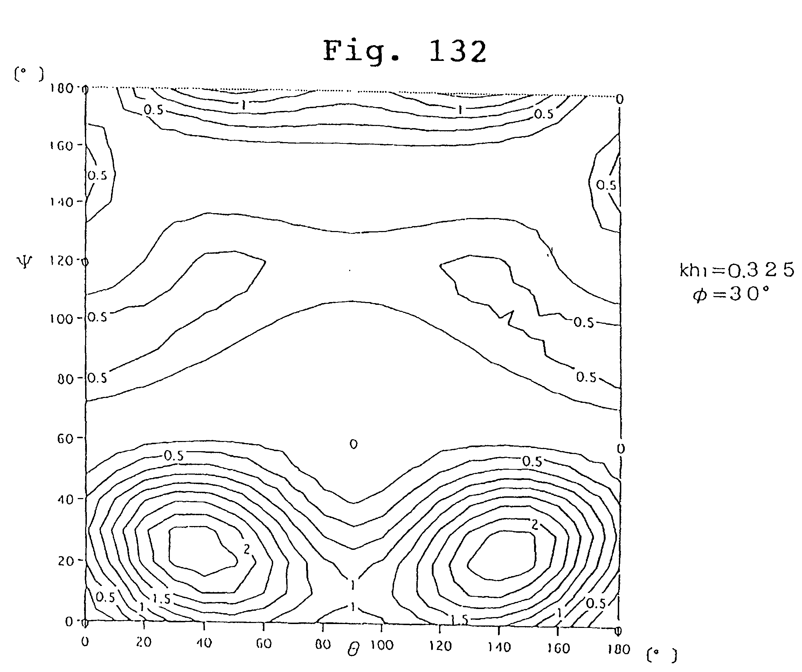

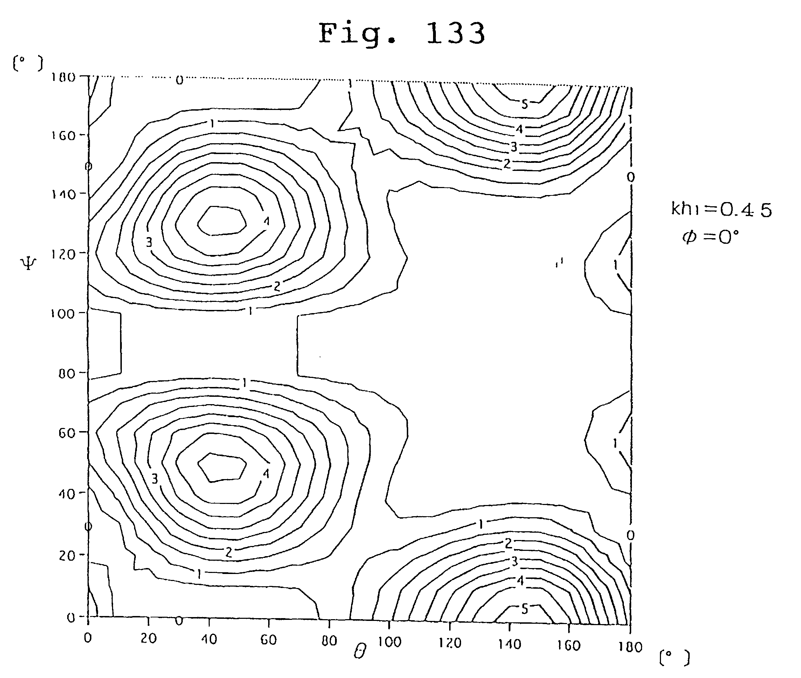

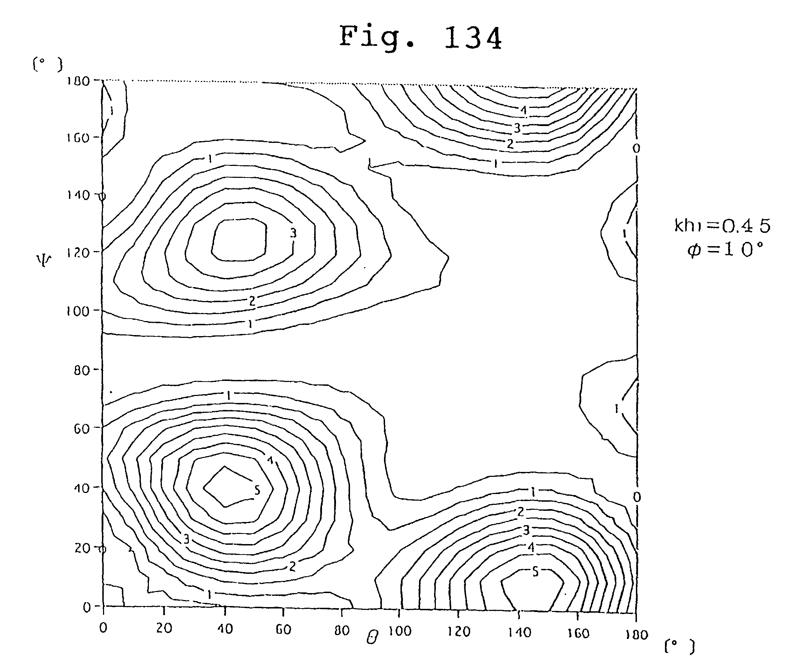

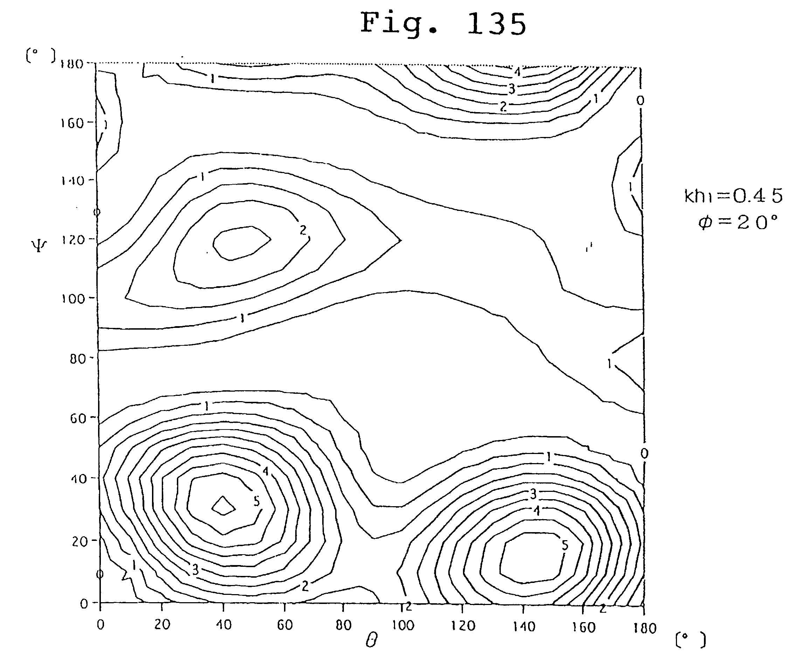

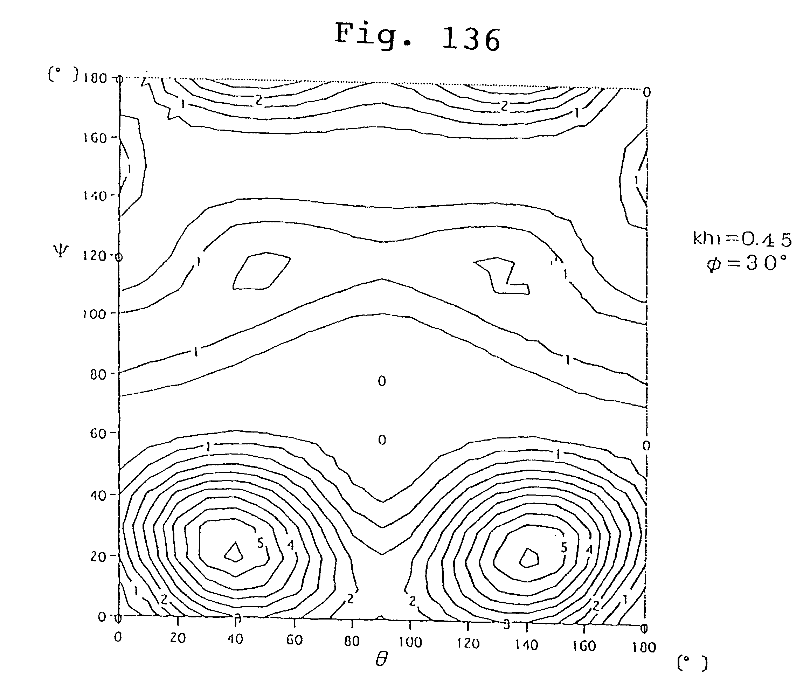

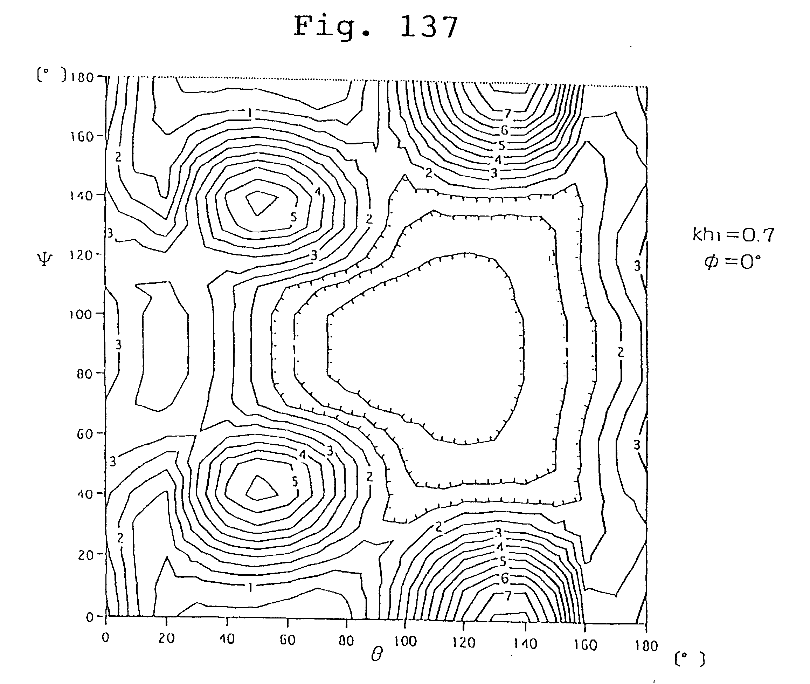

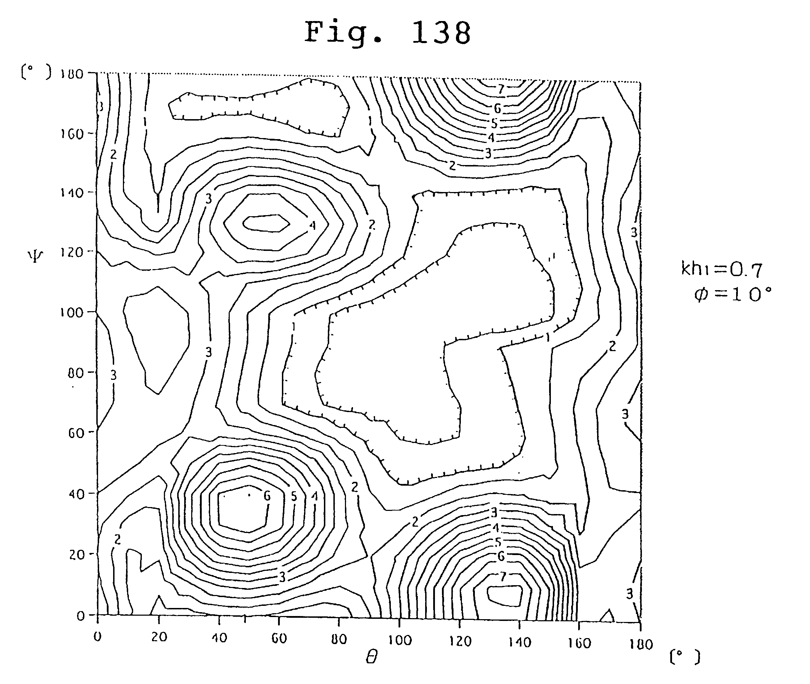

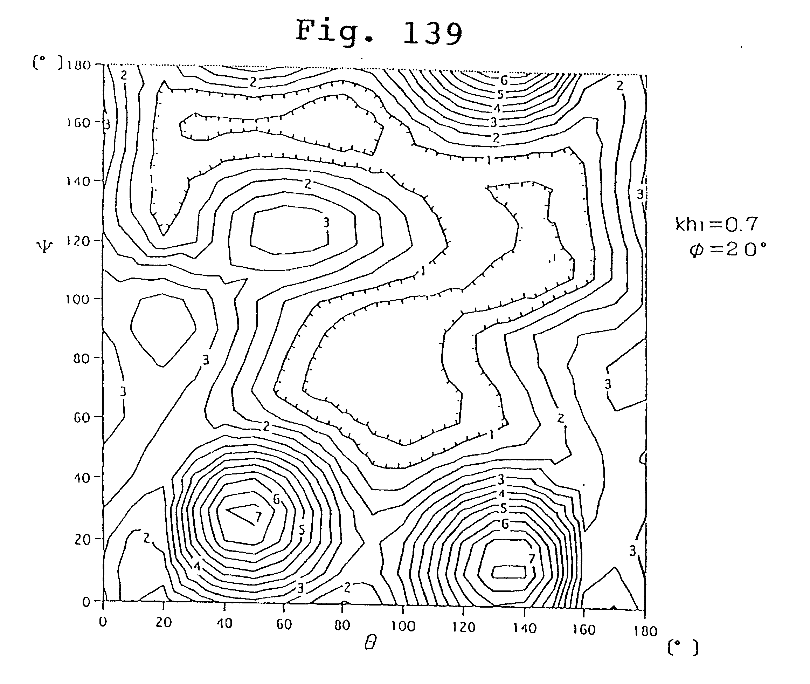

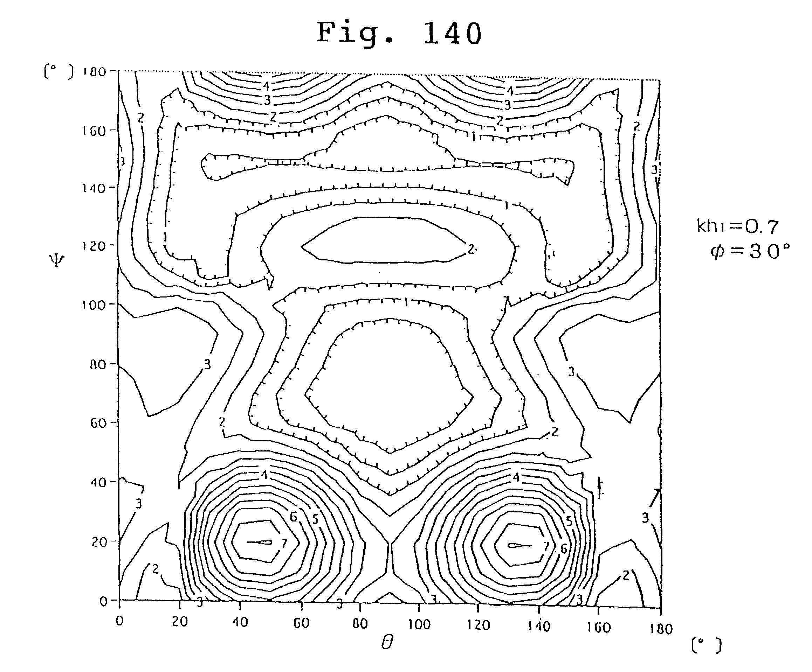

Figs. 125 to 140 are graphs showing contour lines obtained upon evaluating the electromechanical coupling coefficient $K^2$ [%] under conditions that $kh_1 = 0.2, 0.325, 0.6,$ and $0.7$, $\phi = 0°, 10°, 20°,$ and $30°$, $0° \leq \theta \leq 180°$, and $0° \leq \psi \leq 180°$. Note that the values $\theta$ and $\psi$ are plotted in units of $10°$ in these graphs.

It is confirmed from Figs. 125 to 140 that no region for satisfying the electromechanical coefficient $K^2 \geq 10\%$ is present.

From the invention thus described, it will be obvious that the invention may be varied in many ways.

It is to be noted that the embodiments as described herein serve for illustrative purposes only but are not intended to delimit the scope of the invention which is defined by the appended claims.

## Claims

1. A surface acoustic wave device comprising:

    a diamond,

    a short-circuit electrode formed on said diamond,

    a single crystal $LiNbO_3$ layer formed on said short-circuit electrode, said single crystal $LiNbO_3$ layer having a thickness $t_1$ [μm]; and

    an interdigital transducer formed on said $LiNbO_3$ layer;

    said surface acoustic wave device using a surface acoustic wave with wavelength $\lambda$ [μm] in the 1st order mode;

    a parameter $kh_1$ being defined by $kh_1 = 2 \pi t_1 / \lambda$; and

    angles $\theta[°]$, $\phi[°]$, $\psi[°]$ being defined to constitute an Eulerian angle representation $(\theta, \phi, \psi)$ of the crystal orientation on an orthogonal coordinate system $(X,Y,Z)$ with axes $X,Y,Z$ with respect to a crystallographic fundamental coordinate system $(x,y,z)$ with axes $x,y,z$ of said $LiNbO_3$ layer, said Z-axis being set along a normal direction of an exposed surface of said $LiNbO_3$ layer, said X-axis being set along the propagation direction of the surface acoustic wave; and $kh_1$, $\theta$, $\psi$ defining an orthogonal coordinate system $(kh_1,\theta,\psi)$; wherein

    the wavelength $\lambda$ [μm] and the thickness $t_1$ [μm] and crystal orientation of the $LiNbO_3$ layer are chosen such that the values $\phi$, $kh_1$, $\theta$, and $\psi$ are

selected from:

    $0 \leq \phi \leq 360$ and an internal region of a hexahedron in said orthogonal coordinate system $(kh_1,\theta,\psi)$ defined by $kh_1,\theta,\psi$, said hexahedron having as its opposing bottom surfaces, a planar rectangular region with its vertexes at points $A_{11}$, $B_{11}$, $C_{11}$, and $D_{11}$ and a planar rectangular region with its vertexes at points $A_{12}$, $B_{12}$, $C_{12}$, and $D_{12}$, where

    point $A_{11} = (0.45,80,140)$
    point $B_{11} = (0.45,100,140)$
    point $C_{11} = (0.45,100,180)$
    point $D_{11} = (0.45,80,180)$
    point $A_{12} = (0.7,70,120)$
    point $B_{12} = (0.7,110,120)$
    point $C_{12} = (0.7,110,180)$
    point $D_{12} = (0.7,60,180)$, and

    $0 \leq \phi \leq 360$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{13}$, $B_{13}$, $C_{13}$, and $D_{13}$ and a planar rectangular region with its vertexes at points $A_{14}$, $B_{14}$, $C_{14}$, and $D_{14}$, where

    point $A_{13} = (0.45,80,0)$
    point $B_{13} = (0.45,90,0)$
    point $C_{13} = (0.45,90,10)$
    point $D_{13} = (0.45,80,20)$
    point $A_{14} = (0.7,60,0)$
    point $B_{14} = (0.7,110,0)$
    point $C_{14} = (0.7,90,40)$
    point $D_{14} = (0.7,80,40)$.

2. A device according to claim 1, wherein said diamond is a diamond layer formed on a base material, and when a thickness of said diamond layer is $t_2$ [μm], and $kh_2 = 2 \pi t_2 / \lambda$, the following relation is satisfied: $kh_2 \geq 4$.

3. A surface acoustic wave device comprising:

    a diamond,

    a short-circuit electrode formed on said diamond,

    a single crystal $LiNbO_3$ layer formed on said short-circuit electrode, said single crystal $LiNbO_3$ layer having a thickness $t_1$ [μm]; and

    an interdigital transducer formed on said

LiNbO$_3$ layer;

said surface acoustic wave device using a surface acoustic wave with wavelength $\lambda$ [$\mu$m] in the 2nd-order mode;

a parameter kh$_1$ being defined by kh$_1$ = 2 $\pi$ t$_1$/$\lambda$ ; and

angles $\theta$[°], $\phi$[°], $\psi$[°] being defined to constitute an Eulerian angle representation ($\theta$, $\phi$, $\psi$) of the crystal orientation on an orthogonal coordinate system (X,Y,Z) with axes X,Y,Z with respect to a crystallographic fundamental coordinate system (x,y,z) with axes x,y,z of said LiNbO$_3$ layer, said Z-axis being set along a normal direction of an exposed surface of said LiNbO$_3$ layer, said X-axis being set along the propagation direction of the surface acoustic wave; and kh$_1$, $\theta$, $\psi$ defining an orthogonal coordinate system (kh$_1$,$\theta$,$\psi$); wherein

the wavelength $\lambda$ [$\mu$m] and the thickness t$_1$ [$\mu$m] and crystal orientation of the LiNbO$_3$ layer are chosen such that the values $\phi$, kh$_1$, $\theta$, and $\psi$ are selected from:

$0 \leq \phi \leq 15$ and an internal region of a hexahedron in said orthogonal coordinate system (kh$_1$,$\theta$,$\psi$) defined by kh$_1$, $\theta$, $\psi$, said hexahedron having as its opposing bottom surfaces, a planar rectangular region with its vertexes at points A$_{21}$, B$_{21}$, C$_{21}$, and D$_{21}$ and a planar rectangular region with its vertexes at points A$_{22}$, B$_{22}$, C$_{22}$, and D$_{22}$, where

point A$_{21}$ = (0.6,60,40)
point B$_{21}$ = (0.6,110,40)
point C$_{21}$ = (0.6,110,120)
point D$_{21}$ = (0.6,60,120)
point A$_{22}$ = (0.85,50,70)
point B$_{22}$ = (0.85,130,0)
point C$_{22}$ = (0.85,130,180)
point D$_{22}$ = (0.85,50,100),

$0 \leq \phi \leq 15$ and an internal region of a hexahedron in said orthogonal coordinate system (kh$_1$,$\theta$,$\psi$) defined by kh$_1$, $\theta$, $\psi$, said hexahedron having as its opposing bottom surfaces, a planar rectangular region with its vertexes at said points A$_{22}$, B$_{22}$, C$_{22}$, and D$_{22}$ and a planar rectangular region with its vertexes at points A$_{23}$, B$_{33}$, C$_{23}$, and D$_{23}$, where

point A$_{23}$ = (1.1,40,60)

point B$_{23}$ = (1.1,140,0)
point C$_{23}$ = (1.1,140,180)
point D$_{23}$=(1.1,40,110);

$15 \leq \phi \leq 30$ and an internal region of a hexahedron in said orthogonal coordinate system (kh$_1$,$\theta$,$\psi$) defined by kh$_1$, $\theta$, $\psi$, said hexahedron having as its opposing bottom surfaces, a planar rectangular region with its vertexes at points A$_{24}$, B$_{24}$, C$_{24}$, and D$_{24}$ and a planar rectangular region with its vertexes at points A$_{25}$, B$_{25}$, C$_{25}$, and D$_{25}$, where

point A$_{24}$ = (0.6,60,30)
point B$_{24}$ = (0.6,120,30)
point C$_{24}$ = (0.6,120,100)
point D$_{24}$ = (0.6,60,100)
point A$_{25}$ = (0.85,50,30)
point B$_{25}$ = (0.85,130,30)
point C$_{25}$ = (0.85,130,110)
point D$_{25}$ = (0.85,50,110), and

$15 \leq \phi \leq 30$ and an internal region of a hexahedron in said orthogonal coordinate system (kh$_1$,$\theta$,$\psi$) defined by kh$_1$, $\theta$, $\psi$, said hexahedron having as its opposing bottom surfaces, a planar rectangular region with its vertexes at said points A$_{25}$, B$_{25}$, C$_{25}$, and D$_{25}$ and a planar rectangular region with its vertexes at points A$_{26}$, B$_{26}$, C$_{26}$, and D$_{26}$, where

point A$_{26}$ = (1.1,40,30)
point B$_{26}$ = (1.1,140,30)
point C$_{26}$ = (1.1,140,120)
point D$_{26}$ = (1.1,40,120).

4. A device according to claim 3, wherein said diamond is a diamond layer formed on a base material, and when a thickness of said diamond layer is t$_2$ [$\mu$m], and kh$_2$ = 2 $\pi$ t$_2$/$\lambda$, the following relation is satisfied: kh$_2 \geq 4$.

5. A surface acoustic wave device comprising:

a diamond;

an interdigital transducer formed on said diamond;

a single crystal LiNbO$_3$ layer formed on said interdigital transducer, said single crystal LiNbO$_3$ layer having a thickness t$_1$ [$\mu$m]; and

a short-circuit electrode formed on said LiNbO$_3$ layer;

said surface acoustic wave device using a surface acoustic wave with wavelength $\lambda$ [µm] in the 1st-order mode;

a parameter $kh_1$ being defined by $kh_1 = 2 \pi t_1/\lambda$; and

angles $\theta[°]$, $\phi[°]$, $\psi[°]$ being defined to constitute an Eulerian angle representation $(\theta, \phi, \psi)$ of the crystal orientation on an orthogonal coordinate system (X,Y,Z) with axes X,Y,Z with respect to a crystallographic fundamental coordinate system (x,y,z) with axes x,y,z of said $LiNbO_3$ layer, said Z-axis being set along a normal direction of an exposed surface of said $LiNbO_3$ layer, said X-axis being set along the propagation direction of the surface acoustic wave; and $kh_1$, $\theta$, $\psi$ defining an orthogonal coordinate system $(kh_1, \theta, \psi)$; wherein

the wavelength $\lambda$ [µm] and the thickness $t_1$ [µm] and crystal orientation of the $LiNbO_3$ layer are chosen such that the values $\phi$, $kh_1$, $\theta$, and $\psi$ are selected from:

$0 \le \phi \le 15$ and an internal region of a quadrangular pyramid in said orthogonal coordinate system $(kh_1, \theta, \psi)$ defined by $kh_1$, $\theta$, $\psi$, said quadrangular pyramid having its vertex at a point $P_{31}$ and, as its bottom surface, a planar rectangular region with its vertexes at points $A_{31}$, $B_{31}$, $C_{31}$, and $D_{31}$, where

point $P_{31}$ = (0.45,90,150)
point $A_{31}$ = (0.7,70,130)
point $B_{31}$ = (0.7,90,130)
point $C_{31}$ = (0.7,90,180)
point $D_{31}$ = (0.7,70,180), and

$0 \le \phi \le 15$ and an internal region of a hexahedron in said orthogonal coordinate system $(kh_1, \theta, \psi)$ defined by $kh_1$, $\theta$, $\psi$, said hexahedron having as its opposing bottom surfaces, a planar rectangular region with its vertexes at points $A_{32}$, $B_{32}$, $C_{32}$, and $D_{32}$ and a planar rectangular region with its vertexes at points $A_{33}$, $B_{33}$, $C_{33}$, and $D_{33}$, where

point $A_{32}$ = (0.45,80,130)
point $B_{32}$ = (0.45,100,130)
point $C_{32}$ = (0.45,100,150)
point $D_{32}$ = (0.45,80,150)
point $A_{33}$ = (0.7,70,120)
point $B_{33}$ = (0.7,110,120)
point $C_{33}$ = (0.7,110,160)
point $D_{33}$ = (0.7,70,160).

6. A device according to claim 5, wherein said diamond is a diamond layer formed on a base material, and when a thickness of said diamond layer is $t_2$ [µm], and $kh_2 = 2 \pi t_2/\lambda$, the following relation is satisfied: $kh_2 \ge 4$.

7. A surface acoustic wave device comprising:

a diamond;

an interdigital transducer formed on said diamond;

a single crystal $LiNbO_3$ layer formed on said interdigital transducer, said single crystal $LiNbO_3$ layer having a thickness $t_1$ [µm]; and

a short-circuit electrode formed on said $LiNbO_3$ layer;

said surface acoustic wave device using a surface acoustic wave with wavelength $\lambda$ [µm] in the 2nd-order mode;

a parameter $kh_1$ being defined by $kh_1 = 2 \pi t_1/\lambda$; and

angles $\theta[°]$, $\phi[°]$, $\psi[°]$ being defined to constitute an Eulerian angle representation $(\theta, \phi, \psi)$ of the crystal orientation on an orthogonal coordinate system (X,Y,Z) with axes X,Y,Z with respect to a crystallographic fundamental coordinate system (x,y,z) with axes x,y,z of said $LiNbO_3$ layer, said Z-axis being set along a normal direction of an exposed surface of said $LiNbO_3$ layer, said X-axis being set along the propagation direction of the surface acoustic wave; and $kh_1$, $\theta$, $\psi$, defining an orthogonal coordinate system $(kh_1, \theta, \psi)$; wherein

the wavelength $\lambda$ [µm] and the thickness $t_1$ [µm] and crystal orientation of the $LiNbO_3$ layer are chosen such that the values $\phi$, $kh_1$, $\theta$, and $\psi$ are selected from:

$0 \le \phi \le 15$ and an internal region of a hexahedron in said orthogonal coordinate system $(kh_1, \theta, \psi)$ defined by $kh_1$, $\theta$, $\psi$, said hexahedron having as its opposing bottom surfaces, a planar rectangular region with its vertexes at points $A_{41}$, $B_{41}$, $C_{41}$, and $D_{41}$ and a planar rectangular region with its vertexes at points $A_{42}$, $B_{42}$, $C_{42}$, and $D_{42}$, where

point $A_{41}$ = (0.6,70,40)
point $B_{41}$ = (0.6,100,40)
point $C_{41}$ = (0.6,100,110)

point $D_{41}$ = (0.6,70,110)
point $A_{42}$ = (0.85,70,60)
point $B_{42}$ = (0.85,120,0)
point $C_{42}$ = (0.85,120,180)
point $D_{42}$ = (0.85,70,100),

$0 \le \phi \le 15$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at said points $A_{42}$, $B_{42}$, $C_{42}$, and $D_{42}$ and a planar rectangular region with its vertexes at points $A_{43}$, $B_{43}$, $C_{43}$, and $D_{43}$,
where

point $A_{43}$ = (1.1,90,0)
point $B_{43}$ = (1.1,130,0)
point $C_{43}$ = (1.1,130,180)
point $D_{43}$ = (1.1,90,180),

$15 \le \phi \le 30$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{44}$, $B_{44}$, $C_{44}$, and $D_{44}$ and a planar rectangular region with its vertexes at points $A_{45}$, $B_{45}$, $C_{45}$, and $D_{45}$,
where

point $A_{44}$ = (0.6,70,20)
point $B_{44}$ = (0.6,110,20)
point $C_{44}$ = (0.6,100,90)
point $D_{44}$ = (0.6,70,90)
point $A_{45}$ = (0.85,60,10)
point $B_{45}$ = (0.85,120,10)
point $C_{45}$ = (0.85,120,90)
point $D_{45}$ = (0.85,60,90), and

$15 \le \phi \le 30$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at said points $A_{45}$, $B_{45}$, $C_{45}$, and $D_{45}$ and a planar rectangular region with its vertexes at points $A_{46}$, $B_{46}$, $C_{46}$, and $D_{46}$,
where

point $A_{46}$ = (1.1,80,10)
point $B_{46}$ = (1.1,120,10)
point $C_{46}$ = (1.1,130,80)
point $D_{46}$ = (1.1,50,80).

8. A device according to claim 7, wherein said diamond is a diamond layer formed on a base material, and when a thickness of said diamond layer is $t_2$ [$\mu$m], and $kh_2 = 2 \pi t_2/\lambda$, the following relation is satisfied: $kh_2 \ge 4$.

9. A surface acoustic wave device comprising:

a diamond;

single crystal $LiNbO_3$ layer formed on said diamond, said single crystal $LiNbO_3$ layer having a thickness $t_1$ [$\mu$m]; and

an interdigital transducer formed on said $LiNbO_3$ layer;

said surface acoustic wave device using a surface acoustic wave with wavelength $\lambda$ [$\mu$m] in the 1st-order mode;

a parameter $kh_1$ being defined by $kh_1 = 2 \pi t_1/\lambda$; and

angles $\theta[°]$, $\phi[°]$, $\psi[°]$ being defined to constitute an Eulerian angle representation $(\theta, \phi, \psi)$ of the crystal orientation on an orthogonal coordinate system $(X,Y,Z)$ with axes $X,Y,Z$ with respect to a crystallographic fundamental coordinate system $(x,y,z)$ with axes $x,y,z$ of said $LiNbO_3$ layer, said Z-axis being set along a normal direction of an exposed surface of said $LiNbO_3$ layer, said X-axis being set along the propagation direction of the surface acoustic wave; and $kh_1$, $\theta$, $\psi$ defining an orthogonal coordinate system $(kh_1,\theta,\psi)$; wherein

the wavelength $\lambda$ [$\mu$m] and the thickness $t_1$ [$\mu$m] and crystal orientation of the $LiNbO_3$ layer are chosen such that the values $\phi$, $kh_1$, $\theta$, and $\psi$ are selected from:

$0 \le \phi \le 360$ and an internal region of a quadrangular pyramid in said orthogonal coordinate system $(kh_1,\theta,\psi)$ defined by $kh_1$, $\theta$, $\psi$, said quadrangular pyramid having its vertex at a point $P_{51}$ and, as its bottom surface, a planar rectangular region with its vertexes at points $A_{51}$, $B_{51}$, $C_{51}$, and $D_{51}$,
where

point $P_{51}$ = (0.6,90,0)
point $A_{51}$ = (0.7,80,0)
point $B_{51}$ = (0.7,110,0)
point $C_{51}$ = (0.7,110,10)
point $D_{51}$ = (0.7,80,10), and

$0 \le \phi \le 360$ and an internal region of a quadrangular pyramid in said orthogonal coor-

dinate system $(kh_1,\theta,\psi)$ defined by $kh_1$, $\theta$, $\psi$, said quadrangular pyramid having its vertex at a point $P_{52}$ and, as its bottom surface, a planar rectangular region with its vertexes at points $A_{52}$, $B_{52}$, $C_{52}$, and $D_{52}$, where

point $P_{52}$ = (0.6,100,0)
point $A_{52}$ = (0.7,90,170)
point $B_{52}$ = (0.7,100,170)
point $C_{52}$ = (0.7,110,180)
point $D_{52}$ = (0.7,80,180).

**10.** A device according to claim 9, wherein said diamond is a diamond layer formed on a base material, and when a thickness of said diamond layer is $t_2$ [μm], and $kh_2 = 2\pi t_2/\lambda$, the following relation is satisfied: $kh_2 \geq 4$.

**11.** A surface acoustic wave device comprising:

a diamond;

single crystal $LiNbO_3$ layer formed on said diamond, said single crystal $LiNbO_3$ layer having a thickness $t_1$ [μm]; and

an interdigital transducer formed on said $LiNbO_3$ layer;

said surface acoustic wave device using a surface acoustic wave with wavelength $\lambda$ [μm] in the 2nd-order mode;

a parameter $kh_1$ being defined by $kh_1 = 2\pi t_1/\lambda$; and

angles $\theta[°]$, $\phi[°]$, $\psi[°]$ being defined to constitute an Eulerian angle representation $(\theta, \phi, \psi)$ of the crystal orientation on an orthogonal coordinate system (X,Y,Z) with axes X,Y,Z with respect to a crystallographic fundamental coordinate system (x,y,z) with axes x,y,z of said $LiNbO_3$ layer, said Z-axis being set along a normal direction of an exposed surface of said $LiNbO_3$ layer, said X-axis being set along the propagation direction of the surface acoustic wave; and $kh_1$, $\theta$, $\psi$ defining an orthogonal coordinate system $(kh_1,\theta,\psi)$; wherein

the wavelength $\lambda$ [μm] and the thickness $t_1$ [μm] and crystal orientation of the $LiNbO_3$ layer are chosen such that the values $\phi$, $kh_1$, $\theta$, and $\psi$ are selected from:

$0 \leq \phi \leq 15$ and an internal region of a hexahedron in said orthogonal coordinate system $(kh_1,\theta,\psi)$ defined by $kh_1$, $\theta$, $\psi$, said

hexahedron having as its opposing bottom surfaces, a planar rectangular region with its vertexes at points $A_{61}$, $B_{61}$, $C_{61}$, and $D_{61}$ and a planar rectangular region with its vertexes at points $A_{62}$, $B_{62}$, $C_{62}$, and $D_{62}$, where

point $A_{61}$ = (0.85,140,40)
point $B_{61}$ = (0.85,160,40)
point $C_{61}$ = (0.85,160,60)
point $D_{61}$ = (0.85,140,80)
point $A_{62}$ = (1.1,120,30)
point $B_{62}$ = (1.1,170,30)
point $C_{62}$ = (1.1,170,70)
point $D_{62}$ = (1.1,120,70),

$0 \leq \phi \leq 15$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{63}$, $B_{63}$, $C_{63}$, and $D_{63}$ and a planar rectangular region with its vertexes at points $A_{64}$, $B_{64}$, $C_{64}$, and $D_{64}$, where

point $A_{63}$ = (0.85,130,130)
point $B_{63}$ = (0.85,160,130)
point $C_{63}$ = (0.85,160,150)
point $D_{63}$ = (0.85,130,150)
point $A_{64}$ = (1.1,100,140)
point $B_{64}$ = (1.1,140,100)
point $C_{64}$ = (1.1,160,160)
point $D_{64}$ = (1.1,130,160),

$0 \leq \phi \leq 15$ and an internal region of a quadrangular pyramid in said orthogonal coordinate system $(kh_1,\theta,\psi)$ defined by $kh_1$, $\theta$, $\psi$, said quadrangular pyramid having its vertex at a point $P_{65}$ and, as its bottom surface, a planar rectangular region with its vertexes at points $A_{65}$, $B_{65}$, $C_{65}$, and $D_{65}$, where

point $P_{65}$ = (0.85,30,90)
point $A_{65}$ = (1.1,20,70)
point $B_{65}$ = (1.1,40,70)
point $C_{65}$ = (1.1,40,110)
point $D_{65}$ = (1.1,20,110),

$15 \leq \phi \leq 30$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{66}$, $B_{66}$, $C_{66}$, and $D_{66}$ and a planar rectangular region with its vertexes at points $A_{67}$, $B_{67}$, $C_{67}$, and $D_{67}$,

where

point $A_{66}$ = (0.6,20,150)
point $B_{66}$ = (0.6,40,150)
point $C_{66}$ = (0.6,40,170)
point $D_{66}$ = (0.6,20,170)
point $A_{67}$ = (0.85,50,130)
point $B_{67}$ = (0.85,70,140)
point $C_{67}$ = (0.85,50,160)
point $D_{67}$ = (0.85,20,160),

$15 \leq \phi \leq 30$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{67}$, $B_{67}$, $C_{67}$, and $D_{67}$ and a planar rectangular region with its vertexes at points $A_{68}$, $B_{68}$, $C_{68}$, and $D_{68}$,

where point $A_{68}$ = (1.1,40,120)
point $B_{68}$ = (1.1,90,120)
point $C_{68}$ = (1.1,90,160)
point $D_{68}$ = (1.1,40,160),

$15 \leq \phi \leq 30$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{69}$, $B_{69}$, $C_{69}$, and $D_{69}$ and a planar rectangular region with its vertexes at points $A_{6A}$, $B_{6A}$, $C_{6A}$, and $D_{6A}$, where

point $A_{69}$ = (0.6,140,150)
point $B_{69}$ = (0.6,160,150)
point $C_{69}$ = (0.6,160,160)
point $D_{69}$ = (0.6,140,160)
point $A_{6A}$ = (0.85,100,140)
point $B_{6A}$ = (0.85,130,130)
point $C_{6A}$ = (0.85,160,160)
point $D_{6A}$ = (0.85,130,160),

$15 \leq \phi \leq 30$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{6A}$, $B_{6A}$, $C_{6A}$, and $D_{6A}$ and a planar rectangular region with its vertexes at points $A_{6B}$, $B_{6B}$, $C_{6B}$, and $D_{6B}$, where

point $A_{6B}$ = (1.1,100,120)
point $B_{6B}$ = (1.1,150,120)
point $C_{6B}$ = (1.1,150,160)

point $D_{6B}$ = (1.1,100,160),

$15 \leq \phi \leq 30$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{6C}$, $B_{6C}$, $C_{6C}$, and $D_{6C}$ and a planar rectangular region with its vertexes at points $A_{6D}$, $B_{6D}$, $C_{6D}$, and $D_{6D}$, where

point $A_{6C}$ = (0.85,150,50)
point $B_{6C}$ = (0.85,160,50)
point $C_{6C}$ = (0.85,160,60)
point $D_{6C}$ = (0.85,150,60)
point $A_{6D}$ = (1.1,130,40)
point $B_{6D}$ = (1.1,160,40)
point $C_{6D}$ = (1.1,160,90)
point $D_{6D}$ = (1.1,130,90), and

$15 \leq \phi \leq 30$ and an internal region of a quadrangular pyramid in said orthogonal coordinate system $(kh_1,\theta,\psi)$ defined by $kh_1$, $\theta$, $\psi$, said quadrangular pyramid having its vertex at a point $P_{6E}$ and, as its bottom surface, a planar rectangular region with its vertexes at points $A_{6E}$, $B_{6E}$, $C_{6E}$, and $D_{6E}$, where

point $P_{6E}$ = (0.85,30,70)
point $A_{6E}$ = (1.1,20,50)
point $B_{6E}$ = (1.1,40,50)
point $C_{6E}$ = (1.1,40,90)
point $D_{6E}$ = (1.1,20,90).

12. A device according to claim 11, wherein said diamond is a diamond layer formed on a base material, and when a thickness of said diamond layer is $t_2$ [μm], and $kh_2 = 2 \pi t_2/\lambda$, the following relation is satisfied: $kh_2 \geq 4$.

13. A surface acoustic wave device comprising:

a diamond;

an interdigital transducer formed on said diamond; and

a single crystal $LiNbO_3$ layer formed on said interdigital transducer, said single crystal $LiNbO_3$ layer having a thickness $t_1$ [μm];

said surface acoustic wave device using a surface acoustic wave with wavelength $\lambda$ [μm] in the 2nd-order mode;

a parameter $kh_1$ being defined by $kh_1 = 2\pi t_1/\lambda$; and

angles $\theta[°]$, $\phi[°]$, $\psi[°]$ being defined to constitute an Eulerian angle representation $(\theta, \phi, \psi)$ of the crystal orientation on an orthogonal coordinate system $(X,Y,Z)$ with axes $X,Y,Z$ with respect to a crystallographic fundamental coordinate system $(x,y,z)$ with axes $x,y,z$ of said $LiNbO_3$ layer, said Z-axis being set along a normal direction of an exposed surface of said $LiNbO_3$ layer, said X-axis being set along the propagation direction of the surface acoustic wave; and $kh_1$, $\theta$, $\psi$ defining an orthogonal coordinate system $(kh_1,\theta,\psi)$; wherein

the wavelength $\lambda$ [μm] and the thickness $t_1$ [μm] and crystal orientation of the $LiNbO_3$ layer are chosen such that the values $\phi$, $kh_1$, $\theta$, and $\psi$ are selected from:

$15 \leq \phi \leq 30$ and an internal region of a hexahedron in said orthogonal coordinate system $(kh_1,\theta,\psi)$ defined by $kh_1$, $\theta$, $\psi$, said hexahedron having as its opposing bottom surfaces, a planar rectangular region with its vertexes at points $A_{71}$, $B_{71}$, $C_{71}$, and $D_{71}$ and a planar rectangular region with its vertexes at points $A_{72}$, $B_{72}$, $C_{72}$, and $D_{72}$, where

point $A_{71} = (0.85,50,160)$
point $B_{71} = (0.85,100,160)$
point $C_{71} = (0.85,90,170)$
point $D_{71} = (0.85,50,170)$
point $A_{72} = (1.1,40,150)$
point $B_{72} = (1.1,140,150)$
point $C_{72} = (1.1,140,180)$
point $D_{72} = (1.1,40,180)$.

14. A device according to claim 13, wherein said diamond is a diamond layer formed on a base material, and when a thickness of said diamond layer is $t_2$ [μm], and $kh_2 = 2\pi t_2/\lambda$, the following relation is satisfied: $kh_2 \geq 4$.

**Patentansprüche**

1. Oberflächenwellenbauelement, welches aufweist:

einen Diamanten,

eine auf dem Diamanten vorgesehene Kurzschlußdiode;

eine einkristalline $LiNbO_3$-Schicht, die auf der Kurzschlußelektode vorgesehen ist, wobei die

einkristalline $LiNbO_3$-Schicht eine Dicke $t_1$ [μm] aufweist; und

einen auf der $LiNbO_3$-Schicht vorgesehenen Interdigitalwandler;

wobei das Oberflächenwellenbauelement eine akustische Oberflächenwelle mit einer Wellenlänge $\lambda$ [μm] in der Mode der ersten Ordnung verwendet;

ein Parameter $kh_1$ definiert ist als $kh_1 = 2\pi t_1/\lambda$; und

Winkel $\theta[°]$, $\phi[°]$, $\psi[°]$ so definiert sind, dass sie eine Darstellung in Eulerschen Winkeln $(\theta,\phi,\psi)$ der Kristallorientierung auf einem orthogonalen Koordinatensystem $(X,Y,Z)$ mit Achsen X, Y, Z in Bezug auf ein kristallographisches Fundamentalkoordinatensystem $(x,y,z)$ mit Achsen x, y, z der $LiNbO_3$-Schicht bilden, wobei die Z-Achse entlang einer normalen Richtung einer freiliegenden Oberfläche der $LiNbO_3$-Schicht eingestellt ist, die X-Achse entlang der Ausbreitungsrichtung der akustischen Oberflächenwelle eingestellt ist; und $kh_1$, $\theta$, $\psi$ ein orthogonales Koordinatensystem $(kh_1,\theta,\psi)$ festlegen; wobei

die Wellenlänge $\lambda$ [μm] und die Dicke $t_1$ [μm] und die Kristallorientierung der $LiNbO_3$-Schicht so gewählt sind, dass die Werte $\phi$, $kh_1$, $\theta$ und $\psi$ ausgewählt sind aus:

$0 \leq \phi \leq 360$ und einem internen Bereich eines Hexaeders in dem orthogonalen Koordinatensystem $(kh_1,\theta,\psi)$, das durch $kh_1$, $\theta$, $\psi$ definiert ist, wobei das Hexaeder als seine entgegengesetzten Bodenoberflächen einen ebenen rechteckigen Bereich mit dessen Ecken an Punkten $A_{11}$, $B_{11}$, $C_{11}$ und $D_{11}$ und einen ebenen rechteckigen Bereich mit seinen Ekken an Punkten $A_{12}$, $B_{12}$, $C_{12}$ und $D_{12}$ aufweist, wobei

Punkt $A_{11} = (0,45, 80, 140)$
Punkt $B_{11} = (0,45, 100, 140)$
Punkt $C_{11} = (0,45, 100, 180)$
Punkt $D_{11} = (0,45, 80, 180)$
Punkt $A_{12} = (0,7, 70, 120)$
Punkt $B_{12} = (0,7, 110, 120)$
Punkt $C_{12} = (0,7, 110, 180)$
Punkt $D_{12} = (0,7, 60, 180)$, und

$0 \leq \phi \leq 360$ und einem internen Bereich eines Hexaeders in dem orthogonalen Koordinatensystem $(kh_1,\theta,\psi)$, das durch $kh_1$, $\theta$, $\psi$ definiert ist, wobei das Hexaeder als seine entgegengesetzten Bodenoberflächen einen ebenen rechteckigen Bereich mit dessen Ecken an Punkten $A_{13}$, $B_{13}$, $C_{13}$ und $D_{13}$ aufweist, sowie einen ebenen rechteckigen Bereich mit seinen Ecken an Punkten $A_{14}$, $B_{14}$, $C_{14}$ und $D_{14}$, wobei

Punkt $A_{13}$ = (0,45, 80, 0)
Punkt $B_{13}$ = (0,45, 90, 0)
Punkt $C_{13}$ = (0,45, 90, 10)
Punkt $D_{13}$ = (0,45, 80, 20)
Punkt $A_{14}$ = (0,7, 60, 0)
Punkt $B_{14}$ = (0,7, 110, 0)
Punkt $C_{14}$ = (0,7, 90, 40)
Punkt $D_{14}$ = (0,7, 80, 40).

2. Bauelement nach Anspruch 1, bei welchem der Diamant eine Diamantschicht ist, die auf einem Basismaterial vorgesehen ist, und bei welchem, wenn eine Dicke der Diamantschicht $t_2$ [μm] beträgt, und gilt: $kh_2 = 2\pi t_2/\lambda$, die folgende Beziehung erfüllt ist: $kh_2 \geq 4$.

3. Oberflächenwellenbauelement, welches aufweist:

einen Diamanten,

eine auf dem Diamanten vorgesehene Kurzschlußdiode;

eine einkristalline LiNbO$_3$-Schicht, die auf der Kurzschlußelektode vorgesehen ist, wobei die einkristalline LiNbO$_3$-Schicht eine Dicke $t_1$ [μm] aufweist; und

einen auf der LiNbO$_3$-Schicht vorgesehenen Interdigitalwandler;

wobei das Oberflächenwellenbauelement eine akustische Oberflächenwelle mit einer Wellenlänge $\lambda$ [μm] in der Mode der ersten Ordnung verwendet;

ein Parameter $kh_1$ definiert ist als $kh_1 = 2\pi t_1/\lambda$; und

Winkel $\theta[°]$, $\phi[°]$, $\psi[°]$ so definiert sind, dass sie eine Darstellung in Eulerschen Winkeln $(\theta,\phi,\psi)$ der Kristallorientierung auf einem orthogonalen Koordinatensystem (X,Y,Z) mit Achsen X, Y, Z in Bezug auf ein kristallographisches Fundamentalkoordinatensystem (x,y,z) mit Achsen x, y, z der LiNbO$_3$-Schicht bilden, wobei die Z-Achse entlang einer normalen Richtung einer freiliegenden Oberfläche der LiNbO$_3$-Schicht eingestellt ist, die X-Achse entlang der Ausbreitungsrichtung der akustischen Oberflächenwelle eingestellt ist; und $kh_1$, $\theta$, $\psi$ ein orthogonales Koordinatensystem $(kh_1,\theta,\psi)$ festlegen; wobei

die Wellenlänge $\lambda$ [μm] und die Dicke $t_1$ [μm] und die Kristallorientierung der LiNbO$_3$-Schicht so gewählt sind, dass die Werte $\phi$, $kh_1$, $\theta$ und $\psi$ ausgewählt sind aus:

$0 \leq \phi \leq 15$ und einem internen Bereich eines Hexaeders in dem orthogonalen Koordinatensystem $(kh_1,\theta,\psi)$, das durch $kh_1$, $\theta$, $\psi$ definiert ist, wobei das Hexaeder als seine entgegengesetzten Bodenoberflächen einen ebenen rechteckigen Bereich mit dessen Ecken an Punkten $A_{21}$, $B_{21}$, $C_{21}$ und $D_{21}$ aufweist sowie einen ebenen rechteckigen Bereich mit seinen Ecken an Punkten $A_{22}$, $B_{22}$, $C_{22}$ und $D_{22}$ aufweist, wobei

Punkt $A_{21}$ = (0,6, 60, 40)
Punkt $B_{21}$ = (0,6, 110, 40)
Punkt $C_{21}$ = (0,6, 110, 120)
Punkt $D_{21}$ = (0,6, 60, 120)
Punkt $A_{22}$ = (0,85, 50, 70)
Punkt $B_{22}$ = (0,85, 130, 0)
Punkt $C_{22}$ = (0,85, 130, 180)
Punkt $D_{22}$ = (0,85, 50, 100),

$0 \leq \phi \leq 15$ und einem internen Bereich eines Hexaeders in dem orthogonalen Koordinatensystem $(kh_1,\theta,\psi)$, der durch $kh_1$, $\theta$, $\psi$ definiert ist, wobei das Hexaeder als seine entgegengesetzten Bodenoberflächen einen ebenen rechteckigen Bereich mit dessen Ecken an den Punkten $A_{22}$, $B_{22}$, $C_{22}$ und $D_{22}$ und einen ebenen rechteckigen Bereich mit seinen Ecken an Punkten $A_{23}$, $B_{23}$, $C_{23}$ und $D_{23}$ aufweist, wobei

Punkt $A_{23}$ = (1,1, 40, 60)
Punkt $B_{23}$ = (1,1, 140, 0)
Punkt $C_{23}$ = (1,1, 140, 180)
Punkt $D_{23}$ = (1,1, 40, 110);

$0 \leq \phi \leq 30$ und einem externen Bereich eines Hexaeders in dem orthogonalen Koordinatensystem $(kh_1,\theta,\psi)$, der durch $kh_1$, $\theta$, $\psi$ definiert ist, wobei das Hexaeder als seine entgegengesetzten Bodenoberflächen einen ebenen rechteckigen Bereich mit dessen Ecken an Punkten $A_{24}$, $B_{24}$, $C_{24}$ und $D_{24}$ sowie einen ebenen rechteckigen Bereich mit seinen Ecken an Punkten $A_{25}$, $B_{25}$, $C_{25}$ und $D_{25}$, wobei

Punkt $A_{24}$ = (0,6, 60, 30)
Punkt $B_{24}$ = (0,6, 120, 30)

Punkt $C_{24}$ = (0,6, 120, 100)
Punkt $D_{24}$ = (0,6, 60, 100)
Punkt $A_{25}$ = (0,85, 50, 30)
Punkt $B_{25}$ = (0,85, 130, 30)
Punkt $C_{25}$ = (0,85, 130, 110)
Punkt $D_{25}$ = (0,85, 50, 110), und

$0 \le \phi \le 30$ und einem internen Bereich eines Hexaeders in dem orthogonalen Koordinatensystem $(kh_1, \theta, \psi)$, der durch $kh_1$, $\theta$, $\psi$ definiert ist, wobei das Hexaeder als seine entgegengesetzten Bodenoberflächen einen ebenen rechteckigen Bereich mit seinen Ecken an den Punkten $A_{25}$, $B_{25}$, $C_{25}$ und $D_{25}$ aufweist, sowie einen ebenen rechteckigen Bereich mit seinen Ecken an Punkten $A_{26}$, $B_{26}$, $C_{26}$ und $D_{26}$, wobei

Punkt $A_{26}$ = (1,1, 40, 30)
Punkt $B_{26}$ = (1,1, 140, 30)
Punkt $C_{26}$ = (1,1, 140, 120)
Punkt $D_{26}$ = (1,1, 40, 120).

4. Bauelement nach Anspruch 3, bei welchem der Diamant eine Diamantschicht ist, die auf einem Basismaterial vorgesehen ist, und dann, wenn eine Dicke der Diamantschicht gleich $t_2$ [µm] ist, und gilt: $kh_2 = 2\pi t_2/\lambda$, die folgende Beziehung erfüllt ist: $kh_2 \ge 4$.

5. Oberflächenwellenbauelement, welches aufweist:

einen Diamanten,

einen auf dem Diamanten vorgesehenen Interdigitalwandler;

eine einkristalline $LiNbO_3$-Schicht, die auf dem Interdigitalwandler vorgesehen ist, wobei die einkristalline $LiNbO_3$-Schicht eine Dicke $t_1$ [µm] aufweist; und

eine auf der $LiNbO_3$-Schicht vorgesehenen Kurzschlußelektrode;

wobei das Oberflächenwellenbauelement eine akustische Oberflächenwelle mit einer Wellenlänge $\lambda$ [µm] in der Mode erster Ordnung verwendet;

ein Parameter $kh_1$ definiert ist durch $kh_1 = 2\pi t_1/\lambda$; und

Winkel $\theta[°]$, $\phi[°]$, $\psi[°]$ so definiert sind, dass sie eine Darstellung $(\theta, \phi, \psi)$ in Eulerschen Winkeln der Kristallorientierung auf einem orthogonalen Koordinatensystem $(X, Y, Z)$ mit Achsen X, Y, Z in Bezug auf ein kristallographisches Fundamentalkoordinatensystem $(x, y, z)$ mit Achsen x,

y, z der $LiNbO_3$-Schicht bilden, wobei die Z-Achse entlang einer normalen Richtung einer freiliegenden Oberfläche der $LiNbO_3$-Schicht eingestellt ist, die X-Achse entlang der Ausbreitungsrichtung der akustischen Oberflächenwelle eingestellt ist; und $kh_1$, $\theta$, $\psi$ ein orthogonales Koordinatensystem $(kh_1, \theta, \psi)$ definieren; wobei

die Wellenlänge $\lambda$ [µm] und die Dicke $t_1$ [µm] und die Kristallorientierung der $LiNbO_3$-Schicht so gewählt sind, dass die Werte $\phi$, $kh_1$, $\theta$ und $\psi$ ausgewählt sind aus:

$0 \le \phi \le 15$ und einem internen Bereich einer vierseitigen Pyramide in dem orthogonalen Koordinatensystem $(kh_1, \theta, \psi)$, das durch $kh_1$, $\theta$, $\psi$ definiert ist, wobei die vierseitige Pyramide ihre Ecke an einem Punkt $P_{31}$ und als ihre Bodenoberfläche einen ebenen rechteckigen Bereich mit seinen Ecken an Punkten $A_{31}$, $B_{31}$, $C_{31}$ und $D_{31}$ aufweist, wobei

Punkt $P_{31}$ = (0,45, 90, 150)
Punkt $A_{31}$ = (0,7, 70, 130)
Punkt $B_{31}$ = (0,7, 90, 130)
Punkt $C_{31}$ = (0,7, 90, 180)
Punkt $D_{31}$ = (0,7, 70, 180), und

$0 \le \phi \le 15$ und einem internen Bereich eines Hexaeders in dem orthogonalen Koordinatensystem $(kh_1, \theta, \psi)$, das durch $kh_1$, $\theta$, $\psi$ definiert ist, wobei das Hexaeder als seine entgegengesetzten Bodenoberflächen einen ebenen rechteckigen Bereich mit seinen Ecken an Punkten $A_{32}$, $B_{32}$, $C_{32}$ and $D_{32}$ aufweist, und einen ebenen rechteckigen Bereich mit seinen Ecken an Punkten $A_{33}$, $B_{33}$, $C_{33}$ und $D_{33}$, wobei

Punkt $A_{32}$ = (0,45, 80, 130)
Punkt $B_{32}$ = (0,45, 100, 130)
Punkt $C_{32}$ = (0,45, 100, 150)
Punkt $D_{32}$ = (0,45, 80, 150)
Punkt $A_{33}$ = (0,7, 70, 120)
Punkt $B_{33}$ = (0,7, 110, 120)
Punkt $C_{33}$ = (0,7, 110, 160)
Punkt $D_{33}$ = (0,7, 70, 160).

6. Bauelement nach Anspruch 5, bei welchem der Diamant eine Diamantschicht ist, die auf einem Basismaterial vorgesehen ist, und dann, wenn eine Dicke der Diamantschicht gleich $t_2$ [µm] beträgt, und gilt: $kh_2 = 2\pi t_2/\lambda$, folgende Beziehung erfüllt ist: $kh_2 \ge 4$.

7. Oberflächenwellenbauelement, welches aufweist:

einen Diamanten,

einen auf dem Diamanten vorgesehenen Interdigitalwandler;

eine einkristalline $LiNbO_3$-Schicht, die auf dem Interdigitalwandler vorgesehen ist, wobei die einkristalline $LiNbO_3$-Schicht eine Dicke $t_1$ [µm] aufweist; und

eine auf der $LiNbO_3$-Schicht vorgesehenen Kurzschlußelektrode;

wobei das Oberflächenwellenbauelement eine akustische Oberflächenwelle mit einer Wellenlänge $\lambda$ [µm] in der Mode zweiter Ordnung verwendet;

ein Parameter $kh_1$ definiert ist durch $kh_1 = 2\pi t_1/\lambda$; und

Winkel $\theta[°]$, $\phi[°]$, $\psi[°]$ so definiert sind, dass sie eine Darstellung $(\theta,\phi,\psi)$ in Eulerschen Winkeln der Kristallorientierung auf einem orthogonalen Koordinatensystem (X,Y,Z) mit Achsen X, Y, Z in Bezug auf ein kristallographisches Fundamentalkoordinatensystem (x,y,z) mit Achsen x, y, z der $LiNbO_3$-Schicht bilden, wobei die Z-Achse entlang einer normalen Richtung einer freiliegenden Oberfläche der $LiNbO_3$-Schicht eingestellt ist, die X-Achse entlang der Ausbreitungsrichtung der akustischen Oberflächenwelle eingestellt ist; und $kh_1$, $\theta$, $\psi$ ein orthogonales Koordinatensystem $(kh_1,\theta,\psi)$ definieren; wobei

die Wellenlänge $\lambda$ [µm] und die Dicke $t_1$ [µm] und die Kristallorientierung der $LiNbO_3$-Schicht so gewählt sind, dass die Werte $\phi$, $kh_1$, $\theta$ und $\psi$ ausgewählt sind aus:

$0 \leq \phi \leq 15$ und einem internen Bereich eines Hexaeders in dem orthogonalen Koordinatensystem $(kh_1,\theta,\psi)$, das durch $kh_1$, $\theta$, $\psi$ definiert ist, wobei das Hexaeder an seinen entgegengesetzten Bodenoberflächen einen ebenen rechteckigen Bereich mit seinen Ecken an Punkten $A_{41}$, $B_{41}$, $C_{41}$ und $D_{41}$ und einen ebenen rechteckigen Bereich mit seinen Ekken an Punkten $A_{42}$, $B_{42}$, $C_{42}$ und $D_{42}$ aufweist. wobei

    Punkt $A_{41}$ = (0,6, 70, 40)
    Punkt $B_{41}$ = (0,6, 100, 40)
    Punkt $C_{41}$ = (0,6, 100, 110)
    Punkt $D_{41}$ = (0,6, 70, 100)
    Punkt $A_{42}$ = (0,85, 70, 60)
    Punkt $B_{42}$ = (0,85, 120, 0)

    Punkt $C_{42}$ = (0,85, 120, 180)
    Punkt $D_{42}$ = (0,85, 70, 100),

$0 \leq \phi \leq 15$ und einem internen Bereich eines Hexaeders in dem orthogonalen Koordinatensystem $(kh_1,\theta,\psi)$, das durch $kh_1$, $\theta$, $\psi$ definiert wird, wobei das Hexaeder als seine entgegengesetzten Bodenoberflächen einen ebenen rechteckigen Bereich mit seinen Ecken an den Punkten $A_{42}$, $B_{42}$, $C_{42}$ und $D_{42}$ aufweist, und einen ebenen rechteckigen Bereich mit seinen Ecken an Punkten $A_{43}$, $B_{43}$, $C_{43}$ und $D_{43}$, wobei

    Punkt $A_{43}$ = (1,1, 90, 0)
    Punkt $B_{43}$ = (1,1, 130, 0)
    Punkt $C_{43}$ = (1,1, 130, 180)
    Punkt $D_{43}$ = (1,1, 90, 180),

$0 \leq \phi \leq 30$ und einem internen Bereich eines Hexaeders in dem orthogonalen Koordinatensystem $(kh_1,\theta,\psi)$, das durch $kh_1$, $\theta$, $\psi$ definiert wird, wobei das Hexaeder als seine entgegengesetzten Bodenoberflächen einen ebenen rechteckigen Bereich mit seinen Ecken an Punkten $A_{44}$, $B_{44}$, $C_{44}$ und $D_{44}$ aufweist, und einen ebenen rechteckigen Bereich mit seinen Ecken an Punkten $A_{45}$, $B_{45}$, $C_{45}$ und $D_{45}$, wobei

    Punkt $A_{44}$ = (0,6, 70, 20)
    Punkt $B_{44}$ = (0,6, 110, 20)
    Punkt $C_{44}$ = (0,6, 100, 90)
    Punkt $D_{44}$ = (0,6, 70, 90)
    Punkt $A_{45}$ = (0,85, 60, 10)
    Punkt $B_{45}$ = (0,85, 120, 10)
    Punkt $C_{45}$ = (0,85, 120, 90)
    Punkt $D_{45}$ = (0,85, 60, 90), und

$0 \leq \phi \leq 30$ und einem internen Bereich eines Hexaeders in dem orthogonalen Koordinatensystem $(kh_1,\theta,\psi)$, das durch $kh_1$, $\theta$, $\psi$ definiert ist, wobei das Hexaeder als seine entgegengesetzten Bodenoberflächen einen ebenen rechteckigen Bereich mit seinen Ecken an den Punkten $A_{45}$, $B_{45}$, $C_{45}$ und $D_{45}$ und einen ebenen rechteckigen Bereich mit seinen Ecken an Punkten $A_{46}$, $B_{46}$, $C_{46}$ und $D_{46}$ aufweist, wobei

    Punkt $A_{46}$ = (1,1, 80, 10)
    Punkt $B_{46}$ = (1,1, 120, 10)
    Punkt $C_{46}$ = (1,1, 130, 80)
    Punkt $D_{46}$ = (1,1, 50, 80).

**8.** Bauelement nach Anspruch 7, bei welchem der Diamant eine Diamantschicht ist, die auf einem Basismaterial vorgesehen ist, und dann, wenn eine Dicke

der Diamantschicht gleich $t_2$ [μm] beträgt, und gilt: $kh_2 = 2\pi t_2/\lambda$, folgende Beziehung erfüllt ist: $kh_2 \geq 4$.

9. Oberflächenwellenbauelement, welches aufweist:

   einen Diamanten,

   eine einkristalline LiNbO$_3$-Schicht auf dem Diamanten, wobei die einkristalline LiNbO$_3$-Schicht eine Dicke $t_1$ [μm] aufweist; und

   einen auf der LiNbO$_3$-Schicht vorgesehenen Interdigitalwandler;

   wobei das Oberflächenwellenbauelement eine akustische Oberflächenwelle mit einer Wellenlänge λ [μm] in der Mode erster Ordnung verwendet;

   ein Parameter $kh_1$ definiert ist durch $kh_1 = 2\pi t_1/\lambda$; und

   Winkel θ[°], φ[°], ψ[°] so definiert sind, dass sie eine Darstellung (θ,φ,ψ) in Eulerschen Winkeln der Kristallorientierung auf einem orthogonalen Koordinatensystem (X,Y,Z) mit Achsen X, Y, Z in Bezug auf ein kristallographisches Fundamentalkoordinatensystem (x,y,z) mit Achsen x, y, z der LiNbO$_3$-Schicht bilden, wobei die Z-Achse entlang einer normalen Richtung einer freiliegenden Oberfläche der LiNbO$_3$-Schicht eingestellt ist, die X-Achse entlang der Ausbreitungsrichtung der akustischen Oberflächenwelle eingestellt ist; und $kh_1$, θ, ψ ein orthogonales Koordinatensystem ($kh_1$,θ,ψ) definieren; wobei

   die Wellenlänge λ [μm] und die Dicke $t_1$ [μm] und die Kristallorientierung der LiNbO$_3$-Schicht so gewählt sind, dass die Werte φ, $kh_1$, θ und ψ ausgewählt sind aus:

   $0 \leq \phi \leq 360$ und einem internen Bereich einer vierseitigen Pyramide in dem orthogonalen Koordinatensystem ($kh_1$,θ,ψ), das durch $kh_1$, θ, ψ definiert ist, wobei die vierseitige Pyramide ihre Ecke an einem Punkt $P_{51}$ und als ihre Bodenoberfläche einen ebenen rechteckigen Bereich mit seinen Ecken an Punkten $A_{51}$, $B_{51}$, $C_{51}$ und $D_{51}$ aufweist, wobei

   Punkt $P_{51}$ = (0,6, 90, 0)
   Punkt $A_{51}$ = (0,7, 80, 0)
   Punkt $B_{51}$ = (0,7, 110, 0)
   Punkt $C_{51}$ = (0,7, 110, 10)
   Punkt $D_{51}$ = (0,7, 80, 10), und

$0 \leq \phi \leq 360$ und einem internen Bereich einer vierseitigen Pyramide in dem orthogonalen Koordinatensystem ($kh_1$,θ,ψ), das durch $kh_1$, θ, ψ definiert ist, wobei die vierseitige Pyramide ihre Ecke an einem Punkt $P_{52}$ und als ihre Bodenoberfläche einen ebenen rechteckigen Bereich mit seinen Ecken an Punkten $A_{52}$, $B_{52}$, $C_{52}$ und $D_{52}$ aufweist, wobei

   Punkt $P_{52}$ = (0,6, 100, 0)
   Punkt $A_{52}$ = (0,7, 90, 170)
   Punkt $B_{52}$ = (0,7, 100, 170)
   Punkt $C_{52}$ = (0,7, 110, 180)
   Punkt $D_{52}$ = (0,7, 80, 180).

10. Bauelement nach Anspruch 9, bei welchem der Diamant eine Diamantschicht ist, die auf einem Basismaterial vorgesehen ist, und dann, wenn eine Dicke der Diamantschicht gleich $t_2$ [μm] beträgt, und gilt: $kh_2 = 2\pi t_2/\lambda$, folgende Beziehung erfüllt ist: $kh_2 \geq 4$.

11. Oberflächenwellenbauelement, welches aufweist:

   einen Diamanten,

   eine einkristalline LiNbO$_3$-Schicht auf dem Diamanten, wobei die einkristalline LiNbO$_3$-Schicht eine Dicke $t_1$ [μm] aufweist; und

   einen auf der LiNbO$_3$-Schicht vorgesehenen Interdigitalwandler;

   wobei das Oberflächenwellenbauelement eine akustische Oberflächenwelle mit einer Wellenlänge λ [μm] in der Mode zweiter Ordnung verwendet;

   ein Parameter $kh_1$ definiert ist durch $kh_1 = 2\pi t_1/\lambda$; und

   Winkel θ[°], φ[°], ψ[°] so definiert sind, dass sie eine Darstellung (θ,φ,ψ) in Eulerschen Winkeln der Kristallorientierung auf einem orthogonalen Koordinatensystem (X,Y,Z) mit Achsen X, Y, Z in Bezug auf ein kristallographisches Fundamentalkoordinatensystem (x,y,z) mit Achsen x, y, z der LiNbO$_3$-Schicht bilden, wobei die Z-Achse entlang einer normalen Richtung einer freiliegenden Oberfläche der LiNbO$_3$-Schicht eingestellt ist, die X-Achse entlang der Ausbreitungsrichtung der akustischen Oberflächenwelle eingestellt ist; und $kh_1$, θ, ψ ein orthogonales Koordinatensystem ($kh_1$,θ,ψ) definieren; wobei

   die Wellenlänge λ [μm] und die Dicke $t_1$ [μm] und die Kristallorientierung der LiNbO$_3$-Schicht

so gewählt sind, dass die Werte φ, kh$_1$, θ und ψ ausgewählt sind aus:

0 ≤ φ ≤ 15 und einem internen Bereich eines Hexaeders in dem orthogonalen Koordinatensystem (kh$_1$,θ,ψ), das durch kh$_1$, θ, ψ definiert ist, wobei das Hexaeder als seine entgegengesetzten Bodenoberflächen einen ebenen rechteckigen Bereich mit seinen Ecken an Punkten A$_{61}$, B$_{61}$, C$_{61}$ und D$_{61}$ und einen ebenen rechteckigen Bereich mit seinen Ekken an Punkten A$_{62}$, B$_{62}$, C$_{62}$ und D$_{62}$ aufweist, wobei

Punkt A$_{61}$ = (0,85, 140, 40)
Punkt B$_{61}$ = (0,85, 160, 40)
Punkt C$_{61}$ = (0,85, 160, 60)
Punkt D$_{61}$ = (0,85, 140, 60)
Punkt A$_{62}$ = (1,1, 120, 30)
Punkt B$_{62}$ = (1,1, 170, 30)
Punkt C$_{62}$ = (1,1, 170, 70)
Punkt D$_{62}$ = (1,1, 120, 70),

0 ≤ φ ≤ 15 und einem internen Bereich eines Hexaeders in dem orthogonalen Koordinatensystem (kh$_1$,θ,ψ), das durch kh$_1$, θ, ψ definiert ist, wobei das Hexaeder als seine entgegengesetzten Bodenoberflächen einen ebenen rechteckigen Bereich mit seinen Ecken an Punkten A$_{63}$, B$_{63}$, C$_{63}$ und D$_{63}$ und einen ebenen rechteckigen Bereich mit seinen Ekken an Punkten A$_{64}$, B$_{64}$, C$_{64}$ und D$_{64}$ aufweist, wobei

Punkt A$_{63}$ = (0,85, 130, 130)
Punkt B$_{63}$ = (0,85, 160, 130)
Punkt C$_{63}$ = (0,85, 160, 150)
Punkt D$_{63}$ = (0,85, 130, 150)
Punkt A$_{64}$ = (1,1, 100, 140)
Punkt B$_{64}$ = (1,1, 140, 100)
Punkt C$_{64}$ = (1,1, 160, 160)
Punkt D$_{64}$ = (1,1, 130, 160),

0 ≤ φ ≤ 15 und einem internen Bereich einer vierseitigen Pyramide in dem orthogonalen Koordinatensystem (kh$_1$,θ,ψ), das durch kh$_1$, θ, ψ definiert ist, wobei die vierseitige Pyramide ihre Ecke an einem Punkt P$_{65}$ und als ihre Bodenoberfläche einen ebenen rechteckigen Bereich mit seinen Ekken an Punkten A$_{65}$, B$_{65}$, C$_{65}$ und D$_{65}$ aufweist, wobei

Punkt P$_{65}$ = (0,85, 30, 90)
Punkt A$_{65}$ = (1,1, 20, 70)
Punkt B$_{65}$ = (1,1, 40, 70)
Punkt C$_{65}$ = (1,1, 40, 110)
Punkt D$_{65}$ = (1,1, 20, 110),

15 ≤ φ ≤ 30 und einem internen Bereich eines Hexaeders in dem orthogonalen Koordinatensystem (kh$_1$,θ,ψ), das durch kh$_1$, θ, ψ definiert ist, wobei das Hexaeder als seine entgegengesetzten Bodenoberflächen einen ebenen rechteckigen Bereich mit seinen Ecken an Punkten A$_{66}$, B$_{66}$, C$_{66}$ und D$_{66}$ und einen ebenen rechteckigen Bereich mit seinen Ekken an Punkten A$_{67}$, B$_{67}$, C$_{67}$ und D$_{67}$ aufweist, wobei

Punkt A$_{66}$ = (0,6, 20, 150)
Punkt B$_{66}$ = (0,6, 40, 150)
Punkt C$_{66}$ = (0,6, 40, 170)
Punkt D$_{66}$ = (0,6, 20, 170)
Punkt A$_{67}$ = (0,85, 50, 130)
Punkt B$_{67}$ = (0,85, 70, 140)
Punkt C$_{67}$ = (0,85, 50, 160)
Punkt D$_{67}$ = (0,85,20,160),

15 ≤ φ ≤ 30 und einem internen Bereich eines Hexaeders in dem orthogonalen Koordinatensystem (kh$_1$,θ,ψ), das durch kh$_1$, θ, ψ definiert ist, wobei das Hexaeder als seine entgegengesetzten Bodenoberflächen einen ebenen rechteckigen Bereich mit seinen Ecken an Punkten A$_{67}$, B$_{67}$, C$_{67}$ und D$_{67}$ und einen ebenen rechteckigen Bereich mit seinen Ekken an Punkten A$_{68}$, B$_{68}$, C$_{68}$ und D$_{68}$ aufweist, wobei

Punkt A$_{68}$ = (1,1, 40, 120)
Punkt B$_{68}$ = (1,1, 90, 120)
Punkt C$_{68}$ = (1,1, 90, 160)
Punkt D$_{68}$ = (1,1, 40, 160),

15 ≤ φ ≤ 30 und einem internen Bereich eines Hexaeders in dem orthogonalen Koordinatensystem (kh$_1$,θ,ψ), das durch kh$_1$, θ, ψ definiert wird, wobei das Hexaeder als seine entgegengesetzten Bodenoberflächen einen ebenen rechteckigen Bereich mit seinen Ecken an Punkten A$_{69}$, B$_{69}$, C$_{69}$ und D$_{69}$ und einen ebenen rechteckigen Bereich mit seinen Ekken an Punkten A$_{6A}$, B$_{6A}$, C$_{6A}$ und D$_{6A}$ aufweist, wobei

Punkt A$_{69}$ = (0,6, 140, 150)
Punkt B$_{69}$ = (0,6, 160, 150)
Punkt C$_{69}$ = (0,6, 160, 160)
Punkt D$_{69}$ = (0,6, 140, 160)
Punkt A$_{6A}$ = (0,85, 100, 140)
Punkt B$_{6A}$ = (0,85, 130, 130)
Punkt C$_{6A}$ = (0,85, 160, 160)
Punkt D$_{6A}$ = (0,85, 130, 160),

15 ≤ φ ≤ 30 und einem internen Bereich eines Hexaeders in dem orthogonalen Koor-

dinatensystem ($kh_1,\theta,\psi$), das durch $kh_1$, $\theta$, $\psi$ definiert ist, wobei das Hexaeder als seine entgegengesetzten Bodenoberflächen einen ebenen rechteckigen Bereich mit seinen Ecken an Punkten $A_{6A}$, $B_{6A}$, $C_{6A}$ und $D_{6A}$ und einen ebenen rechteckigen Bereich mit seinen Ecken an Punkten $A_{6B}$, $B_{6B}$, $C_{6B}$ und $D_{6B}$ aufweist, wobei

> Punkt $A_{6B}$ = (1,1, 100, 120)
> Punkt $B_{6B}$ = (1,1, 150, 120)
> Punkt $C_{6B}$ = (1,1, 150, 160)
> Punkt $D_{6B}$ = (1,1, 100, 160)

$15 \leq \phi \leq 30$ und einem internen Bereich eines Hexaeders in dem orthogonalen Koordinatensystem ($kh_1,\theta,\psi$), das durch $kh_1$, $\theta$, $\psi$ definiert ist, wobei das Hexaeder als seine entgegengesetzten Bodenoberflächen einen ebenen rechteckigen Bereich mit seinen Ecken an Punkten $A_{6C}$ $B_{6C}$, $C_{6C}$ und $D_{6C}$ und einen ebenen rechteckigen Bereich mit seinen Ecken an Punkten $A_{6D}$, $B_{6D}$, $C_{6D}$ und $D_{6D}$ aufweist, wobei

> Punkt $A_{6C}$ = (0,85, 150, 50)
> Punkt $B_{6C}$ = (0,85, 160, 50)
> Punkt $C_{6C}$ = (0,85, 160, 60)
> Punkt $D_{6C}$ = (0,85, 150, 60)
> Punkt $A_{6D}$ = (1,1, 130, 40)
> Punkt $B_{6D}$ = (0,1, 160, 40)
> Punkt $C_{6D}$ = (0,1, 160, 90)
> Punkt $D_{6D}$ = (0,1, 130, 90), und

$15 \leq \phi \leq 30$ und einem internen Bereich einer vierseitigen Pyramide in dem orthogonalen Koordinatensystem ($kh_1,\theta,\psi$), das durch $kh_1$, $\theta$, $\psi$ definiert wird, wobei die vierseitige Pyramide ihre Ecke an einem Punkt $P_{6E}$ und als ihre Bodenoberfläche einen ebenen rechteckigen Bereich mit seinen Ekken an Punkten $A_{6E}$, $B_{6E}$, $C_{6E}$ und $D_{6E}$ aufweist, wobei

> Punkt $P_{6E}$ = (0,85, 30, 70)
> Punkt $A_{6E}$ = (1,1,20,50)
> Punkt $B_{6E}$ = (1,1, 40, 50)
> Punkt $C_{6E}$ = (1,1, 40, 90)
> Punkt $D_{6E}$ = (1,1, 20, 90).

**12.** Bauelement nach Anspruch 11, bei welchem der Diamant eine Diamantschicht ist, die auf einem Basismaterial vorgesehen ist, und dann, wenn eine Dicke der Diamantschicht $t_2$ [μm] beträgt, und gilt: $kh_2 = 2\pi t_2/\lambda$, folgende Beziehung erfüllt ist: $kh_2 \geq 4$.

**13.** Oberflächenwellenbauelement, welches aufweist:

einen Diamanten,

einen auf dem Diamanten vorgesehenen Interdigitalwandler; und

eine einkristalline $LiNbO_3$-Schicht auf dem Interdigitalwandler, wobei die einkristalline $LiNbO_3$-Schicht eine Dicke $t_1$ [μm] aufweist; und

wobei das Oberflächenwellenbauelement eine akustische Oberflächenwelle mit einer Wellenlänge $\lambda$ [μm] in der Mode zweiter Ordnung verwendet;

ein Parameter $kh_1$ definiert ist durch $kh_1 = 2\pi t_1/\lambda$; und

Winkel $\theta[°]$, $\phi[°]$, $\psi[°]$ so definiert sind, dass sie eine Darstellung ($\theta,\phi,\psi$) in Eulerschen Winkeln der Kristallorientierung auf einem orthogonalen Koordinatensystem (X,Y,Z) mit Achsen X, Y, Z in Bezug auf ein kristallographisches Fundamentalkoordinatensystem (x,y,z) mit Achsen x, y, z der $LiNbO_3$-Schicht bilden, wobei die Z-Achse entlang einer normalen Richtung einer freiliegenden Oberfläche der $LiNbO_3$-Schicht eingestellt ist, die X-Achse entlang der Ausbreitungsrichtung der akustischen Oberflächenwelle eingestellt ist; und $kh_1$, $\theta$, $\psi$ ein orthogonales Koordinatensystem ($kh_1,\theta,\psi$) definieren; wobei

die Wellenlänge $\lambda$ [μm] und die Dicke $t_1$ [μm] und die Kristallorientierung der $LiNbO_3$-Schicht so gewählt sind, dass die Werte $\phi$, $kh_1$, $\theta$ und $\psi$ ausgewählt sind aus:

> $15 \leq \phi \leq 30$ und einem internen Bereich eines Hexaeders in dem orthogonalen Koordinatensystem ($kh_1,\theta,\psi$), das durch $kh_1$, $\theta$, $\psi$ definiert ist, wobei das Hexaeder als seine entgegengesetzten Bodenoberflächen einen ebenen rechteckigen Bereich mit seinen Ecken an Punkten $A_{71}$, $B_{71}$, $C_{71}$ und $D_{71}$ und einen ebenen rechteckigen Bereich mit seinen Ekken an Punkten $A_{72}$, $B_{72}$, $C_{72}$ und $D_{72}$ aufweist, wobei
>
> > Punkt $A_{71}$ = (0,85, 50, 160)
> > Punkt $B_{71}$ = (0,85, 100, 160)
> > Punkt $C_{71}$ = (0,85, 90, 170)
> > Punkt $D_{71}$ = (0,85, 50, 170)
> > Punkt $A_{72}$ = (1,1, 40, 150)
> > Punkt $B_{72}$ = (1,1, 140, 150)
> > Punkt $C_{72}$ = (1,1, 140, 180)
> > Punkt $D_{72}$ = (1,1, 40, 180).

**14.** Bauelement nach Anspruch 13, bei welchem der Diamant eine Diamantschicht ist, die auf einem Basismaterial vorgesehen ist, und dann, wenn eine Dicke der Diamantschicht $t_2$ [μm] beträgt, und gilt: $kh_2 = 2\pi t_2/\lambda$, folgende Beziehung erfüllt ist: $kh_2 \geq 4$.

## Revendications

**1.** Un dispositif à ondes acoustiques de surface comprenant :

un diamant,
une électrode en court-circuit formée sur ce diamant,
une couche de $LiNbO_3$ monocristallin formée sur l'électrode en court-circuit, cette couche de $LiNbO_3$ monocristallin ayant une épaisseur $t_1$ [μm]; et
un transducteur interdigité formé sur la couche de $LiNbO_3$;
ce dispositif à ondes acoustiques de surface utilisant une onde acoustique de surface avec une longueur d'onde $\lambda$ [μm] dans le mode du lier ordre;
un paramètre $kh_1$ étant défini par $kh_1 = 2 \pi t_1/\lambda$; et
des angles $\theta$ [°], $\phi$ [°], $\Psi$ [°] étant définis pour constituer une représentation par des angles d'Euler $(\theta, \phi, \Psi)$ de l'orientation cristalline dans un système de coordonnées orthogonal (X, Y, Z) avec des axes X, Y, Z, par rapport à un système de coordonnées cristallographique fondamental (x, y, z) avec des axes x, y, z de la couche de $LiNbO_3$, l'axe Z étant orienté selon une direction normale d'une surface à nu de la couche de $LiNbO_3$, l'axe X étant orienté selon la direction de propagation de l'onde acoustique de surface; et $kh_1, \theta, \Psi$ définissant un système de coordonnées orthogonal $(kh_1, \theta, \Psi)$; dans lequel
la longueur d'onde $\lambda$ [μm] et l'épaisseur $t_1$ [μm] et l'orientation cristalline de la couche de $LiNbO_3$ sont choisies de façon que les valeurs $\phi, kh_1, \theta$ et $\Psi$ soient sélectionnées parmi :

$0 \leq \phi \leq 360$ et une région interne d'un hexaèdre dans le système de coordonnées orthogonal $(kh_1, \theta, \Psi)$ défini par $kh_1$, $\theta, \Psi$, cet hexaèdre ayant pour ses surfaces de base en regard une région rectangulaire plane avec ses sommets à des points $A_{11}$, $B_{11}, C_{11}$ et $D_{11}$ et une région rectangulaire plane avec ses sommets à des points $A_{12}$, $B_{12}, C_{12}$ et $D_{12}$, avec

point $A_{11} = (0,45, 80, 140)$
point $B_{11} = (0,45, 100, 140)$
point $C_{11} = (0,45, 100, 180)$
point $D_{11} = (0,45, 80, 180)$
point $A_{12} = (0,7, 70, 120)$
point $B_{12} = (0,7, 110, 120)$
point $C_{12} = (0,7, 110, 180)$
point $D_{12} = (0,7, 60, 180)$, et

$0 \leq \phi \leq 360$ et une région interne d'un hexaèdre dans le système de coordonnées orthogonal $(kh_1, \theta, \Psi)$ défini par $kh_1$, $\theta, \Psi$, cet hexaèdre ayant pour ses surfaces de base en regard une région rectangulaire plane avec ses sommets à des points $A_{13}$, $B_{13}, C_{13}$ et $D_{13}$ et une région rectangulaire plane avec ses sommets à des points $A_{14}$, $B_{14}, C_{14}$ et $D_{14}$, avec

point $A_{13} = (0,45, 80, 0)$
point $B_{13} = (0,45, 90, 0)$
point $C_{13} = (0,45, 90, 10)$
point $D_{13} = (0,45, 80, 20)$
point $A_{14} = (0,7, 60, 0)$
point $B_{14} = (0,7, 110, 0)$
point $C_{14} = (0,7, 90, 40)$
point $D_{14} = (0,7, 80, 40)$

**2.** Un dispositif selon la revendication 1, dans lequel le diamant est une couche de diamant formée sur un matériau de base, et lorsqu'une épaisseur de la couche de diamant est $t_2$ [μm] et $kh_2 = 2 \pi t_2/\lambda$, on a la relation suivante : $kh_2 \geq 4$.

**3.** Un dispositif à ondes acoustiques de surface comprenant :

un diamant,
une électrode en court-circuit formée sur ce diamant,
une couche de $LiNbO_3$ monocristallin formée sur l'électrode en court-circuit, cette couche de $LiNbO_3$ monocristallin ayant une épaisseur $t_1$ [μm]; et
un transducteur interdigité formé sur la couche de $LiNbO_3$;
ce dispositif à ondes acoustiques de surface utilisant une onde acoustique de surface avec une longueur d'onde $\lambda$ [μm] dans le mode du 2-ième ordre;
un paramètre $kh_1$ étant défini par $kh_1 = 2 \pi t_1/\lambda$; et
des angles $\theta$ [°], $\phi$ [°], $\Psi$ [°] étant définis pour constituer une représentation par des angles d'Euler $(\theta, \phi, \Psi)$ de l'orientation cristalline dans un système de coordonnées orthogonal (X, Y, Z) avec des axes X, Y, Z, par rapport à un système de coordonnées cristallographique fondamental (x, y, z) avec des axes x, y, z de la couche de $LiNbO_3$, l'axe Z étant orienté selon une direction normale d'une surface à nu de la couche de $LiNbO_3$, l'axe X étant orienté selon la direction de propagation de l'onde acoustique de surface; et $kh_1$, $\theta$, $\Psi$ définissant un système de coordonnées orthogonal ($kh_1$, $\theta$, $\Psi$); dans lequel

la longueur d'onde $\lambda$ [μm] et l'épaisseur $t_1$ [μm] et l'orientation cristalline de la couche de $LiNbO_3$ sont choisies de façon que les valeurs $\phi$, $kh_1$, $\theta$ et $\Psi$ soient sélectionnées parmi :

$0 \leq \phi \leq 15$ et une région interne d'un hexaèdre dans le système de coordonnées orthogonal ($kh_1$, $\theta$, $\Psi$) défini par $kh_1$, $\theta$, $\psi$, cet hexaèdre ayant pour ses surfaces de base en regard une région rectangulaire plane avec ses sommets à des points $A_{21}$, $B_{21}$, $C_{21}$ et $D_{21}$ et une région rectangulaire plane avec ses sommets à des points $A_{22}$, $B_{22}$, $C_{22}$ et $D_{22}$, avec

point $A_{21}$ = (0,6, 60, 40)
point $B_{21}$ = (0,6, 110, 40)
point $C_{21}$ = (0,6, 110, 120)
point $D_{21}$ = (0,6, 60, 120)
point $A_{22}$ = (0,85, 50, 70)
point $B_{22}$ = (0,85, 130, 0)
point $C_{22}$ = (0,85, 130, 180)
point $D_{22}$ = (0,85, 50, 100), et

$0 \leq \phi \leq 15$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard une région rectangulaire plane avec ses sommets aux points $A_{22}$, $B_{22}$, $C_{22}$ et $D_{22}$ et une région rectangulaire plane avec ses sommets à des points $A_{23}$, $B_{23}$, $C_{23}$ et $D_{23}$, avec

point $A_{23}$ = (1,1, 40, 60)
point $B_{23}$ = (1,1, 140, 0)
point $C_{23}$ = (1,1, 140, 180)
point $D_{23}$ = (1,1, 40, 110);

$15 \leq \phi \leq 30$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard une région rectangulaire plane avec ses sommets à des points $A_{24}$, $B_{24}$, $C_{24}$ et $D_{24}$ et une région rectangulaire plane avec ses sommets à des points $A_{25}$, $B_{25}$, $C_{25}$ et $D_{25}$,

avec

point $A_{24}$ = (0,6, 60, 30)
point $B_{24}$ = (0,6, 120, 30)
point $C_{24}$ = (0,6, 120, 100)
point $D_{24}$ = (0,6, 60, 100)
point $A_{25}$ = (0,85, 50, 30)
point $B_{25}$ = (0,85, 130, 30)
point $C_{25}$ = (0,85, 130, 110)
point $D_{25}$ = (0,85, 50, 110); et

$15 \leq \phi \leq 30$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard une région rectangulaire plane avec ses sommets aux points $A_{25}$, $B_{25}$, $C_{25}$ et $D_{25}$ et une région rectangulaire plane avec ses sommets à des points $A_{26}$, $B_{26}$, $C_{26}$ et $D_{26}$,

avec point $A_{26}$ = (1,1, 40, 30)
point $B_{26}$ = (1,1, 140, 30)
point $C_{26}$ = (1,1,140, 120)
point $D_{26}$ = (1,1, 40, 120).

4. Un dispositif selon la revendication 3, dans lequel le diamant est une couche de diamant formée sur un matériau de base, et lorsqu'une épaisseur de la couche de diamant est $t_2$ [μm] et $kh_2$ = 2 $\pi$ $t_2/\lambda$, on a la relation suivante : $kh_2 \geq 4$.

5. Un dispositif à ondes acoustiques de surface comprenant :

un diamant;
un transducteur interdigité formé sur ce diamant;
une couche de $LiNbO_3$ monocristallin formée sur le transducteur interdigité, cette couche de $LiNbO_3$ monocristallin ayant une épaisseur $t_1$ [μm]; et
une électrode en court-circuit formée sur la couche de $LiNbO_3$;
ce dispositif à ondes acoustiques de surface utilisant une onde acoustique de surface avec une longueur d'onde $\lambda$ [μm] dans le mode du lier ordre;
un paramètre $kh_1$ étant défini par $kh_1$ = 2 $\pi$ $t_1/\lambda$; et
des angles $\theta$ [°], $\phi$ [°], $\Psi$ [°] étant définis pour constituer une représentation par des angles d'Euler ($\theta$, $\phi$, $\Psi$) de l'orientation cristalline dans un système de coordonnées orthogonal (X, Y, Z) avec des axes X, Y, Z, par rapport à un système de coordonnées cristallographique fondamental (x, y, z) avec des axes x, y, z de la couche de $LiNbO_3$, l'axe Z étant orienté selon une direction normale d'une surface à nu de la couche de $LiNbO_3$, l'axe X étant orienté selon la direction de propagation de l'onde acoustique de surface; et $kh_1$, $\theta$, $\Psi$ définissant un système de coordonnées orthogonal ($kh_1$, $\theta$, $\Psi$); dans lequel

la longueur d'onde $\lambda$ [µm] et l'épaisseur $t_1$ [µm] et l'orientation cristalline de la couche de $LiNbO_3$ sont choisies de façon que les valeurs $\phi$, $kh_1$, $\theta$ et $\Psi$ soient sélectionnées parmi :

$0 \leq \phi \leq 15$ et une région interne d'une pyramide quadrangulaire dans le système de coordonnées orthogonal ($kh_1$, $\theta$, $\Psi$) défini par $kh_1$, $\theta$, $\Psi$, cette pyramide quadrangulaire ayant son sommet à un point $P_{31}$ et, pour sa surface de base, une région rectangulaire plane avec ses sommets à des points $A_{31}$, $B_{31}$, $C_{31}$ et $D_{31}$, avec

point $P_{31} = (0{,}45, 90, 150)$
point $A_{31} = (0{,}7, 70, 130)$
point $B_{31} = (0{,}7, 90, 130)$
point $C_{31} = (0{,}7, 90, 180)$
point $D_{31} = (0{,}7, 70, 180)$, et

$0 \leq \phi \leq 15$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard, une région rectangulaire plane avec ses sommets à des points $A_{32}$, $B_{32}$, $C_{32}$ et $D_{32}$ et une région rectangulaire plane avec ses sommets à des points $A_{33}$, $B_{33}$, $C_{33}$ et $D_{33}$, avec

point $A_{32} = (0{,}45, 80, 130)$
point $B_{32} = (0{,}45, 100, 130)$
point $C_{32} = (0{,}45, 100, 150)$
point $D_{32} = (0{,}45, 80, 150)$
point $A_{33} = (0{,}7, 70, 120)$
point $B_{33} = (0{,}7, 110, 120)$
point $C_{33} = (0{,}7, 110, 160)$
point $D_{33} = (0{,}7, 70, 160)$.

6. Un dispositif selon la revendication 5, dans lequel le diamant est une couche de diamant formée sur un matériau de base, et lorsqu'une épaisseur de la couche de diamant est $t_2$ [µm] et $kh_2 = 2\pi t_2/\lambda$, on a la relation suivante : $kh_2 \geq 4$.

7. Un dispositif à ondes acoustiques de surface comprenant :

un diamant;
un transducteur interdigité formé sur ce dia-

mant;
une couche de $LiNbO_3$ monocristallin formée sur le transducteur interdigité, cette couche de $LiNbO_3$ monocristallin ayant une épaisseur $t_1$ [µm]; et
une électrode en court-circuit formée sur la couche de $LiNbO_3$;
ce dispositif à ondes acoustiques de surface utilisant une onde acoustique de surface avec une longueur d'onde $\lambda$ [µm] dans le mode du 2-ième ordre;
un paramètre $kh_1$ étant défini par $kh_1 = 2\pi t_1/\lambda$; et
des angles $\theta$ [°], $\phi$ [°], $\Psi$ [°] étant définis pour constituer une représentation par des angles d'Euler ($\theta$, $\phi$, $\Psi$) de l'orientation cristalline dans un système de coordonnées orthogonal (X, Y, Z) avec des axes X, Y, Z, par rapport à un système de coordonnées cristallographique fondamental (x, y, z) avec des axes x, y, z de la couche de $LiNbO_3$, l'axe Z étant orienté selon une direction normale d'une surface à nu de la couche de $LiNbO_3$, l'axe X étant orienté selon la direction de propagation de l'onde acoustique de surface; et $kh_1$, $\theta$, $\Psi$ définissant un système de coordonnées orthogonal ($kh_1$, $\theta$, $\Psi$); dans lequel

la longueur d'onde $\lambda$ [µm] et l'épaisseur $t_1$ [µm] et l'orientation cristalline de la couche de $LiNbO_3$ sont choisies de façon que les valeurs $\phi$, $kh_1$, $\theta$ et $\Psi$ soient sélectionnées parmi :

$0 \leq \phi \leq 15$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard, une région rectangulaire plane avec ses sommets à des points $A_{41}$, $B_{41}$, $C_{41}$ et $D_{41}$, et une région rectangulaire plane avec ses sommets à des points $A_{42}$, $B_{42}$, $C_{42}$ et $D_{42}$, avec

point $A_{41} = (0{,}6, 70, 40)$
point $B_{41} = (0{,}6, 100, 40)$
point $C_{41} = (0{,}6, 100, 110)$
point $D_{41} = (0{,}6, 70, 110)$
point $A_{42} = (0{,}85, 70, 60)$
point $B_{42} = (0{,}85, 120, 0)$
point $C_{42} = (0{,}85, 120, 180)$
point $D_{42} = (0{,}85, 70, 100)$,

$0 \leq \phi \leq 15$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard, une région rectangulaire plane avec ses sommets aux points $A_{42}$, $B_{42}$, $C_{42}$

et $D_{42}$, et une région rectangulaire plane avec ses sommets à des points $A_{43}$, $B_{43}$, $C_{43}$ et $D_{43}$,
avec

point $A_{43} = (1,1, 90, 0)$
point $B_{43} = (1,1, 130, 0)$
point $C_{43} = (1,1, 130, 180)$
point $D_{43} = (1,1, 130, 180)$

$15 \leq \phi \leq 30$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard une région rectangulaire plane avec ses sommets à des points $A_{44}$, $B_{44}$, $C_{44}$ et $D_{44}$ et une région rectangulaire plane avec ses sommets à des points $A_{45}$, $B_{45}$, $C_{45}$ et $D_{45}$,

avec point $A_{44} = (0,6, 70, 20)$
point $B_{44} = (0,6, 110, 20)$
point $C_{44} = (0,6, 100, 90)$
point $D_{44} = (0,6, 70, 90)$
point $A_{45} = (0,85, 60, 10)$
point $B_{45} = (0,85, 120, 10)$
point $C_{45} = (0,85, 120, 90)$
point $D_{45} = (0,85, 60, 90)$; et

$15 \leq \phi \leq 30$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard une région rectangulaire plane avec ses sommets aux points $A_{45}$, $B_{45}$, $C_{45}$ et $D_{45}$ et une région rectangulaire plane avec ses sommets à des points $A_{46}$, $B_{46}$, $C_{46}$ et $D_{46}$,
avec

point $A_{46} = (1,1, 80, 10)$
point $B_{46} = (1,1, 120, 10)$
point $C_{46} = (1,1, 130, 80)$
point $D_{46} = (1,1, 50, 80)$.

8. Un dispositif selon la revendication 7, dans lequel le diamant est une couche de diamant formée sur un matériau de base, et lorsqu'une épaisseur de la couche de diamant est $t_2$ [μm] et $kh_2 = 2 \pi t_2/\lambda$, on a la relation suivante : $kh_2 \geq 4$.

9. Un dispositif à ondes acoustiques de surface comprenant :

un diamant;
une couche de $LiNbO_3$ monocristallin formée sur ce diamant, cette couche de $LiNbO_3$ monocristallin ayant une épaisseur $t_1$ [μm]; et

un transducteur interdigité formé sur la couche de $LiNbO_3$
ce dispositif à ondes acoustiques de surface utilisant une onde acoustique de surface avec une longueur d'onde $\lambda$[μm] dans le mode du 1ier ordre;
un paramètre $kh_1$ étant défini par $kh_1 = 2 \pi t_1/\lambda$; et
des angles $\theta$ [°], $\phi$ [°], $\Psi$ [°] étant définis pour constituer une représentation par des angles d'Euler ($\theta$, $\phi$, $\Psi$) de l'orientation cristalline dans un système de coordonnées orthogonal (X, Y, Z) avec des axes X, Y, Z, par rapport à un système de coordonnées cristallographique fondamental (x, y, z) avec des axes x, y, z de la couche de $LiNbO_3$, l'axe Z étant orienté selon une direction normale d'une surface à nu de la couche de $LiNbO_3$, l'axe X étant orienté selon la direction de propagation de l'onde acoustique de surface; et $kh_1$, $\theta$, $\Psi$ définissant un système de coordonnées orthogonal ($kh_1$, $\theta$, $\Psi$);
dans lequel
la longueur d'onde $\lambda$ [μm] et l'épaisseur $t_1$ [μm] et l'orientation cristalline de la couche de $LiNbO_3$ sont choisies de façon que les valeurs $\phi$, $kh_1$, $\theta$ et $\Psi$ soient sélectionnées parmi :

$0 \leq \phi \leq 360$ et une région interne d'une pyramide quadrangulaire dans le système de coordonnées orthogonal ($kh_1$, $\theta$, $\Psi$) défini par $kh_1$, $\theta$, $\Psi$, cette pyramide quadrangulaire ayant son sommet à un point $P_{51}$ et, pour sa surface de base, une région rectangulaire plane avec ses sommets à des points $A_{51}$, $B_{51}$, $C_{51}$ et $D_{51}$,
avec

point $P_{51} = (0,6, 90, 0)$
point $A_{51} = (0,7, 80, 0)$
point $B_{51} = (0,7, 110, 0)$
point $C_{51} = (0,7, 110, 10)$
point $D_{51} = (0,7, 80, 10)$, et

$0 \leq \phi \leq 360$ et une région interne d'une pyramide quadrangulaire dans le système de coordonnées orthogonal ($kh_1$, $\theta$, $\Psi$) défini par $kh_1$, $\theta$, $\Psi$, cette pyramide quadrangulaire ayant son sommet à un point $P_{52}$ et, pour sa surface de base, une région rectangulaire plane avec ses sommets à des points $A_{52}$, $B_{52}$, $C_{52}$ et $D_{52}$,
avec

point $P_{52} = (0,6, 100, 0)$
point $A_{52} = (0,7, 90, 170)$
point $B_{52} = (0,7, 100, 170)$
point $C_{52} = (0,7, 110, 180)$
point $D_{52} = (0,7, 80, 180)$

**10.** Un dispositif selon la revendication 9, dans lequel le diamant est une couche de diamant formée sur un matériau de base, et lorsqu'une épaisseur de la couche de diamant est $t_2$ [μm] et $kh_2 = 2 \pi t_2/\lambda$, on a la relation suivante : $kh_2 \geq 4$.

**11.** Un dispositif à ondes acoustiques de surface comprenant :

un diamant;
une couche de $LiNbO_3$ monocristallin formée sur ce diamant, cette couche de $LiNbO_3$ monocristallin ayant une épaisseur $t_1$ [μm]; et
un transducteur interdigité formé sur la couche de $LiNbO_3$;
ce dispositif à ondes acoustiques de surface utilisant une onde acoustique de surface avec une longueur d'onde $\lambda$ [μm] dans le mode du 2-ième ordre;
un paramètre $kh_1$ étant défini par $kh_1 = 2 \pi t_1/\lambda$; et
des angles $\theta$ [°], $\phi$ [°], $\Psi$ [°] étant définis pour constituer une représentation par des angles d'Euler ($\theta$, $\phi$, $\Psi$) de l'orientation cristalline dans un système de coordonnées orthogonal (X, Y, Z) avec des axes X, Y, Z, par rapport à un système de coordonnées cristallographique fondamental (x, y, z) avec des axes x, y, z de la couche de $LiNbO_3$, l'axe Z étant orienté selon une direction normale d'une surface à nu de la couche de $LiNbO_3$, l'axe X étant orienté selon la direction de propagation de l'onde acoustique de surface; et $kh_1$, $\theta$, $\Psi$ définissant un système de coordonnées orthogonal ($kh_1$, $\theta$, $\Psi$); dans lequel
la longueur d'onde $\lambda$ [μm] et l'épaisseur $t_1$ [μm] et l'orientation cristalline de la couche de $LiNbO_3$ sont choisies de façon que les valeurs $\phi$, $kh_1$, $\theta$ et $\Psi$ soient sélectionnées parmi :

$0 \leq \phi \leq 15$ et une région interne d'un hexaèdre dans le système de coordonnées orthogonal ($kh_1$, $\theta$, $\psi$) défini par $kh_1$, $\theta$, $\Psi$, cet hexaèdre ayant pour ses surfaces de base en regard, une région rectangulaire plane avec ses sommets à des points $A_{61}$, $B_{61}$, $C_{61}$ et $D_{61}$, et une région rectangulaire plane avec ses sommets à des points $A_{62}$, $B_{62}$, $C_{62}$ et $D_{62}$,
avec

point $A_{61} = (0,85, 140, 40)$
point $B_{61} = (0,85, 160, 40)$
point $C_{61} = (0,85, 160, 60)$
point $D_{61} = (0,85, 140, 60)$
point $A_{62} = (1,1, 120, 30)$
point $B_{62} = (1,1, 170, 30)$
point $C_{62} = (1,1, 170, 30)$

point $D_{62} = (1,1, 170, 30)$

$0 \leq \phi \leq 15$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard, une région rectangulaire plane avec ses sommets à des points $A_{63}$, $B_{63}$, $C_{63}$ et $D_{61}$, et une région rectangulaire plane avec ses sommets à des points $A_{64}$, $B_{64}$, $C_{64}$ et $D_{64}$,
avec

point $A_{63} = (0,85, 130, 130)$
point $B_{63} = (0,85, 160, 130)$
point $C_{63} = (0,85, 160, 150)$
point $D_{63} = (0,85, 130, 150)$
point $A_{64} = (1,1, 100, 140)$
point $B_{64} = (1,1, 140, 100)$
point $C_{64} = (1,1, 160, 160)$
point $D_{64} = (1,1, 130, 160)$

$0 \leq \phi \leq 15$ et une région interne d'une pyramide quadrangulaire du système de coordonnées orthogonal ($kh_1$, $\theta$, $\Psi$) défini par $kh_1$, $\theta$, $\Psi$, cette pyramide quadrangulaire ayant son sommet à un point $P_{65}$ et, pour sa surface de base, une région rectangulaire plane avec ses sommets à des points $A_{65}$, $B_{65}$, $C_{65}$ et $D_{65}$,
avec

point $P_{65} = (0,85, 30, 90)$
point $A_{65} = (1,1, 20, 70)$
point $B_{65} = (1,1, 40, 70)$
point $C_{65} = (1,1, 40, 110)$
point $D_{65} = (1,1, 20, 110)$,

$15 \leq \phi \leq 30$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard, une région rectangulaire plane avec ses sommets à des points $A_{66}$, $B_{66}$, $C_{66}$ et $D_{66}$ et une région rectangulaire plane avec ses sommets à des points $A_{67}$, $B_{67}$, $C_{67}$ et $D_{67}$,
avec

point $A_{66} = (0,6, 20, 150)$
point $B_{66} = (0,6, 40, 150)$
point $C_{66} = (0,6, 40, 170)$
point $D_{66} = (0,6, 20, 170)$
point $A_{67} = (0,85, 50, 130)$
point $B_{67} = (0,85, 70, 140)$
point $C_{67} = (0,85, 50, 160)$
point $D_{67} = (0,85, 20, 160)$,

$15 \leq \phi \leq 30$ et une région interne d'un hexaèdre dans le système de coordonnées orthogonal $(kh_1, \theta, \Psi)$ défini par $kh_1$, $\theta$, $\Psi$, cet hexaèdre ayant pour ses surfaces de base en regard une région rectangulaire plane avec ses sommets aux points $A_{67}$, $B_{67}$, $C_{67}$ et $D_{67}$ et une région rectangulaire plane avec ses sommets à des points $A_{68}$, $B_{68}$, $C_{68}$ et $D_{68}$, avec

> point $A_{68}$ = (1,1, 40, 120)
> point $B_{68}$ = (1,1, 90, 120)
> point $C_{68}$ = (1,1, 90, 160)
> point $D_{68}$ = (1,1, 40, 160),

$15 \leq \phi \leq 30$ et une région interne d'un hexaèdre dans le système de coordonnées orthogonal $(kh_1, \theta, \Psi)$ défini par $kh_1$, $\theta$, $\Psi$, cet hexaèdre ayant pour ses surfaces de base en regard une région rectangulaire plane avec ses sommets à des points $A_{69}$, $B_{69}$, $C_{69}$ et $D_{69}$ et une région rectangulaire plane avec ses sommets à des points $A_{6A}$, $B_{6A}$, $C_{6A}$ et $D_{6A}$, avec

> point $A_{69}$ = (0,6, 140, 150)
> point $B_{69}$ = (0,6, 160, 150)
> point $C_{69}$ = (0,6, 160, 160)
> point $D_{69}$ = (0,6, 140, 160)
> point $A_{6A}$ = (0,85, 100, 140)
> point $B_{6A}$ = (0,85, 130, 130)
> point $C_{6A}$ = (0,85, 160, 160)
> point $D_{6A}$ = (0,85, 130, 160),

$15 \leq \phi \leq 30$ et une région interne d'un hexaèdre dans le système de coordonnées orthogonal $(kh_1, \theta, \Psi)$ défini par $kh_1$, $\theta$, $\Psi$, cet hexaèdre ayant pour ses surfaces de base en regard une région rectangulaire plane avec ses sommets aux points $A_{6A}$, $B_{6A}$, $C_{6A}$ et $D_{6A}$ et une région rectangulaire plane avec ses sommets à des points $A_{6B}$, $B_{6B}$, $C_{6B}$ et $D_{6B}$, avec

> point $A_{6B}$ = (1,1, 100, 120)
> point $B_{6B}$ = (1,1, 150, 120)
> point $C_{6B}$ = (1,1, 150, 160)
> point $D_{6B}$ = (1,1, 100, 160),

$15 \leq \phi \leq 30$ et une région interne d'un hexaèdre dans le système de coordonnées orthogonal $(kh_1, \theta, \Psi)$ défini par $kh_1$, $\theta$, $\Psi$, cet hexaèdre ayant pour ses surfaces de base en regard une région rectangulaire plane avec ses sommets à des points $A_{6C}$, $B_{6C}$, $C_{6C}$ et $D_{6C}$ et une région rectangulaire plane avec ses sommets à des points $A_{6D}$, $B_{6D}$, $C_{6D}$ et $D_{6D}$, avec

> point $A_{6C}$ = (0,85, 150, 50)
> point $B_{6C}$ = (0,85, 160, 50)
> point $C_{6C}$ = (0,85, 160, 60)
> point $D_{6C}$ = (0,85, 150, 60)
> point $A_{6D}$ = (1,1, 130, 40)
> point $B_{6D}$ = (1,1, 160, 40)
> point $C_{6D}$ = (1,1, 160, 90)
> point $D_{6D}$ = (1,1, 130, 90), et

$0 \leq \phi \leq 30$ et une région interne d'une pyramide quadrangulaire dans le système de coordonnées orthogonal $(kh_1, \theta, \Psi)$ défini par $kh_1$, $\theta$, $\Psi$, cette pyramide quadrangulaire ayant son sommet à un point $P_{6E}$ et, pour sa surface de base, une région rectangulaire plane avec ses sommets à des points $A_{6E}$, $B_{6E}$, $C_{6E}$ et $D_{6E}$, avec

> point $P_{6E}$ = (0,85, 30, 70)
> point $A_{6E}$ = (1,1, 20, 50)
> point $B_{6E}$ = (1,1, 40, 50)
> point $C_{6E}$ = (1,1, 40, 90)
> point $D_{6E}$ = (1,1, 20, 90).

**12.** Un dispositif selon la revendication 11, dans lequel le diamant est une couche de diamant formée sur un matériau de base, et lorsqu'une épaisseur de la couche de diamant est $t_2$ [µm] et $kh_2 = 2 \pi t_2/\lambda$, on a la relation suivante : $kh_2 \geq 4$.

**13.** Un dispositif à ondes acoustiques de surface comprenant :

> un diamant,
> un transducteur interdigité formé sur ce diamant; et
> une couche de LiNbO$_3$ monocristallin formée sur le transducteur interdigité, cette couche de LiNbO$_3$ monocristallin ayant une épaisseur $t_1$ [µm];
> ce dispositif à ondes acoustiques de surface utilisant une onde acoustique de surface avec une longueur d'onde $\lambda$ [µm] dans le mode du 2-ième ordre;
> un paramètre $kh_1$ étant défini par $kh_1 = 2 \pi t_1/\lambda$; et
> des angles $\theta$ [°], $\phi$ [°], $\Psi$ [°] étant définis pour constituer une représentation par des angles d'Euler $(\theta, \phi, \Psi)$ de l'orientation cristalline dans un système de coordonnées orthogonal (X, Y, Z) avec des axes X, Y, Z, par rapport à un système de coordonnées cristallographique fondamental (x, y, z) avec des axes x, y, z de la couche de $LiNbO_3$, l'axe Z étant orienté selon une direction normale d'une surface à nu de la couche de $LiNbO_3$, l'axe X étant orienté selon la direction de propagation de l'onde acoustique de surface; et $kh_1$, $\theta$, $\Psi$ définissant un système de coordonnées orthogonal ($kh_1$, $\theta$, $\Psi$); dans lequel

la longueur d'onde $\lambda$ [μm] et l'épaisseur $t_1$ [μm] et l'orientation cristalline de la couche de $LiNbO_3$ sont choisies de façon que les valeurs $\phi$, $kh_1$, $\theta$ et $\Psi$ soient sélectionnées parmi :

$15 \leq \phi \leq 30$ et une région interne d'un hexaèdre dans le système de coordonnées orthogonal ($kh_1$, $\theta$, $\Psi$) défini par $kh_1$, $\theta$, $\Psi$, cet hexaèdre ayant pour ses surfaces de base en regard, une région rectangulaire plane avec ses sommets à des points $A_{71}$, $B_{71}$, $C_{71}$ et $D_{71}$ et une région rectangulaire plane avec ses sommets à des points $A_{72}$, $B_{72}$, $C_{72}$ et $D_{72}$, avec

point $A_{71}$ = (0,85, 50, 160)
point $B_{71}$ = (0,85, 100, 160)
point $C_{71}$ = (0,85, 90, 170)
point $D_{71}$ = (0,85, 50, 170)
point $A_{72}$ = (1,1, 40, 150)
point $B_{72}$ = (1,1, 140, 150)
point $C_{72}$ = (1,1, 140, 180)
point $D_{72}$ = (1,1, 40, 180)

14. Un dispositif selon la revendication 13, dans lequel le diamant est une couche de diamant formée sur un matériau de base, et lorsqu'une épaisseur de la couche de diamant est $t_2$ [μm] et $kh_2 = 2\pi t_2/\lambda$, on a la relation suivante : $kh_2 \geq 4$.

## Fig.1

## Fig.2

*Fig.3*

400

$\lambda=4d$

W

|←d→|

400

→|d|←

ELECTRODE INTERSECTION WIDTH : W
ELECTRODE WIDTH : d

*Fig.4*

400

$\lambda=8d$

|←d→|←d→|

400

# Fig.5

# Fig. 6

# Fig. 7

khı=0.2
$\phi$=10°

EP 0 789 453 B1

# Fig. 8

khı=0.2
φ=20°

# Fig. 9

khı=0.2
φ=30°

EP 0 789 453 B1

Fig. 10

## Fig. 11

khı＝0.325
φ＝10°

EP 0 789 453 B1

Fig. 12

Fig. 13

# Fig. 14

EP 0 789 453 B1

Fig. 15

kh₁=0.45
φ=10°

Fig. 16

$kh_1 = 0.45$
$\phi = 20°$

Fig. 17

khı=0.45
φ=30°

Fig. 18

$kh_1 = 0.7$
$\phi = 0°$

Fig. 19

$kh_1=0.7$
$\phi=10°$

EP 0 789 453 B1

Fig. 20

$kh_1 = 0.7$
$\varphi = 2 0°$

Fig. 21

khı=0.7
φ=30°

EP 0 789 453 B1

# Fig. 22

# Fig. 23

Fig. 24

$kh_1 = 0.6$
$\phi = 0°$

Fig. 25

khı = 0.6
φ = 10°

Fig. 26

kh₁=0.6
φ=20°

# Fig. 27

khı=0.6
φ=30°

EP 0 789 453 B1

Fig. 28

kh₁ = 0.85
φ = 0°

Fig. 29

khı=0.85
φ=10°

# Fig. 30

khı=0.8 5
φ = 2 0°

Fig. 31

khi=0.85
φ=30°

# Fig. 32

khı = 1.1
$\phi = 0°$

EP 0 789 453 B1

Fig. 33

Fig. 34

khi = 1.1
φ = 20°

EP 0 789 453 B1

Fig. 35

$kh_1 = 1.1$
$\phi = 30°$

# Fig. 36

$kh_1 = 1.6$
$\phi = 0°$

Fig. 37

khı=1.6
φ=10°

# Fig. 38

khi = 1.6
φ = 2 0°

EP 0 789 453 B1

Fig. 39

kh₁ = 1.6
φ = 30°

# Fig. 40

Fig. 41

## Fig. 42

khı=0.2
$\phi = 10°$

Fig. 43

$k_h = 0.2$
$\phi = 20°$

# Fig. 44

khı=0.2
$\phi = 30°$

Fig. 45

$kh_1 = 0.325$
$\phi = 0°$

# Fig. 46

khı=0.325
$\phi = 10°$

## Fig. 47

khı=0.3 2 5
$\phi$=2 0°

EP 0 789 453 B1

# Fig. 48

kh₁＝0.325
φ＝30°

EP 0 789 453 B1

# Fig. 49

khı=0.4 5
$\phi = 0°$

EP 0 789 453 B1

Fig. 50

khı=0.45
φ=10°

EP 0 789 453 B1

Fig. 51

# Fig. 52

$kh_1 = 0.45$
$\phi = 30°$

# Fig. 53

khı=0.7
$\phi = 0°$

EP 0 789 453 B1

83

## Fig. 54

$kh_1 = 0.7$
$\phi = 10°$

EP 0 789 453 B1

Fig. 55

# Fig. 56

khι=0.7
$\phi = 30°$

# Fig. 57

LiNbO$_3$      200

340

400

DIAMOND      100

Fig. 58

$kh_1 = 0.6$
$\phi = 0°$

Fig. 59

khı=0.6
φ=10°

# Fig. 60

khı=0.6
$\phi = 2\,0\,°$

EP 0 789 453 B1

Fig. 61

# Fig. 62

khι=0.8 5
φ=0°

EP 0 789 453 B1

Fig. 63

# Fig. 64

khı=0.8 5
$\phi = 2\,0°$

EP 0 789 453 B1

# Fig. 65

khı = 0.8 5
φ = 3 0°

# Fig. 66

khι＝1.1
φ＝0°

EP 0 789 453 B1

# Fig. 67

khı = 1.1
φ = 10°

EP 0 789 453 B1

97

# Fig. 68

khı = 1.1
$\phi = 20°$

EP 0 789 453 B1

Fig. 69

khı = 1.1
φ = 30°

# Fig. 70

khı＝1.6
φ＝0°

# Fig. 71

khı=1.6
φ=10°

EP 0 789 453 B1

# Fig. 72

khı = 1.6
φ = 20°

EP 0 789 453 B1

EP 0 789 453 B1

# Fig. 73

kh₁ = 1.6
φ = 30°

# Fig. 74

Fig. 75

Fig. 76

$kh_1 = 0.2$
$\phi = 10°$

Fig. 77

kh₁=0.2
φ=20°

## Fig. 78

khı=0.2
$\phi = 30°$

EP 0 789 453 B1

108

# Fig. 79

khi = 0.3 2 5

$\phi = 0°$

EP 0 789 453 B1

## Fig. 80

khı=0.325
$\phi = 10°$

EP 0 789 453 B1

Fig. 81

Fig. 82

khı=0.325
φ=30°

## Fig. 83

EP 0 789 453 B1

# Fig. 84

khı=0.4 5
φ=10°

## Fig. 85

khi=0.45
$\phi = 20°$

Fig. 86

kh₁=0.45
φ=30°

Fig. 87

khı=0.7
φ=0°

# Fig. 88

kh=0.7
$\phi = 10°$

EP 0 789 453 B1

118

Fig. 89

khı=0.7
φ=20°

# Fig. 90

khι＝0.7
$\phi = 3\,0°$

EP 0 789 453 B1

# Fig. 91

Fig. 92

## Fig. 93

khı=0.6
$\phi$=10°

EP 0 789 453 B1

# Fig. 94

khı=0.6
φ=2 0°

EP 0 789 453 B1

Fig. 95

khi = 0.6
φ = 30°

Fig. 96

# Fig. 97

khı=0.85
$\phi = 1\,0°$

127

EP 0 789 453 B1

Fig. 98

kh₁=0.85
φ=20°

# Fig. 99

$kh_1 = 0.85$
$\phi = 30°$

EP 0 789 453 B1

Fig. 100

# Fig. 101

EP 0 789 453 B1

khı=1.1
$\phi = 10°$

# Fig. 102

khi = 1.1
φ = 20°

EP 0 789 453 B1

Fig. 103

$kh_1 = 1.1$
$\varphi = 30°$

# Fig. 104

khı=1.6
$\phi = 0°$

Fig. 105

khı=1.6
φ=10°

## Fig. 106

khi = 1.6
φ = 20°

Fig. 107

khı = 1.6
φ = 30°

# Fig. 108

LiNbO$_3$ ∿370

∿400

DIAMOND ∿100

# Fig. 109

khı=0.6
$\phi = 0°$

EP 0 789 453 B1

Fig. 110

khı=0.6
φ=10°

EP 0 789 453 B1

140

Fig. 111

# Fig. 112

khi=0.6
$\phi=30°$

EP 0 789 453 B1

Fig. 113

kh₁=0.85
φ=0°

EP 0 789 453 B1

# Fig. 114

khı=0.85
$\phi = 1\,0\,°$

# Fig. 115

khı=0.85
$\phi = 20°$

EP 0 789 453 B1

145

EP 0 789 453 B1

## Fig. 116

khı=0.85
$\phi = 30°$

# Fig. 117

khı=1.1
φ=0°

147

EP 0 789 453 B1

Fig. 118

148

Fig. 119

kh₁=1.1
Φ=20°

Fig. 120

$kh_1 = 1.1$
$\phi = 30°$

Fig. 121

kh₁ = 1.6
φ = 0°

Fig. 122

## Fig. 123

khı＝1.6
φ＝20°

EP 0 789 453 B1

Fig. 124

kh₁ = 1.6
φ = 30°

# Fig. 125

khı=0.2
φ=0°

Fig. 126

khı=0.2
$\phi = 10°$

EP 0 789 453 B1

Fig. 127

khı=0.2
$\phi = 20°$

EP 0 789 453 B1

Fig. 128

Fig. 129

kh₁=0.325
φ=0°

# Fig. 130

khı=0.325
φ=10°

EP 0 789 453 B1

## Fig. 131

kh₁=0.3 2 5
φ=2 0°

Fig. 132

Fig. 133

$kh_1 = 0.45$
$\phi = 0°$

Fig. 134

## Fig. 135

khɪ=0.45
$\phi$=20°

EP 0 789 453 B1

# Fig. 136

khι=0.45
φ=30°

EP 0 789 453 B1

Fig. 137

Fig. 138

$kh_1 = 0.7$
$\phi = 10°$

# Fig. 139

khı=0.7
$\phi = 20°$

169

Fig. 140